# EUROPEAN PATENT APPLICATION

(11) **EP 4 545 977 A1**
(43) Date of publication of application: **30.04.2025**
(21) Application number: 23826848.6
(22) Date of filing: 18.05.2023
(51) Int. Cl.: G01N 35/08, B81B 1/00, B81C 1/00, G01N 37/00

(54) **MICROCHANNEL CHIP, MICROCHANNEL BASE MATERIAL, METHOD FOR FABRICATING MICROCHANNEL CHIP, AND METHOD FOR FABRICATING MICROCHANNEL BASE MATERIAL**

(30) Priority: 24.06.2022 JP 2022102142; 24.06.2022 JP 2022102143; 24.06.2022 JP 2022102144
(71) Applicant: Toppan Holdings Inc., Tokyo 110-0016 (JP)
(72) Inventor: HASE Hina, Tokyo 110-0016 (JP); FUKUGAMI Norihito, Tokyo 110-0016 (JP)
(74) Representative: Plasseraud IP
(86) International application number: PCT/JP2023/018667
(87) International publication number: WO 2023/248660

(57) **Abstract**

To provide a microfluidic chip in which members are prevented from suffering damage due to pressure at the time of bonding a wall section and a covering member and no liquid leakage occurs when liquid flows, a microfluidic base member that allows the microfluidic chip to be formed, and methods for manufacturing the microfluidic chip and the microfluidic base member. A microfluidic chip (1) includes: a substrate (10); a barrier layer (11); and a cover layer (12). The barrier layer (11) includes a resin material. The barrier layer (11) is provided on the substrate (10). The barrier layer (11) forms a channel section (13). The cover layer (12) is provided on an opposite surface of the barrier layer (11) to the substrate (10) and covers the channel section (13). The channel section (13) is formed in the barrier layer (11) as an opening section having an opening width of 2000 µm or less. The barrier layer (11) has an opening area ratio of 60% or less.

## Description

### Technical Field

The present disclosure relates to a microfluidic chip, a microfluidic base member, and methods for manufacturing the microfluidic chip and the microfluidic base member.

### Background Art

In recent years, technology has been proposed that forms fine reaction fields by applying litho-processing or thick film processing technology and allows for testing in units of several microliters to several nanoliters. Such technology that uses fine reaction fields is referred to as a µ-TAS (Micro Total Analysis system).

µ-TAS is applied to fields such as genetic testing, chromosome testing, cell testing, and medicament development, biotechnology, the testing of trace quantities of substances in the environment, the inspection of the breeding environment of agricultural crops or the like, the genetic testing of agricultural crops, and the like. The introduction of µ-TAS technology offers great effects such as automation, acceleration, higher accuracy, lower cost, speediness, and reduced environmental impacts.

µ-TAS uses micrometer-sized channels (microfluidic channels or microchannels) formed on substrates in many cases. Such substrates are each referred to as a chip, a microchip, a microfluidic chip, or the like.

Conventionally, such microfluidic chips have been fabricated by using technology such as injection molding, molding, cutting, and etching. In addition, glass substrates have been chiefly used as substrates of microfluidic chips because glass substrates are easy to manufacture and also allow for optical detection. Meanwhile, microfluidic chips including light and inexpensive resin materials less prone to damage than glass substrates also have been under development. Methods for manufacturing microfluidic chips including resin materials include a method for fabricating a microfluidic chip by forming a resin pattern for a channel chiefly by photolithography and bonding a covering member to the resin pattern. This method makes it possible to form even a fine channel pattern that is difficult to form by the conventional technology in some cases.

Such a microfluidic chip is fabricated by bonding a plurality of members to each other. For example, PTL 1 discloses a microfluidic chip formed in a method in which a plurality of members is bonded to each other with an adhesive in between. In addition, for example, as described in PTL 2, a method has also been proposed in which process gas is converted to plasma under atmospheric pressure or pressure near atmospheric pressure to modify a substrate surface, and members are bonded to each other with no adhesive (e.g., PTL 2).

### Citation List

### Patent Literature

PTL 1: JP 2007-240461 A
PTL 2: JP 2011-104886 A

### Summary of the Invention

### Technical Problem

When a microfluidic chip is fabricated, a plurality of members is bonded to each other. It is therefore necessary to apply pressure corresponding to the bonding method to the members. For example, when a wall section (barrier section) in which a channel is formed and a covering member are bonded, these members are pressed in accordance with the bonding method. A channel portion (an opening region of the wall section) has occupied larger surface area in a microfluidic chip in recent years as a channel pattern structure has been more complicated. When the wall section has a larger opening area or greater opening width, the stability of bonding the wall section and the covering member reduces and members (such as a substrate, the wall section, and a cover layer) may suffer damage. In addition, if the members suffer damage when the members are bonded to each other, liquid leakage occurs in some cases when liquid flows through the microfluidic chip.

Accordingly, in view of the problem described above, an object of the present disclosure is to provide a microfluidic chip in which members are prevented from suffering damage due to pressure at the time of bonding a wall section and a covering member and no liquid leakage occurs when liquid flows, a microfluidic base member that allows the microfluidic chip to be formed, and methods for manufacturing the microfluidic chip and the microfluidic base member.

### Solution to Problem

To solve the problem described above, a microfluidic chip according to an aspect of the present disclosure includes: a substrate; a barrier section; and a covering member. The barrier section includes a resin material. The barrier section is provided on the substrate. The barrier section forms a channel. The covering member is provided on an opposite surface of the barrier section to the substrate and covers the channel. The microfluidic chip is characterized in that the channel is formed in the barrier section as an opening section having an opening width of 2000 µm or less, and the barrier section has an opening area ratio of 60% or less.

In addition, a microfluidic base member according to an aspect of the present disclosure includes: a substrate; and a barrier section including a resin material. The barrier section is provided on the substrate. The barrier section forms a channel on the substrate. The microfluidic base member is characterized in that the channel is formed in the barrier section as an opening section having an opening width of 2000 µm or less, and the barrier section has an opening area ratio of 60% or less in a covering member bonded state in which a covering member is provided on an opposite surface of the barrier section to the substrate. The covering member serves as a cover of the channel.

In addition, a method for manufacturing a microfluidic chip according to an aspect of the present disclosure includes: a step of coating a substrate with resin; a step of exposing the resin used for the coating; a step of developing and cleaning the exposed resin to form a barrier section that defines a channel on the substrate; a step of conducting post-baking treatment on the barrier section; and a step of bonding a covering member to an opposite surface of the barrier section to the substrate. The method is characterized in that redundant resin on the substrate is removed by the developing to form an opening section having an opening width of 2000 µm or less in the barrier section and cause the barrier section to have an opening area ratio of 60% or less. The opening section serves as the channel.

In addition, a method for manufacturing a microfluidic base member according to an aspect of the present disclosure includes: a step of coating a substrate with resin; a step of exposing the resin used for the coating; a step of developing and cleaning the exposed resin to form a barrier section that defines a channel on the substrate; and a step of conducting post-baking treatment on the barrier section. The method is characterized in that redundant resin on the substrate is removed by the developing to form an opening section having an opening width of 2000 µm or less in the barrier section and cause the barrier section to have an opening area ratio of 60% or less in a covering member bonded state in which a covering member is provided on an opposite surface of the barrier section to the substrate. The opening section serves as the channel. The covering member serves as a cover of the channel.

### Advantageous Effects of the Invention

According to the aspects of the present disclosure, it is possible to provide a microfluidic base member that allows a microfluidic chip to be formed in which members are prevented from suffering damage due to pressure at the time of bonding a wall section and a covering member and no liquid leakage occurs when liquid flows.

### Brief Description of the Drawings

[Fig. 1] Fig. 1 is a schematic plan view of a configuration example of a microfluidic chip according to a 1-1-th embodiment of the present disclosure.
[Fig. 2] Fig. 2 is a schematic cross-sectional view of the configuration example of the microfluidic chip according to the 1-1-th embodiment of the present disclosure.
[Fig. 3A] Fig. 3A is a schematic plan view of a configuration example of a barrier section and a channel section of the microfluidic chip according to the 1-1-th embodiment of the present disclosure.
[Fig. 3B] Fig. 3B is an enlarged view of a configuration of the channel section illustrated in Fig. 3A.
[Fig. 4] Fig. 4 is a flowchart illustrating an example of a method for manufacturing a microfluidic chip according to the 1-1-th embodiment of the present disclosure.
[Fig. 5A] Fig. 5A is a schematic plan view of an arrangement example of a channel section in a microfluidic chip according to a modification example of the 1-1-th embodiment of the present disclosure.
[Fig. 5B] Fig. 5B is a schematic plan view of an arrangement example of a channel section in a microfluidic chip according to another modification example of the 1-1-th embodiment of the present disclosure.
[Fig. 6] Fig. 6 is a schematic plan view of an arrangement example of a microfluidic chip according to a 1-2-th embodiment of the present disclosure.
[Fig. 7] Fig. 7 is a schematic cross-sectional view of the configuration example of the microfluidic chip according to the 1-2-th embodiment of the present disclosure.
[Fig. 8] Fig. 8 is a schematic plan view of a configuration example of a microfluidic chip according to a 2-1-th embodiment of the present disclosure.
[Fig. 9] Fig. 9 is a schematic cross-sectional view of the configuration example of the microfluidic chip according to the 2-1-th embodiment of the present disclosure.
[Fig. 10A] Fig. 10A is a schematic plan view of a configuration example of a barrier section and a channel section of the microfluidic chip according to the 2-1-th embodiment of the present disclosure.
[Fig. 10B] Fig. 10B is an enlarged view of a configuration of the channel section illustrated in Fig. 3A.
[Fig. 11] Fig. 11 is a flowchart illustrating an example of a method for manufacturing a microfluidic chip according to the 2-1-th embodiment of the present disclosure.
[Fig. 12] Fig. 12 is a schematic plan view of an arrangement example of a channel section in a microfluidic chip according to a modification example of the 2-1-th embodiment of the present disclosure.
[Fig. 13] Fig. 13 is a schematic plan view (Part 1) of an arrangement example of a channel section in a microfluidic chip according to another modification example of the 2-1-th embodiment of the present disclosure.
[Fig. 14] Fig. 14 is a schematic plan view (Part 2) of an arrangement example of a channel section in a microfluidic chip according to another modification example of the 2-1-th embodiment of the present disclosure.
[Fig. 15] Fig. 15 is a schematic plan view (Part 3) of an arrangement example of a channel section in a microfluidic chip according to another modification example of the 2-1-th embodiment of the present disclosure.
[Fig. 16] Fig. 16 is a schematic plan view of a configuration example of a microfluidic chip according to a 2-2-th embodiment of the present disclosure.
[Fig. 17] Fig. 17 is a schematic cross-sectional view of the configuration example of the microfluidic chip according to the 2-2-th embodiment of the present disclosure.
[Fig. 18A] Fig. 18A is a schematic plan view of a configuration example of a microfluidic chip according to a 3-1-th embodiment of the present disclosure.
[Fig. 18B] Fig. 18B is a schematic cross-sectional view of the configuration example of the microfluidic chip according to the 3-1-th embodiment of the present disclosure.
[Fig. 19A] Fig. 19A is a schematic plan view of a configuration example of a microfluidic base member according to the 3-1-th embodiment of the present disclosure.
[Fig. 19B] Fig. 19B is a schematic cross-sectional view of the configuration example of the microfluidic base member according to the 3-1-th embodiment of the present disclosure.
[Fig. 20] Fig. 20 is an enlarged view of a configuration of a channel section illustrated in Fig. 19A.
[Fig. 21] Fig. 21 is a flowchart illustrating an example of a method for manufacturing a microfluidic base member according to the 3-1-th embodiment of the present disclosure.
[Fig. 22A] Fig. 22A is a schematic plan view of an arrangement example of a channel section in a microfluidic base member according to a first modification example of the 3-1-th embodiment of the present disclosure.
[Fig. 22B] Fig. 22B is a schematic cross-sectional view of the arrangement example of the channel section in the microfluidic base member according to the first modification example of the 3-1-th embodiment of the present disclosure.
[Fig. 23] Fig. 23 is a schematic plan view of another arrangement example of the channel section in the microfluidic base member according to the first modification example of the 3-1-th embodiment of the present disclosure.
[Fig. 24A] Fig. 24A is a schematic plan view of a configuration example of a microfluidic base member according to a second modification example of the 3-1-th embodiment of the present disclosure.
[Fig. 24B] Fig. 24B is a schematic cross-sectional view of the configuration example of the microfluidic base member according to the second modification example of the 3-1-th embodiment of the present disclosure.
[Fig. 25A] Fig. 25A is a schematic plan view of a configuration example of a microfluidic chip according to a 3-2-th embodiment of the present disclosure.
[Fig. 25B] Fig. 25B is a schematic cross-sectional view of the configuration example of the microfluidic chip according to the 3-2-th embodiment of the present disclosure.
[Fig. 26A] Fig. 26A is a schematic plan view of a configuration example of the microfluidic base member according to the 3-2-th embodiment of the present disclosure.
[Fig. 26B] Fig. 26B is a schematic cross-sectional view of the configuration example of the microfluidic base member according to the 3-2-th embodiment of the present disclosure.
[Fig. 27] Fig. 27 is a schematic plan view of an arrangement example of a covering member support section in a microfluidic base member according to a first modification example of the 3-2-th embodiment of the present disclosure.
[Fig. 28] Fig. 28 is a schematic plan view (Part 1) of another arrangement example of the covering member support section in the microfluidic base member according to the first modification example of the 3-2-th embodiment of the present disclosure.
[Fig. 29] Fig. 29 is a schematic plan view (Part 2) of another arrangement example of the covering member support section in the microfluidic base member according to the first modification example of the 3-2-th embodiment of the present disclosure.
[Fig. 30] Fig. 30 is a schematic plan view (Part 3) of another arrangement example of the covering member support section in the microfluidic base member according to the first modification example of the 3-2-th embodiment of the present disclosure.
[Fig. 31A] Fig. 31A is a schematic plan view of a configuration example of a microfluidic base member according to a second modification example of the 3-2-th embodiment of the present disclosure.
[Fig. 31B] Fig. 31B is a schematic cross-sectional view of the configuration example of the microfluidic base member according to the second modification example of the 3-2-th embodiment of the present disclosure.

### Description of the Embodiments

The present disclosure will be described below through embodiments, but the following embodiments do not limit the claimed invention. In addition, all the combinations of features described in the embodiments are not necessarily essential for the solution of the invention. In addition, the drawings schematically illustrate the invention according to the claims. The dimensions such as the width and the thickness of each section are different from the actual dimensions. The ratio of the dimensions is also different from the actual ratio.

### 1. First Embodiment

A microfluidic chip according to a first embodiment of the present disclosure will be described. It is to be noted that the side of the microfluidic chip closer to a substrate will be described as "down" and the opposite side of the microfluidic chip to the substrate (closer to a covering member) will be described as "up" in the following description in some cases.

As a result of intensive studies, the present inventors have found that the opening area ratio of a wall section and the dimensions (e.g., the opening width of a channel) of an opening section formed in the wall section are controlled in a microfluidic chip to satisfy specific conditions, thereby increasing the bonding stability of bonding a plurality of members (the wall section and a covering member here). The present inventors have hereby invented a microfluidic chip in which members (a substrate, a wall section, and a covering member) are prevented from suffering damage due to pressure at the time of bonding the wall section and the covering member and no liquid leakage occurs when liquid flows, and a method for manufacturing the microfluidic chip. It is to be noted that details of the opening area ratio of the wall section will be described below.

The respective aspects (a 1-1-th embodiment and a 1-2-th embodiment) of the first embodiment of the present disclosure will be described below with reference to the drawings.

### (1.1) 1-1-th Embodiment

### (1.1.1) Basic Configuration of Microfluidic Chip

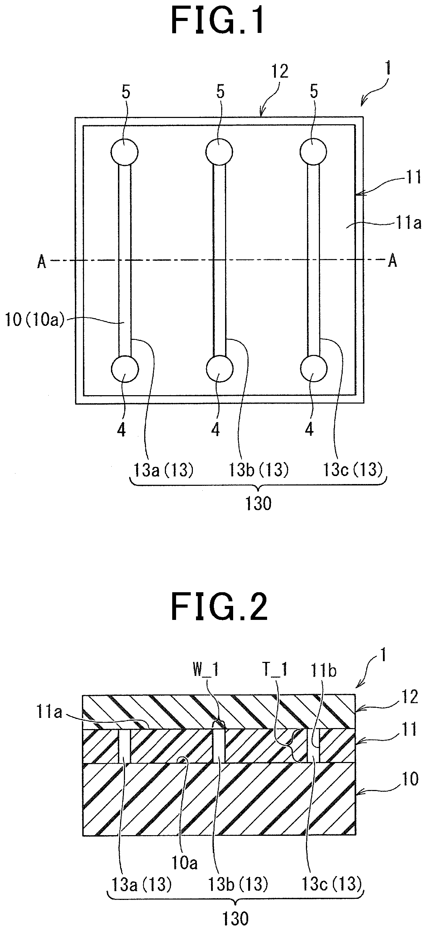

Each of Figs. 1 and 2 is an outline diagram for describing a configuration example of a microfluidic chip 1 according to the 1-1-th embodiment (referred to as "the present embodiment" below) of the present disclosure. Specifically, Fig. 1 is an outline plan view of a microfluidic chip 1 according to the present embodiment. In addition, Fig. 2 is an outline cross-sectional view of a cross section of the microfluidic chip 1 taken along a line A-A illustrated in Fig. 1.

As illustrated in Fig. 1, the microfluidic chip 1 includes input sections 4 each for introducing a fluid (e.g., liquid), channel sections 13 each formed on a substrate 10, and output sections 5 each for discharging a fluid from the channel section 13. The fluid introduced from the input section 4 flows in the channel section 13. Each of the output sections 5 is not limited to a component (discharge section) that discharges a fluid and may be a component (drug fixation section) that brings the fluid and a drug solution into contact. A component that functions as at least one of the discharge section or the drug solution fixation section of a fluid will be generically referred to as the "output section" below.

A barrier layer (an example of a barrier section) 11 that defines each of the channel sections 13 is formed on the substrate 10. The channel section 13 is an opening section that opens on a front surface 11a. In the microfluidic chip 1, the channel section 13 is covered with a cover layer (an example of a covering member) 12 that is a covering member. The input sections 4 and the output sections 5 are through holes provided in the cover layer 12. Details of the respective components will be described below.

Fig. 1 illustrates the substrate 10, the barrier layer 11, and the channel sections 13 that are visually recognizable through the cover layer 12 having transparency.

It is sufficient if the microfluidic chip 1 is provided with the at least one or more input sections 4 and the at least one or more output sections 5. The microfluidic chip 1 may be provided with the plurality of input sections 4 and the plurality of output sections 5. In addition, it is sufficient if the one or more channel sections 13 are provided in the microfluidic chip 1. The plurality of channel sections 13 may be provided. The channel sections 13 may be designed to allow fluids introduced from the input sections 4 to merge or be separated. Specifically, the plurality of input sections 4 may be provided for the one channel section 13 or the one input section 4 may be provided for the plurality of channel sections 13. In addition, similarly, the plurality of output sections 5 may be provided for the one channel section 13 or the one output section 5 may be provided for the plurality of channel sections 13.

The microfluidic chip 1 illustrated in each of Figs. 1 and 2 includes a channel group 130 including the three channel sections 13 (channel sections 13a, 13b, and 13c) as an example.

Details of the members (the substrate 10, the barrier layer 11, and the cover layer 12) included in the channel sections 13 (channel sections 13a to 13c) in the microfluidic chip 1 will be described here.

As illustrated in Fig. 2, the barrier layer 11 that is a wall section sandwiched between two base members (a first base member and a second base member) defines the channel sections 13 that are channels in each of which a fluid flows in the microfluidic chip 1. In this example, the cover layer (an example of the covering member) 12 that is provided on the upper surface side of the barrier layer 11 and covers the upper section of the channel section 13 corresponds to the first base member. The substrate 10 that is provided on the bottom surface side of the barrier layer 11 and forms the bottom section of the channel section 13 corresponds to the second base member. That is, the microfluidic chip 1 includes the channel sections 13 provided on the substrate 10, the cover layer 12 that serves as a cover of the channel sections 13, the substrate 10, and the pair of barrier layers 11 that is disposed between the cover layer 12 and the substrate 10 and forms the channel section 13 on the substrate 10. More specifically, the microfluidic chip 1 includes the substrate 10, the barrier layer 11 that is provided on the substrate 10 and forms a channel, and the cover layer 12 that is provided on the opposite surface of the barrier layer 11 to the substrate 10 and covers the channel sections 13.

Each of the channel sections 13 in which a fluid introduced from the input section 4 flows is a region surrounded by the substrate 10, the barrier layer 11, and the cover layer 12. The channel section 13 is defined by the barrier layer 11 provided on the substrate 10 to be opposed to the substrate 10. The opposite side of the channel section 13 to the substrate 10 is covered with the cover layer 12 that serves as a covering member. As described above, a fluid is introduced to the channel section 13 from the input section 4 provided in the cover layer 12 and the fluid flowing in the channel section 13 is discharged from the output section 5.

### (1.1.1.1) Substrate

The substrate 10 is a member that serves as the base of the microfluidic chip 1. The barrier layer 11 provided on the substrate 10 is included in the channel sections 13. That is, the substrate 10 and the barrier layer 11 can be regarded as the body section of the microfluidic chip 1.

It is possible to form the substrate 10 by using any of a light-transmissive material or a non-light-transmissive material. For example, in a case where the internal state (the state of a fluid) of each of the channel sections 13 is detected and observed by using light, it is possible to use a material that is excellent in transparency to the light. This allows the inner state of the channel section 13 to be observed, for example, from the substrate 10 side. It is possible to use resin, glass, or the like as the light-transmissive material. The resin used for the light-transmissive material that is used to form the substrate 10 includes an acrylic resin, a methacrylic resin, polypropylene, a polycarbonate resin, a cycloolefin resin, a polystyrene resin, a polyester resin, a urethane resin, a silicone resin, a fluororesin, and the like from the perspective of the suitability for the formation of the body section of the microfluidic chip 1.

In addition, for example, in a case where it is unnecessary to detect or observe the internal (the state of a fluid) state of each of the channel sections 13 by using light, a non-light-transmissive material may be used. The non-light-transmissive material includes a silicon wafer, a copper plate, and the like. The thickness of the substrate 10 is not limited in particular, but a certain level of rigidity is necessary in a channel formation step and it is thus preferable that the thickness of the substrate 10 be within a range of 10 µm (0.01 mm) or more and 10 mm or less.

### (1.1.1.2) Barrier Layer

The barrier layer 11 is a component that is provided on the substrate 10 and forms the channel sections 13. Specifically, the channel section 13 is defined by opposed side surfaces 11b of the barrier layers 11. As illustrated in Fig. 2, the channel group 130, that is, the plurality of channel sections 13 (channel sections 13a, 13b, and 13c), is formed in the barrier layer 11 in the present embodiment. The microfluidic chip 1 includes the plurality of channel sections 13, thereby making it possible, for example, to carry out a plurality of tests at the same time or carry out tests in which different types of fluids are used, making it possible to use the microfluidic chip more widely. The plurality of respective channel sections 13 may be independent or some of the plurality of channel sections 13 may cross each other.

It is possible to form the barrier layer 11 by using a resin material. It is possible to use, for example, a photosensitive resin as the resin material of the barrier layer 11.

It is desirable that the photosensitive resin that forms the barrier layer 11 have photosensitivity to light having a wavelength of 190 nm or more and 400 nm or less, which is in the ultraviolet region. It is possible to use a photoresist such as a liquid resist or a dry film resist as the photosensitive resin. These photosensitive resins may be either positive photosensitive resins in which the photosensitive regions are dissolved or negative photosensitive resins in which the photosensitive regions are insoluble. A photosensitive resin composition suitable for the formation of the barrier layer 11 in the microfluidic chip 1 includes a radical negative photosensitive resin including an alkali-soluble polymer, an additional polymerizable monomer, and a photopolymerization initiator. It is possible to use, for example, an acryl-based resin, an acrylic urethane-based resin (urethane acrylate-based resin), an epoxy-based resin, a polyamide-based resin, a polyimide-based resin, a polyurethane-based resin, a polyester-based resin, a polyether-based resin, a polyolefin-based resin, a polycarbonate-based resin, a polystyrene-based resin, a norbornene-based resin, a phenolic novolac-based resin, and another resin having photosensitivity alone, or use a mixture of some of the resins or use copolymerized resins as the photosensitive resin material.

It is to be noted that the resin material of the barrier layer 11 is not limited to a photosensitive resin in the present embodiment. For example, silicone rubber (PDMS: polydimethylsiloxane) or synthetic resin may be used. It is possible to use, for example, a polymethyl methacrylate resin (PMMA), polycarbonate (PC), a polystyrene resin (PS), polypropylene (PP), a cycloolefin polymer (COP), a cycloolefin copolymer (COC), or the like as the synthetic resin. It is desirable to select the resin material of the barrier layer 11 as appropriate depending on the application.

### (1.1.1.3) Cover Layer

In the microfluidic chip 1 according to the present embodiment, the cover layer 12 is provided on the opposite surface of the barrier layer 11 to the substrate 10. As illustrated in Fig. 1, the cover layer 12 is a covering member that covers the channel sections 13. As described above, the cover layer 12 is provided on the opposite surface of the barrier layer 11 to the substrate 10 and is opposed to the substrate 10 with the barrier layer 11 interposed therebetween. More specifically, as illustrated in Fig. 2, the cover layer 12 is supported by the barrier layer 11 in a cross-sectional view. The cover layer 12 is opposed to the substrate 10 in an opening section of the barrier layer 11 in which the channel section 13 is formed. The opposed surface of the cover layer 12 to the substrate 10 defines the upper section of the channel section 13.

It is possible to form the cover layer 12 by using any of a light-transmissive material or a non-light-transmissive material. For example, in a case where the internal state of each of the channels is detected and observed using light, it is possible to use a material that is excellent in transparency to the light. The light-transmissive material is not limited in particular and it is possible to use resin, glass, or the like. The resin that forms the cover layer 12 includes an acrylic resin, a methacrylic resin, polypropylene, a polycarbonate resin, a cycloolefin resin, a polystyrene resin, a polyester resin, a urethane resin, a silicone resin, a fluororesin, and the like from the perspective of the suitability for the formation of the body section of the microfluidic chip 1. The thickness of the cover layer 12 is not limited in particular, but it is preferable that the thickness of the cover layer 12 be within a range of 10 µm or more and 10 mm or less in view of the provision of respective through holes corresponding the input sections 4 and the output sections 5 in the cover layer 12. In addition, it is desirable that the cover layer 12 have, in advance, respective holes corresponding to the input sections 4 from each of which a fluid (liquid) is introduced and the output sections 5 from each of which the fluid is discharged in the cover layer 12 before the cover layer 12 is bonded to the barrier layer 11.

### (1.1.1.4) Configuration of Channel

The configuration of the channel section 13 in the microfluidic chip 1 according to the present embodiment will be described here in detail using Figs. 1 to 3.

The dimensions of the channel section 13 in the microfluidic chip 1 and the opening area ratio of the barrier layer 11 that forms the channel sections 13 will be described below.

As described above, the microfluidic chip has a complicated channel pattern structure and more opening regions tend to occupy the wall section. These increased opening regions reduce the bonding stability of bonding the wall section and the covering member in some cases. The reduced bonding stability may cause a defect such as damage to respective members (the substrate, the wall section, and the covering member in this example) included in the microfluidic chip 1 to be bonded, for example, when the covering member and the wall section are bonded, for example, at the time of fabricating the microfluidic chip 1.

For example, when the bonding stability reduces because of the increased opening regions in the wall section, the resistance of the wall section to pressure reduces, the wall section suffers damage at the time of bonding the wall section and the covering member, and even the covering member and the substrate further suffer damage in some cases. In addition, if members such as the substrate, the wall section, and the covering member suffer damage, liquid leakage occurs in some cases when liquid flows through the microfluidic chip. The increased bonding stability is thus requested from the microfluidic chip at the time of bonding the wall section and the covering member. As described below, the microfluidic chip 1 according to the present embodiment has a configuration in which the dimensions of the channel section 13 and the opening area ratio of the barrier layer 11 satisfy the specific conditions. This makes it possible to provide a microfluidic chip in which the resistance of a wall section to pressure is increased, members (substrate, wall section, and covering member) are prevented from suffering damage due to pressure, and no liquid leakage occurs when liquid flows.

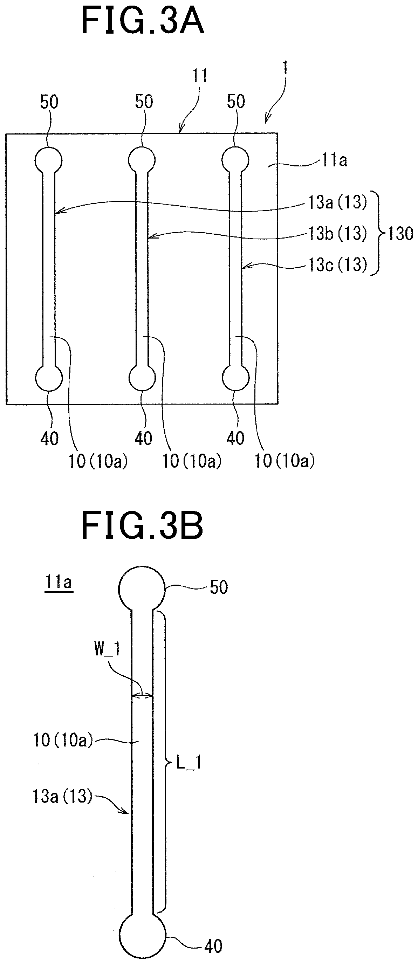

Fig. 3(a) is an outline plan view of the channel sections 13 formed in the barrier layer 11 in the microfluidic chip 1 illustrated in Fig. 1. Fig. 3(b) is an enlarged view of the channel section 13 (channel section 13a) illustrated in Fig. 3(a). To facilitate understandings, each of Figs. 3(a) and 3(b) does not illustrate the cover layer 12.

In the microfluidic chip 1, the channel sections 13 are each formed in the barrier layer 11 as an opening section. As illustrated in Fig. 3(a), the substrate 10 included in the bottom sections of the channel sections 13 is exposed in the channel sections 13 each of which is an opening section formed on the front surface 11a of the barrier layer 11. It is to be noted that the configuration according to the present disclosure is not limited to this. A configuration may be adopted in which the substrate 10 is not exposed on the bottom sections of the channel sections 13 (e.g., a configuration in which the bottom sections of the channel sections 13 are covered with the barrier layer 11 or another member). In addition, the channel section 13 is formed between an input section 40 and an output section 50. The input section 40 is an opening section formed in the barrier layer 11 and is a component for receiving a fluid introduced through the input section 4 of the cover layer 12 and introducing the fluid to the channel section 13. In addition, the output section 50 is an opening section formed in the barrier layer 11 and is a component for receiving a fluid passing through the channel section 13 and discharging the fluid to the output section 5 of the cover layer 12. Each of the output sections 50 is not limited to a component (discharge section) for discharging a fluid and may be a component (drug fixation section) for bringing the fluid and a drug solution into contact. For example, a drug solution is put in the output section 50 in advance, thereby making it possible to bring a fluid sent through the channel section 13 toward the output section 50 and the drug solution into contact. A component that functions as the discharge section or the drug solution fixation section of a fluid will be generically referred to as the "output section" below.

In the microfluidic chip 1, the input section 40 of the barrier layer 11 is provided at the position opposed to the input section 4 of the cover layer 12 and the output section 50 of the barrier layer 11 is provided at the position opposed to the output section 5 of the cover layer 12.

In the present embodiment, the channel group including the plurality of channel sections 13 may be regarded as a component including the input sections 40 and the output sections 50, and the channel sections 13. This allows the channel group to be regarded as a component including even regions that each introduce/discharge a fluid.

The cover layer 12 is bonded to the barrier layer 11 in which the channel sections 13 are formed, thereby surrounding each of the channel sections 13 with the substrate 10, the barrier layer 11, and the cover layer 12 and configuring the channel section 13 to allow a fluid to be transferred with no liquid leakage.

The dimensions of each of the channel sections 13 formed in the barrier layer 11 will be described. As illustrated in each of Fig. 2 and 3(b), a width W_1 of the channel section 13 is the width between the opposed barrier layers 11 (specifically, between the side surfaces 11b) and indicates the width (opening width) between the opening ends of an opening section formed in the barrier layer 11.

The channel sections 13 in the microfluidic chip 1 according to the present embodiment are each formed in the barrier layer 11 as an opening section having an opening width of 2000 µm (2 mm) or less. That is, in the present embodiment. Setting the width W_1 of the channel section 13 to 2000 µm or less makes it possible to prevent pressure applied to the region near the channel section 13 in the barrier layer 11 from increasing in comparison with other regions in the barrier layer 11 when the cover layer 12 that is a covering member is bonded to the barrier layer 11. That is, it is possible to increase the bonding stability of bonding the barrier layer 11 and the cover layer 12.

It is to be noted that the channel sections 13 may be each configured to increase or decrease in opening width (width W_1) between the input section 40 and the output section 50 in the microfluidic chip 1. It is thus sufficient if the width W_1 of the channel section 13 in the microfluidic chip 1 is 2000 µm or less in the region of the greatest opening width (the region of the greatest width between the side surfaces 11b of the barrier layers 11).

In addition, it is preferable that the width W_1 of the channel section 13 defined by the barrier layer 11 be 5 µm or more because the channel section 13 has to be greater in width than a substance to be analyzed/tested as with the thickness (the height of the channel section 13) of the barrier layer 11 described below. That is, it is preferable that the width W_1 of the channel section 13 be within a range of 5 µm or more and 2000 µm or less. This makes it possible to increase the bonding stability of bonding the barrier layer 11 and the cover layer 12 and increase the liquid transferability of a fluid including a substance to be analyzed/tested in the channel section 13.

In addition, as illustrated in Fig. 3(b), a channel length L of the channel section 13 indicates the length of the channel section 13 formed in the barrier layer 11 as an opening section. That is, the channel length L indicates the length between the opening ends between the input section 4 and the output section 5. That is, the channel length L is the length of a liquid transfer section in which a fluid introduced from the input section 4 is discharged from the output section 5. In the present embodiment, it is preferable that the channel length L of the channel section 13 be within a range of 10 mm or more and 100 mm or less. It is more preferable that the channel length L of the channel section 13 be within a range of 30 mm or more and 70 mm or more. It is still more preferable that the channel length L of the channel section 13 be within a range of 40 mm or more and 60 mm or less. Setting the channel length L within a range of 10 mm or more and 100 mm or less makes it possible to secure sufficient reaction time for a reaction solution.

In addition, the height of each of the channel sections 13 illustrated in Fig. 2, that is, a thickness T_1 of the barrier layer 11 on the substrate 10, is not particularly limited. The height (the thickness of T_1 of the barrier layer 11) of the channel section 13, however, has to be greater than a substance (e.g., drugs, bacteria, cells, red blood cells, white blood cells, or the like) to be analyzed/tested included in a fluid introduced to the channel section 13. It is therefore preferable that the height (the thickness T_1 of the barrier layer 11) of the channel section 13 be within a range of 5 µm or more and 500 µm or less. It is to be noted that the thickness of the barrier layer 11 is not limited to this.

Next, the opening area ratio of the barrier layer 11 will be described. The opening area ratio (Ar_1) of the barrier layer 11 is the ratio (Ar_1 (%) = opening area OA_1/superimposition area SA_1) of the area (opening area OA_1) of the opening regions of the barrier layer 11 to the area (superimposition area SA_1) of the whole of the region that forms the barrier layer 11 where the substrate 10 and the cover layer 12 overlap in plan view in the microfluidic chip 1.

It is to be noted that the cover layer 12 is provided with the input sections 4 and the output sections 5 as through holes as illustrated in Fig. 1. The superimposition area SA_1 does not therefore include the area of the regions in which the input sections 4 and the output sections 5 overlap with the substrate 10. In addition, similarly, the opening area OA_1 does not include the input sections 40 and the output sections 50 formed in the barrier layer 11 at the positions opposed to the input sections 4 and the output sections 5 of the cover layer 12.

For example, in the case of the microfluidic chip 1 illustrated in each of Figs. 1 and 2, the cover layer 12 overlaps with the whole of a front surface 10a of the substrate 10. The superimposition area SA_1 in this example is therefore the value (superimposition area SA_1 = area of front surface 10a of substrate 10 - area of input sections 4 and output sections 5) obtained by subtracting the area of the input sections 4 and the output sections 5 from the area of the upper surface of the substrate 10.

In addition, in the microfluidic chip 1 in this example, a plurality of channel sections 13 (channel group 130) are formed in the barrier layer 11. The opening area A2 in this example is therefore the sum of the opening areas (= width W_1 × channel length L of channel sections 13a to 13c) of the channel group 130 (channel sections 13a to 13c). The opening area ratio Ar_1 of the microfluidic chip 1 illustrated in each of Figs. 1 and 2 is therefore calculated as follows. opening area ratio Ar_1 (%) = (sum of opening areas of channel sections 13a to 13c/superimposition area SA_1)

Additionally, it is sufficient if the cover layer 12 functions as a covering member of the microfluidic chip 1. It is possible to design the cover layer 12 in various shapes depending on application. It is sufficient if the cover layer 12 is designed to cover at least part of the substrate 10, that is, a channel region 31, on which the channel sections 13 are formed. For example, it is possible to design the cover layer 12 to cover the whole of the substrate 10 on which the barrier layer 11 is formed in a plan view.

The opening area ratio Ar_1 of the barrier layer 11 of the microfluidic chip 1 according to the present embodiment is 60% or less. That is, the one or more channel sections 13 are formed in the microfluidic chip 1 so that the opening area ratio Ar_1 of the barrier layer 11 was 60% or less. Setting the opening area ratio Ar_1 of the barrier layer 11 to 60% or less makes it possible to prevent pressure applied to the region near the channel section 13 in the barrier layer 11 from increasing in comparison with other regions in the barrier layer 11 when the cover layer 12 that is a covering member is bonded to the barrier layer 11. That is, the increased resistance of the barrier layer 11 to pressure makes it possible to increase the bonding stability of bonding the barrier layer 11 and the cover layer 12.

In addition, the microfluidic chip 1 satisfies the condition that the width W_1 (opening width) of the channel section 13 is 2000 µm or less as described above in addition to the condition that the opening area ratio Ar_1 of the barrier layer 11 is 60% or less, thereby making it possible to further increase the bonding stability of the barrier layer 11 and the cover layer 12 and prevent the barrier layer 11 and the cover layer 12 from suffering damage.

That is, in the microfluidic chip 1, the channel sections 13 are each formed in the barrier layer 11 as an opening section having an opening width of 2000 µm or less and the barrier layer 11 has an opening area ratio of 60% or less. This makes it possible to provide a microfluidic chip in which the bonding stability (e.g., the resistance of the barrier layer 11 to pressure) is increased, members (the substrate 10, the barrier layer 11, and the cover layer 12) are prevented from suffering damage due to pressure at the time of fabricating the microfluidic chip 1, and no liquid leakage occurs when liquid flows.

It is sufficient if the microfluidic chip 1 according to the present embodiment satisfies the conditions that the channel sections 13 formed in the barrier layer 11 as opening sections each have an opening width of 2000 µm or less and the barrier layer 11 has an opening area ratio of 60% or less. It is possible to form the one or more channel sections 13 in the barrier layer 11.

In addition, in the microfluidic chip 1, the area of the barrier layer 11 other than the area of the opening regions, that is, the area (resin area RA_1) of the region of the barrier layer 11 in which resin remains, is calculated as the difference between the superimposition area SA_1 and the opening area OA_1 (resin area RA_1 = superimposition area SA_1 - opening area OA_1). The remainder of the ratio of the opening area OA_1 to the superimposition area SA_1 is thus a resin area ratio RAr_1 (%). Accordingly, when the opening area ratio is 60%, the resin area ratio RAr_1 is 40%. That is, to increase the resistance of the barrier layer 11 to pressure and increase the bonding stability of bonding the barrier layer 11 and the cover layer 12, it is sufficient if the resin area ratio RAr_1 of the barrier layer 11 is 40% or more.

In addition, although described in detail below, thermocompression bonding is favorably used as a method for bonding the barrier layer 11 and the cover layer 12. In a case where the barrier layer 11 and the cover layer 12 are bonded by thermocompression bonding, it is necessary to avoid defects in the bonding of the cover layer 12 and the barrier layer 11 caused by the deformation of the barrier layer 11 due to the thermal expansion coefficient.

Accordingly, in a case where the barrier layer 11 and the cover layer 12 are bonded (joined together) by thermocompression bonding in the microfluidic chip 1, it is preferable that the opening area ratio Ar_1 of the barrier layer 11 be within a range of 20% or more and 60% or less. Setting the opening area ratio of the barrier layer 11 within this range makes it possible to prevent the barrier layer 11 from being deformed because of the thermal expansion coefficient and avoid a defect (bonding failure) in the bonding of the cover layer 12 and the barrier layer 11 due to the deformation. In other words, it is preferable that the resin area ratio RAr_1 of the barrier layer 11 in the microfluidic chip 1 be within a range of 40% or more and 80% or less.

### (1.1.2) Method for Manufacturing Microfluidic Chip

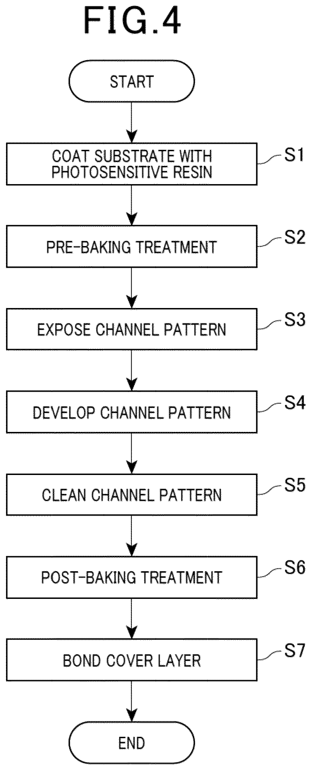

Next, a method for manufacturing the microfluidic chip 1 according to the present embodiment will be described. Fig. 4 is a flowchart illustrating an example of the method for manufacturing the microfluidic chip 1 according to the present embodiment.

A case where the barrier layer 11 is formed by using a photosensitive resin will be described here as an example.

### (Step S1)

In the method for manufacturing the microfluidic chip 1 according to the present embodiment, a step of coating the substrate 10 with resin is first performed. A resin layer that forms the barrier layer 11 is thus provided on the substrate 10.
In the method for manufacturing the microfluidic chip 1 according to the present embodiment, for example, a resin layer (photosensitive resin layer) including a photosensitive resin is formed on the substrate 10.

Examples of a method for forming the photosensitive resin layer on the substrate 10 include coating the substrate 10 with a photosensitive resin. It is possible to conduct the coating, for example, by spin coating, spray coating, bar coating, or the like. Among these, spin coating is preferable from the perspective of the controllability of the film thickness. It is possible to coat the substrate 10 with, for example, photosensitive resins having a variety of forms such as a liquid photosensitive resin, a solid photosensitive resin, a gel photosensitive resin, and a film photosensitive resin. Among these, it is preferable to form a photosensitive resin layer by using a liquid resist.

In addition, it is preferable that the substrate 10 be coated with resin (e.g., photosensitive resin) such that the thickness of the resin layer (e.g., photosensitive resin layer), that is, the thickness of the barrier layer 11 is within a range of 5 µm or more and 500 µm or less. It is to be noted that the thickness of the barrier layer 11 is not limited to this.

### (Step S2)

Once the photosensitive resin is formed on the substrate 10, a step of conducting heating treatment (pre-baking treatment) is then performed for the purpose of removing a solvent medium (solvent) included in the resin (e.g., photosensitive resin) with which the substrate 10 is coated. It is to be noted that the pre-baking treatment is not an essential step for the method for manufacturing the microfluidic chip 1 according to the present embodiment. It is sufficient if the pre-baking treatment is conducted as appropriate at the optimum temperature and time depending on the characteristics of the resin. For example, in a case where the resin layer on the substrate 10 is a photosensitive resin, the pre-baking temperature and time are adjusted to the optimum conditions as appropriate depending on the characteristics of the photosensitive resin.

### (Step S3)

Next, a step of exposing the resin (e.g., photosensitive resin) with which the substrate 10 is coated is performed. Specifically, the photosensitive resin with which the substrate 10 is coated is exposed to have a channel pattern drawn thereon. For example, an exposure apparatus or a laser lithography apparatus producing ultraviolet light as a light source allows for the exposure. Among these, exposure is preferable in which a proximity exposure or contact exposure apparatus producing ultraviolet light as a light source is used. In the case of a proximity exposure apparatus, exposure is performed through a photomask having a channel pattern arrangement in the microfluidic chip 1. It is sufficient if a photomask or the like having a two-layer structure of chromium and chromium oxide as a light-shielding film is used as the photomask.

In addition, as described above, a photosensitive resin having photosensitivity to light having a wavelength of 190 nm or more and 400 nm or less, which is in the ultraviolet region, is used for the barrier layer 11. It is thus sufficient if the photosensitive resin with which the substrate 10 is coated is sensitized to light having a wavelength of 190 nm or more and 400 nm or less in this step (exposure step).

It is to be noted that, in a case where a chemically amplified resist or the like is used to form a resin layer on the substrate 10, it is favorable to further conduct heating treatment (post-exposure bake: PEB) after exposure to accelerate an acid catalyst reaction caused by the exposure.

### (Step S4)

Next, a step of developing the exposed photosensitive resin to form a channel pattern is performed.

The development is conducted by reacting a photosensitive resin and a development liquid, for example, in a development apparatus of a spraying type, a dipping type, a puddle type, or the like. It is possible to use, for example, a sodium carbonate aqueous solution, tetramethyl ammonium hydroxide, potassium hydroxide, an organic solvent, or the like for the development liquid. It is sufficient if the optimum development liquid depending on the characteristics of the photosensitive resin is used as appropriate. The development liquid is not limited to them. In addition, it is possible to adjust the concentration or the development processing time to the optimum condition as appropriate depending on the characteristics of the photosensitive resin.

### (Step S5)

Next, a step of cleaning the resin layer (photosensitive resin layer) on the substrate 10 to completely remove the development liquid used for the development is performed. It is possible to carry out the cleaning, for example, by a cleaning apparatus of a spraying type, a showering type, an immersing type, or the like. It is sufficient if the optimum cleaning water for removing the development liquid used for the development process is used as the cleaning water as appropriate, for example, from pure water, isopropyl alcohol, or the like. After being cleaned, the resin layer is, for example, dried by a spin dryer or an IPA vapor dryer, or naturally dried.

### (Step S6)

Next, a step of conducting heating treatment (post-bake) on the channel pattern, that is, the barrier layer 11 that forms the channel sections 13 is performed. The residual moisture at the time of development or cleaning is removed through this post-baking treatment. The post-baking treatment is conducted by using, for example, a hot plate, an oven, or the like. In the case of insufficient drying in the cleaning step of step S5 described above, the development liquid or the moisture at the time of cleaning remains in the barrier layer 11 in some cases. In addition, solvent that is not removed through the pre-baking treatment also remains in the barrier layer 11 in some cases. It is possible to remove them by conducting post-baking treatment.

### (Step S7)

Next, a step of bonding the cover layer 12 to the barrier layer 11 subjected to the post-baking treatment is performed. In this step, the cover layer 12 is bonded to the opposite surface of the barrier layer 11 to the substrate 10 as illustrated in Fig. 1. This covers the channel sections 13 with the cover layer 12 to form the microfluidic chip 1 illustrated in Fig. 1. In this step, pressure is applied to narrow the gap between the barrier layer 11 and the cover layer 12 and bond the barrier layer 11 and the cover layer 12 with no gap in between. It is to be noted that such an extremely minute gap that causes no liquid leakage when liquid flows through the microfluidic chip 1 is permitted in the barrier layer 11 and the cover layer 12 "bonded with no gap in between".

As a method for bonding the barrier layer 11 and the cover layer 12, a thermocompression bonding method, a method in which an adhesive is used, or a method in which contact surfaces are bonded by conducting surface modification treatment on the bonding surfaces of the barrier layer 11 and the cover layer 12 may be carried out.

In the thermocompression bonding method described above, for example, surface modification treatment is conducted on the bonding surfaces of the barrier layer 11 and the cover layer 12 and thermocompression bonding is then conducted. It is sufficient as the surface modification treatment if a step of conducting surface modification treatment on the barrier layer 11 and the cover layer 12 (covering member) which has not yet been bonded to the barrier layer 11 is performed, for example, after post-baking treatment. An example of the surface modification treatment includes, for example, plasma treatment.

In a case where members (the barrier layer 11 and the cover layer 12 in this example) are bonded to each other by thermocompression bonding, it is preferable to conduct thermocompression bonding in which a thermal press machine or a thermal roll machine is used, for example, after the surface modification treatment is conducted. Providing the cover layer 12 on the barrier layer 11 by thermocompression bonding without using any adhesive makes it possible to prevent an adhesive component from being eluted into a channel and prevent a reaction of a solution in a channel from being inhibited.

It is desirable that the cover layer 12 have holes corresponding to the input sections 4 and the output sections 5 (see Fig. 1) of fluids formed therein in advance before the cover layer 12 is bonded to the barrier layer 11. This makes it possible to prevent problems with the occurrence of debris and contamination in comparison with a case where holes are made after the barrier layer 11 is bonded.

It is preferable that the cover layer 12 be formed to have a thickness which is within a range of 10 µm or more and 10 mm or less in consideration of through holes to be provided. In addition, it is possible to form the cover layer 12 by using any of a light-transmissive material or a non-light-transmissive material. It is preferable to use resin, glass, or the like as the light-transmissive material. It is to be noted that the thickness and the material of the cover layer 12 are not limited to the configuration described above in the present invention.

In addition, in a case where the barrier layer 11 and the cover layer 12 are bonded by using an adhesive as a method for bonding the barrier layer 11 and the cover layer 12, it is possible to select the adhesive on the basis of the affinity or the like with the materials included in the barrier layer 11 and the cover layer 12. The adhesive is not limited in particular as long as the adhesive allows the barrier layer 11 and the cover layer 12 to be bonded. For example, it is possible to use an acrylic resin-based adhesive, a urethane resin-based adhesive, an epoxy resin-based adhesive, or the like as the adhesive in the present embodiment.

In addition, the method for bonding by conducting surface modification treatment includes plasma treatment, corona discharge treatment, excimer laser treatment, and the like. In this case, it is sufficient if the reactivity of the surface of the barrier layer 11 is increased and the optimum treatment method is selected as appropriate depending on the affinity and the adhesion compatibility between the barrier layer 11 and the cover layer 12.

In this way, it is possible to form the barrier layer 11 included in the channel sections 13 on the substrate 10 by using photolithography in the method for manufacturing the microfluidic chip 1 according to the present embodiment.

For example, in a case where the photosensitive resin with which the substrate 10 is coated is a positive resist, the exposure region is dissolved at the time of development to serve as the channel sections 13. The photosensitive resin remaining in the non-exposure region serves as the barrier layer 11. In addition, in a case where the photosensitive resin with which the substrate 10 is coated is a negative resist, the photosensitive resin remaining in the exposure region serves as the barrier layer 11 and the non-exposure region is dissolved at the time of development to serve as the channel sections 13.

As described above, the method for manufacturing the microfluidic chip 1 according to the present embodiment includes the step (step S1 described above) of coating the substrate 10 with resin, the step (step S3 described above) of exposing the resin used for the coating, the steps (step S4 described above and step S5 described above) of developing and cleaning the exposed resin to form the barrier layer 11 that defines the channel section 13 on the substrate 10, the step (step S6 described above) of conducing post-baking treatment on the barrier layer 11, and the step (step S8 described above) of bonding the cover layer 12 to the opposite surface of the barrier layer 11 to the substrate 10. Further, the redundant resin (photosensitive resin layer) on the substrate 10 is removed in the development step (step S4 described above) to form an opening section (channel pattern) having an opening width of 2000 µm or less and serving as the channel section 13 in the barrier layer 11 and cause the barrier layer 11 to have an opening area ratio of 60% or less.

This makes it possible to fabricate the microfluidic chip 1 in which the bonding stability (e.g., the resistance of the barrier layer 11 to pressure) is increased, members (the substrate 10, the barrier layer 11, and the cover layer 12) are prevented from suffering damage due to pressure at the time of bonding the barrier layer 11 and the cover layer 12, and no liquid leakage occurs when liquid flows.

In addition, when the microfluidic chip 1 is fabricated, a seal is affixed or predetermined information (e.g., the identification number of the microfluidic chip, or the like) is printed in some cases by an ink jet printer in the region of the cover layer 12 that does not overlap with the channel section 13 in plan view, that is, the region of the cover layer 12 that is not opposed to the channel section 13. As described above, the microfluidic chip 1 has increased bonding stability. This also makes it possible to prevent the barrier layer 11 and the cover layer 12 from suffering damage due to pressure at the time of pasting a seal to or printing predetermined information on the cover layer 12 bonded to the barrier layer 11.

Further, in the method for manufacturing the microfluidic chip 1 according to the present embodiment, pressure is applied to narrow the gap between the barrier layer 11 and the cover layer 12 and bond the barrier layer 11 and the cover layer 12 with no gap in between in the step (step S8 described above) of bonding the barrier layer 11 and the cover layer 12. As described above, in the method for manufacturing the microfluidic chip 1 according to the present embodiment, the channel section 13 formed in the barrier layer 11 has an opening width of 2000 µm or less and the barrier layer 11 has an opening area ratio of 60% or less. This increases the resistance of the barrier layer 11 to pressure and increases the bonding stability (the resistance of the wall section to pressure) in the step of bonding a plurality of members (the barrier layer 11 and the cover layer 12 in this example) when the microfluidic chip 1 is fabricated. It is therefore possible to provide a microfluidic chip in which members (the substrate 10, the barrier layer 11, and the cover layer 12) are prevented from suffering damage due to pressure at the time of bonding and no liquid leakage occurs when liquid flows. In addition, the increased bonding stability eliminates the necessity of bonding at low pressure to prevent members from suffering damage due to pressure when the microfluidic chip 1 is fabricated. It is possible to prevent a defect (bonding failure) such as insufficiently bonding members because of the bonding at low pressure.

In addition, in a case where the barrier layer 11 and the cover layer 12 are bonded by thermocompression bonding in step S8 described above, it is preferable to form a channel pattern, that is, the channel sections 13, in the barrier layer 11 in the development step (step S4) at the time of forming the barrier layer 11 to set the opening area ratio Ar_1 to 20% or more and 60% or less.

That is, it is preferable in the method for manufacturing the microfluidic chip 1 according to the present embodiment to set the opening area ratio Ar_1 of the barrier layer 11 to 20% or more and 60% or less in the development step described above and bond the barrier layer 11 and the cover layer 12 by thermocompression bonding in the step of bonding the barrier layer 11 and the cover layer 12. This prevents the resistance of the barrier layer 11 to pressure from reducing and prevents the barrier layer 11 and the cover layer 12 from being deformed because of the thermal expansion coefficients at the time of heating. A defect in the bonding of the cover layer 12 and the barrier layer 11 (bonding failure) caused by the deformation is avoided to increase the bonding stability. In addition, it is possible to fabricate the microfluidic chip 1 in which members (the substrate 10, the barrier layer 11, and the cover layer 12) are prevented from suffering damage and warpage due to pressure and heating at the time of bonding the barrier layer 11 and the cover layer 12 and no liquid leakage occurs when liquid flows.

### (1.1.3) Modification Examples

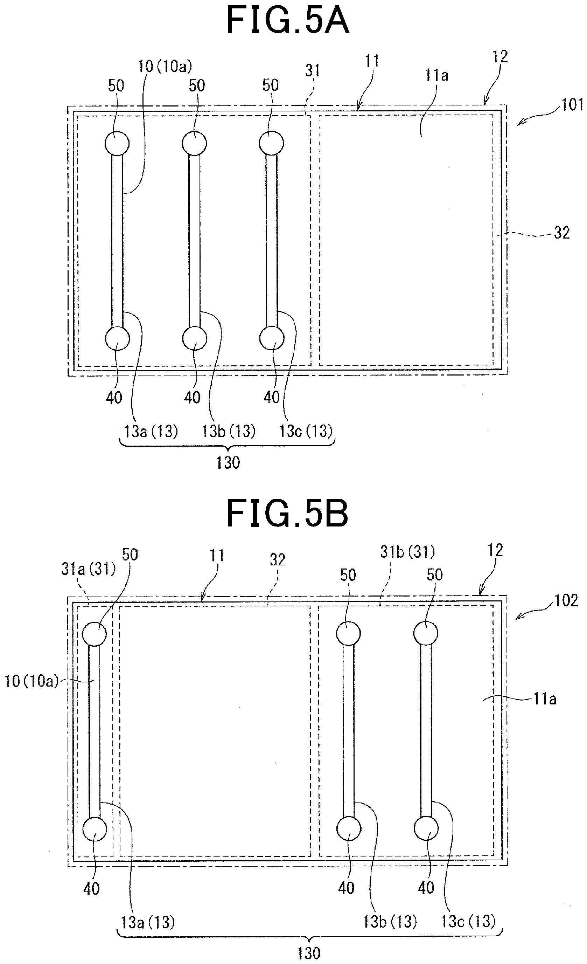

A microfluidic chip according to a modification example of the present embodiment will be described below by using Fig. 5. Fig. 5(a) is an outline plan view for describing a configuration example of a microfluidic chip 101 according to the modification example of the present embodiment.

As with the microfluidic chip 1, the microfluidic chip 101 includes the substrate 10, the barrier layer 11 that forms the channel group 130 including the plurality of channel sections 13 (channel sections 13a to 13c) on the substrate 10, and the cover layer 12. It is to be noted that Fig. 5(a) illustrates the transparent cover layer 12 by a dot-dashed line to facilitate understanding.

As illustrated in Fig. 5(a), the microfluidic chip 101 is different from the microfluidic chip 1 in that the channel region 31 and a support region (an example of a non-channel region) 32 are formed in the barrier layer 11.

The channel region 31 in the barrier layer 11 is a region in which the channel section 13 is formed. It is sufficient if the at least one channel section 13 is formed in the channel region 31. In this example, the channel region 31 is provided with the three channel sections 13a, 13b, and 13c. In contrast, the support region 32 in the barrier layer 11 is a region in which the channel section 13 is not provided.

The channel section 13 is not formed in the support region 32 in the barrier layer 11, leaving more resin than in the channel region 31. It is therefore possible to use the support region 32 in the barrier layer 11 as a support member, that is, a covering member support section, that supports the cover layer 12 which is a covering member of the microfluidic chip 101. That is, the channel region 31 and the support region 32 that functions as a covering member support section are formed in the barrier layer 11 in the microfluidic chip 101, thereby further increasing the bonding stability of the barrier layer 11 and the cover layer 12. This makes it possible to reliably provide a microfluidic chip in which members are further prevented from suffering damage due to pressure at the time of bonding the barrier layer 11 and the cover layer 12 and no liquid leakage occurs.

In addition, the barrier layer 11 includes the support region 32 and the rigidity of the microfluidic chip 1 itself thus increases. It is also possible to prevent members from suffering damage due to pressure applied at the time of storage or use.

It is to be noted that the barrier layer 11 is equal in thickness between the channel region 31 and the support region 32 in the barrier layer 11 to increase the stability of bonding to the cover layer 12.

In addition, it is possible to impart a function obtained by using the remaining resin material to part of the support region 32 in which the channel section 13 is not provided. It is possible to imprint characters indicating predetermined information (e.g., an identification number, a product name, or the like), for example, by printing the characters with an ink jet printer or performing a punching process on part of the resin. This causes the support region 32 to function as an information display section. This is not limitative. It is possible to use the support region 32 in the barrier layer 11 for various purposes depending on the application of the microfluidic chip, or the like. It is possible to impart various functions.

In Fig. 5(a), the channel region 31 is disposed in the left region of the barrier layer 11 and the support region 32 is disposed in the right region of the barrier layer 11 in a plan view as an example. It is to be noted that the present disclosure is not limited to this. In the barrier layer 11, the channel region 31 may be disposed in the right region and the support region 32 may be disposed in the left region.

In addition, in a case where the plurality of channel sections 13 is formed in the barrier layer 11 as in a microfluidic chip 102 illustrated in Fig. 5(b), the plurality of channel regions 31 may be formed. In this case, the support region 32 may be disposed between the plurality of channel regions 31. In Fig. 5(b), the channel region 31 is divided into two regions (channel regions 31a and 31b) and the support region 32 is provided between the channel regions 31a and 31b. In this example, the channel section 13a that is one of the plurality of channel sections 13 is provided in the channel region 31a and the rest (channel sections 13b and 13c) of the channel sections 13 are provided in the channel region 31b. In a case where the plurality of channel sections 13 and the plurality of channel regions 31 are formed in the barrier layer 11, it is sufficient if the at least one channel section 13 of the plurality of channel sections 13 is formed in each of the channel regions 31 (the channel regions 31a and 31b in this example).

It is to be noted that each of Figs. 5(a) and 5(b) is a configuration example of a microfluidic chip provided with the channel region 31 and the support region 32 in the barrier layer 11 and Figs. 5(a) and 5(b) are not limited to the microfluidic chips 101 and 102 according to the present modification example. It is possible to adopt various aspects depending on application. For example, the microfluidic chip may be provided with the plurality of support regions 32 in the barrier layer 11.

In this way, the barrier layer 11 of a microfluidic chip (any of microfluidic chips 101 and 102) may include the channel region 31 in which the at least one channel is formed and the support region 32 in which no channel is formed. This makes it possible to reliably provide a microfluidic chip in which the bonding stability of the barrier layer 11 and the cover layer 12 are further increased in the microfluidic chip 1, members are further prevented from suffering damage due to pressure at the time of bonding the barrier layer 11 and the cover layer 12, and no liquid leakage occurs.

### (1.2) 1-2-th Embodiment

### (1.2.1) Overview of Microfluidic Chip

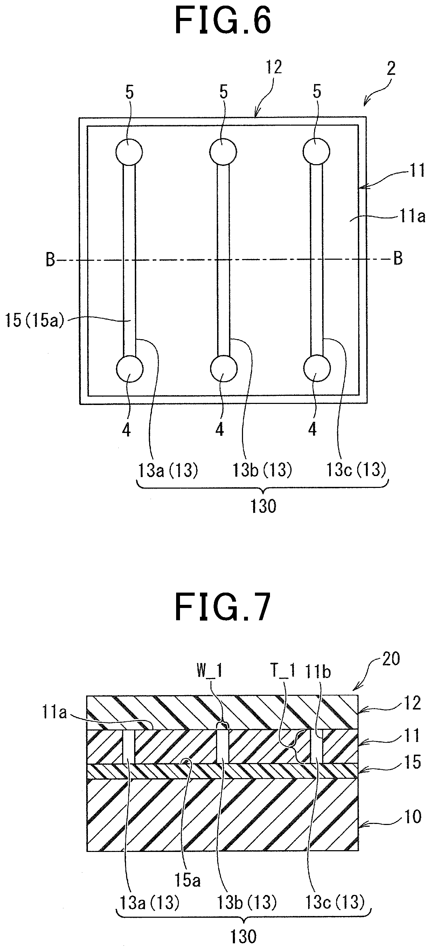

A microfluidic chip 2 according to the 1-2-th embodiment of the present disclosure will be described below by using Figs. 6 and 7. Fig. 6 is an outline plan view describing a configuration example of the microfluidic chip 2 according to the 1-2-th embodiment of the present disclosure. Fig. 7 is a cross-sectional view for describing the configuration example of the microfluidic chip 2 according to the 1-2-th embodiment of the present disclosure. Fig. 7 is an outline cross-sectional view of a cross section of the microfluidic chip 2 taken along a line B-B illustrated in Fig. 6.

As illustrated in each of Figs. 6 and 7, the microfluidic chip 2 includes the substrate 10, an adhesive layer 15 disposed on the substrate 10, the barrier layer 11 that forms the channel group 130 including the channel sections 13a to 13c above the substrate 10, and the cover layer 12. Specifically, the microfluidic chip 2 includes the adhesive layer 15 between the barrier layer 11 and the substrate 10. The microfluidic chip 2 is different from the microfluidic chip 1 according to the 1-1-th embodiment described above in that the microfluidic chip 2 includes the adhesive layer 15.

### (1.2.2) Configuration of Adhesive Layer

The adhesive layer 15 will be described below. It is to be noted that the respective components (the substrate 10, the barrier layer 11, the cover layer 12, and the channel sections 13) other than the adhesive layer 15 are similar to those of the microfluidic chip 1, and will be thus denoted by the same reference signs and the description thereof will be omitted.

The substrate 10 of the microfluidic chip 2 may be subjected to hydrophobization surface treatment (HMDS treatment) or coated with a thin film of resin for the purpose of increasing the adhesion between the substrate 10 and the resin layer (e.g., photosensitive resin layer), that is, the barrier layer 11. In particular, for example, in a case where glass is used for the substrate 10, the thin adhesive layer 15 may be provided between the substrate 10 and the barrier layer 11 (photosensitive resin layer) as illustrated in Fig. 5. In this case, a fluid (e.g., liquid) flowing in each of the channel sections 13 comes into contact with the adhesive layer 15 instead of the substrate 10. It is therefore sufficient if the adhesive layer 15 has resistance to the fluid introduced to the channel section 13. Providing the adhesive layer 15 on the substrate 10 also makes it possible to contribute to an increase in the resolution of a channel pattern by the photosensitive resin, or the like.

As described above, the adhesive layer 15 is formed on the substrate 10. Therefore, as illustrated in each of Figs. 6 and 7, in the microfluidic chip 2 according to the present embodiment, the bottom section of each of the channel sections 13 is formed by the adhesive layer 15. The adhesive layer 15 (specifically, a front surface 15a of the adhesive layer 15) included in the bottom section of the channel section 13 is exposed in the channel section 13.

### <First Example>

Examples of the first embodiment of the present disclosure will be specifically described below, but the first embodiment of the present disclosure is not limited to them.

### [Fabrication of Microfluidic Chip]

### (1.1-th Examples)

### <Example 1-1>

The present inventor manufactured a microfluidic chip by forming a barrier layer on a substrate and bonding the barrier layer and a cover layer as illustrated in each of Figs. 1 and 2.

A method for manufacturing the microfluidic chip 1 according to Example 1-1 in the 1.1-th Examples will be described. First, glass was used as a substrate.

The glass substrate was coated with a transparent photosensitive resin to form a photosensitive resin layer. An acryl-based photosensitive resin was used for the photosensitive resin. The glass substrate was coated with the photosensitive resin by using a spin coater at a rotation speed of 1100 rpm for 30 seconds. The rotation speed and the time were adjusted to obtain a film thickness of 50 µm. Next, heating treatment (pre-bake) was conducted on a hot plate for the purpose of removing a residual solvent medium included in the photosensitive resin. Pre-baking was carried out at a temperature of 90°C for 20 minutes.

Next, the photosensitive resin layer on the glass substrate was exposed to draw a channel pattern. Specifically, the photosensitive resin was subjected to pattern exposure through a photomask having a microfluidic channel pattern arrangement. A photomask having a two-layer structure of chromium and chromium oxide as a light-shielding film was used as the photomask. In addition, a proximity exposure apparatus was used for the exposure. The exposure apparatus carried out exposure by using a high-pressure mercury lamp as a light source and having a cut filter of an i-line filter therein. The exposure value was 170 mJ/cm².

Next, the exposed photosensitive resin layer was developed and used as a barrier layer in which a channel pattern was formed. Specifically, the photosensitive resin layer was developed for 60 seconds by using an alkali development liquid (TMAH 2.38%) to dissolve unexposed portions and pattern channel structures.

Subsequently, shower washing with ultrapure water was performed to remove the development liquid from the photosensitive resin layer on the substrate, and the substrate was dried using a spin dryer.

Next, the channel pattern was subjected to heating treatment (post-bake) in an oven at 100°C for ten minutes.

In the development step described above, channel structures were formed (patterned) so that a channel section had an opening width (channel width) of 10 µm and a channel length of and cause the opening area ratio Ar_1 of the barrier layer to be 10% in the barrier layer subjected to the post-baking (the remaining moisture was removed). That is, a barrier layer including a channel section having an opening width of 10 µm and having 10% as the opening area ratio Ar_1 of the barrier layer was formed in the development.

Next, the bonding surfaces of the barrier layer in which a channel section was formed and a separately fabricated cover layer were subjected to surface modification treatment and the barrier layer and the cover layer were then bonded by pressure bonding (pressure bonding at room temperature) under the following conditions. <Pressure Bonding Conditions>
adhesive: acryl-based adhesive (model number 9969 manufactured by 3M Co., Ltd.)
apparatus used: rubber roller
pressure: 3 N/cm²
temperature: 25°C (room temperature)
press time: three seconds

In addition, polycarbonate having a channel inlet and a channel outlet made in advance and having a thickness of 5 mm was used for the cover layer.

This offered a microfluidic chip according to this Example.

### <Example 1-2>

Channel structures were formed by development in a barrier layer formed on a glass substrate so that the channel sections had an opening width of 500 µm. Except for this, a microfluidic chip according to Example 1-2 was obtained as in Example 1-1.

### <Example 1-3>

Channel structures were formed by development in a barrier layer formed on a glass substrate so that channel sections had an opening width of 2000 µm. Except for this, a microfluidic chip according to Example 1-3 was obtained as in Example 1-1.

### <Example 1-4>

Channel structures were formed by development so that a barrier layer formed on a glass substrate had an opening area ratio of 30%. Except for this, a microfluidic chip according to Example 1-4 was obtained as in Example 1-1.

### <Example 1-5>

Channel structures were formed by development in a barrier layer formed on a glass substrate so that the channel sections had an opening width of 500 µm. Except for this, a microfluidic chip according to Example 1-5 was obtained as in Example 1-4.

### <Example 1-6>

Channel structures were formed by development in a barrier layer formed on a glass substrate so that channel sections had an opening width of 2000 µm. Except for this, a microfluidic chip according to Example 1-6 was obtained as in Example 1-4.

### <Example 1-7>

Channel structures were formed by development so that a barrier layer formed on a glass substrate had an opening area ratio of 60%. Except for this, a microfluidic chip according to Example 1-7 was obtained as in Example 1-1.

### <Example 1-8>

Channel structures were formed by development in a barrier layer formed on a glass substrate so that the channel sections had an opening width of 500 µm. Except for this, a microfluidic chip according to Example 1-8 was obtained as in Example 1-7.

### <Example 1-9>

Channel structures were formed by development in a barrier layer formed on a glass substrate so that channel sections had an opening width of 2000 µm. Except for this, a microfluidic chip according to Example 1-9 was obtained as in Example 7.

### <Comparative Example 1-1>

Channel structures were formed by development so that a barrier layer formed on a glass substrate had an opening area ratio of 70%. Except for this, a microfluidic chip according to a comparative example 1-1 was obtained as in Example 1-1.

### <Comparative Example 1-2>

Channel structures were formed by development in a barrier layer formed on a glass substrate so that the channel sections had an opening width of 500 µm. Except for this, a microfluidic chip according to a comparative example 1-2 was obtained as in the comparative example 1-1.

### <Comparative Example 1-3>

Channel structures were formed by development in a barrier layer formed on a glass substrate so that channel sections had an opening width of 2000 µm. Except for this, a microfluidic chip according to a comparative example 1-3 was obtained as in the comparative example 1-1.

### <Comparative Example 1-4>

Channel structures were formed by development in a barrier layer formed on a glass substrate so that channel sections had an opening width of 3000 µm and so that the barrier layer had an opening area ratio of 30%. Except for this, a microfluidic chip according to a comparative example 1-4 was obtained as in Example 1-1.

### <Comparative Example 1-5>

Channel structures were formed by development in a barrier layer formed on a glass substrate so that channel sections had an opening width of 3000 µm and so that the barrier layer had an opening area ratio of 70%. Except for that, a microfluidic chip according to a comparative example 1-5 was obtained as in Example 1-1.

### [Assessment Methods]

The presence or absence of damage and liquid leakage at the time of bonding the cover layers were assessed for the microfluidic chips according to Example 1-1 to Example 1-9 and the comparative example 1-1 to the comparative example 1-5 in the following methods after the bonding.

### (Presence or Absence of Damage)

The presence or absence of damage was visually confirmed for each of the microfluidic chips according to Example 1-1 to Example 1-9 and the comparative example 1-1 to the comparative example 1-5. "∘ (acceptable)" indicates that no damage was visually confirmed and "× (unacceptable)" indicates that damage was visually confirmed.

### (Presence or Absence of Liquid Leakage)

A 10-µL colored reaction solution was collected by a pipette and introduced from an inlet channel of the cover layer for each of the microfluidic chips according to Example 1-1 to Example 1-9 and the comparative example 1-1 to the comparative example 1-5. The transfer of the solution was observed with a microscope.

The liquid leakage state of each microfluidic chip was assessed in the two levels of "∘" and "×" by the following criterion on the basis of a result of the observation.

### <Assessment Criterion>

∘: no liquid leakage was observed from the channel at a portion at which the barrier layer and the cover layer are bonded
×: liquid leakage was observed from the channel at a portion at which the barrier layer and the cover layer are bonded

Assessment results of the respective Examples and the respective comparative examples in the 1.1-th Examples will be shown in Table 1 along with the opening area ratios of the barrier layers in the microfluidic chips, the opening widths of the channels, the channel lengths, and the pressure bonding temperatures.

**[Table 1]**

| | Barrier layer | | | Pressure bonding temperature | Assessment | |
|---|---|---|---|---|---|---|
| | Opening area ratio | Opening width of channel | Channel length | | Damage state after bonding | Liquid leakage |
| Example 1-1 | 10% | 10 µm | 50 mm | 25°C | ○ | ○ |
| Example 1-2 | 10% | 500 µm | 50 mm | 25°C | ○ | ○ |
| Example 1-3 | 10% | 2000 µm | 50 mm | 25°C | ○ | ○ |
| Example 1-4 | 30% | 10 µm | 50 mm | 25°C | ○ | ○ |
| Example 1-5 | 30% | 500 µm | 50 mm | 25°C | ○ | ○ |
| Example 1-6 | 30% | 2000 µm | 50 mm | 25°C | ○ | ○ |
| Example 1-7 | 60% | 10 µm | 50 mm | 25°C | ○ | ○ |
| Example 1-8 | 60% | 500 µm | 50 mm | 25°C | ○ | ○ |
| Example 1-9 | 60% | 2000 µm | 50 mm | 25°C | ○ | ○ |
| Comparative example 1-1 | 70% | 10 µm | 50 mm | 25°C | × | × |
| Comparative example 1-2 | 70% | 500 µm | 50 mm | 25°C | × | × |
| Comparative example 1-3 | 70% | 2000 µm | 50 mm | 25°C | × | × |
| Comparative example 1-4 | 30% | 3000 µm | 50 mm | 25°C | × | × |
| Comparative example 1-5 | 70% | 3000 µm | 50 mm | 25°C | × | × |

It was confirmed that the microfluidic chips according to Example 1-1 to Example 1-9 in the 1.1-th Examples did not each suffer any damage after bonding and no liquid leakage occurred after liquid flowed. In contrast, the microfluidic chips according to the comparative example 1-1 to the comparative example 1-5 each suffered damage after bonding. Further, liquid leakage was confirmed after liquid flowed.

As the results described above, it was confirmed that the opening area ratio of the wall section and the dimensions (e.g., the opening width of a channel) of an opening section formed in the wall section were controlled in each of the microfluidic chips according to the 1.1-th Examples to satisfy the specific conditions, thereby increasing the bonding stability of bonding a plurality of members (the wall section and the covering member here), preventing members (the substrate, the wall section, and the covering member) from suffering damage due to pressure at the time of bonding the barrier layer and the cover layer, and without liquid leakage occurring when liquid flowed.

Specifically, it was confirmed that a channel section was formed in the barrier layer as an opening section having an opening width of 2000 µm or less and the barrier layer had an opening area ratio of 60% or less as in each of the microfluidic chips according to Example 1-1 to Example 1-9 in the 1.1-th Examples to prevent members from suffering damage due to pressure at the time of bonding the barrier layer and the cover layer and cause no liquid leakage when liquid flowed.

### (1.2-th Examples)

### <Example 2-1>

Channel structures were formed by development so that a channel section had an opening width of 10 µm and so that a barrier layer formed on a glass substrate had an opening area ratio of 20%.

Further, the bonding surfaces of the barrier layer in which a channel section was formed and a separately fabricated cover layer were subjected to surface modification treatment and the barrier layer and the cover layer were then bonded by pressure bonding (thermocompression bonding) under the following conditions.

### <Pressure Bonding Conditions>

apparatus used: thermal press machine
pressure: 2 MPa
temperature: 50°C
press time: five min

Except for this, the microfluidic chip according to Example 2-1 in 1.2-th Examples was fabricated in a method similar to that of Example 1-1 in the 1.1-th Examples.

### <Example 2-2>

Channel structures were formed by development in a barrier layer formed on a glass substrate so that the channel sections had an opening width of 500 µm. Except for this, a microfluidic chip according to Example 2-2 of the 1.2-th Examples was obtained as in Example 2-1 of the 1.2-th Examples.

### <Example 2-3>

Channel structures were formed by development in a barrier layer formed on a glass substrate so that channel sections had an opening width of 2000 µm. Except for this, a microfluidic chip according to Example 2-3 of the 1.2-th Examples was obtained as in Example 2-1 of the 1.2-th Examples.

### <Example 2-4>

Channel structures were formed by development so that a barrier layer formed on a glass substrate had an opening area ratio of 30%. Except for this, a microfluidic chip according to Example 2-4 of the 1.2-th Examples was obtained as in Example 2-1 of the 1.2-th Examples.

### <Example 2-5>

Channel structures were formed by development in a barrier layer formed on a glass substrate so that the channel sections had an opening width of 500 µm. Except for this, a microfluidic chip according to Example 2-5 of the 1.2-th Examples was obtained as in Example 2-4 of the 1.2-th Examples.

### <Example 2-6>

Channel structures were formed by development in a barrier layer formed on a glass substrate so that channel sections had an opening width of 2000 µm. Except for this, a microfluidic chip according to Example 2-6 of the 1.2-th Examples was obtained as in Example 2-4 of the 1.2-th Examples.

### <Example 2-7>

Channel structures were formed by development so that a barrier layer formed on a glass substrate had an opening area ratio of 60%. Except for this, a microfluidic chip according to Example 2-7 of the 1.2-th Examples was obtained as in Example 2-1 of the 1.2-th Examples.

### <Example 2-8>

Channel structures were formed by development in a barrier layer formed on a glass substrate so that the channel sections had an opening width of 500 µm. Except for this, a microfluidic chip according to Example 2-8 of the 1.2-th Examples was obtained as in Example 2-7 of the 1.2-th Examples.

### <Example 2-9>

Channel structures were formed by development in a barrier layer formed on a glass substrate so that channel sections had an opening width of 2000 µm. Except for this, a microfluidic chip according to Example 2-9 of the 1.2-th Examples was obtained as in Example 2-7 of the 1.2-th Examples.

### <Comparative Example 2-1>

Channel structures were formed by development so that a barrier layer formed on a glass substrate had an opening area ratio of 70%. Except for this, a microfluidic chip according to a comparative example 2-1 of the 1.2-th Examples was obtained as in Example 2-1 of the 1.2-th Examples.

### <Comparative Example 2-2>

Channel structures were formed by development in a barrier layer formed on a glass substrate so that the channel sections had an opening width of 500 µm. Except for this, a microfluidic chip according to a comparative example 2-2 of the 1.2-th Examples was obtained as in the comparative example 2-1 of the 1.2-th Examples.

### <Comparative Example 2-3>

Channel structures were formed by development in a barrier layer formed on a glass substrate so that channel sections had an opening width of 2000 µm. Except for this, a microfluidic chip according to a comparative example 2-3 of the 1.2-th Examples was obtained as in the comparative example 2-1 of the 1.2-th Examples.

### <Comparative Example 2-4>

Channel structures were formed by development in a barrier layer formed on a glass substrate so that channel sections had an opening width of 3000 µm and so that the barrier layer had an opening area ratio of 30%. Except for this, a microfluidic chip according to a comparative example 2-4 of the 1.2-th Examples was obtained as in Example 2-1 of the 1.2-th Examples.

### <Comparative Example 2-5>

Channel structures were formed by development in a barrier layer formed on a glass substrate so that channel sections had an opening width of 3000 µm and so that the barrier layer **had an opening** area ratio of 70%. Except for this, a microfluidic chip according to a comparative example 2-5 of the 1.2-th Examples was obtained as in Example 2-1 of the 1.2-th Examples.

### [Assessment Methods]

The presence or absence of damage and warpage and the presence or absence of liquid leakage at the time of bonding the cover layers were assessed for the microfluidic chips according to Example 2-1 to Example 2-9, and comparative example 2-1 to comparative example 2-5 of the 1.2-th Examples in the following methods after the bonding.

### (Presence or Absence of Damage and Warpage)

The presence or absence of damage and warpage was visually confirmed for each of the microfluidic chips according to Example 2-1 to Example 2-9 and comparative example 2-1 to comparative example 2-5 in the 1.2-th Examples. "∘ (acceptable)" indicates that none of damage and warpage was visually confirmed and "× (unacceptable)" indicates that at least one of damage or warpage was visually confirmed.

### (Presence or Absence of Liquid Leakage)

A 10-µL colored reaction solution was collected by a pipette and introduced from an inlet channel of the cover layer for each of the microfluidic chips according to Example 2-1 to Example 2-9 and the comparative example 2-1 to the comparative example 2-5 in the 1.2-th Examples. The transfer of the solution was observed with a microscope.

The liquid leakage state of each microfluidic chip was assessed in the two levels of "∘" and "×" by the following criterion on the basis of a result of the observation.

### <Assessment Criterion>

∘: no liquid leakage was observed from the channel at a portion at which the barrier layer and the cover layer are bonded
×: liquid leakage was observed from the channel at a portion at which the barrier layer and the cover layer are bonded

It is to be noted that "-" describes that it is not possible for liquid to flow because of damage to a microfluidic chip.

Assessment results of the respective Examples and the respective comparative examples in 1.2-th Examples will be shown in Table 2 along with the opening area ratios of the barrier layers in the microfluidic chips, the opening widths of the channels, the channel lengths, and the pressure bonding temperatures.

**[Table 2]**

| | Barrier layer | | | Pressure bonding temperature | Assessment | |
|---|---|---|---|---|---|---|
| | opening area ratio | opening width of channel | channel length | | damage state after bonding | liquid leakage |
| Example 2-1 | 20% | 10 µm | 50 mm | 50°C | ○ | ○ |
| Example 2-2 | 20% | 500 µm | 50 mm | 50°C | ○ | ○ |
| Example 2-3 | 20% | 2000 µm | 50 mm | 50°C | ○ | ○ |
| Example 2-4 | 30% | 10 µm | 50 mm | 50°C | ○ | ○ |
| Example 2-5 | 30% | 500 µm | 50 mm | 50°C | ○ | ○ |
| Example 2-6 | 30% | 2000 µm | 50 mm | 50°C | ○ | ○ |
| Example 2-7 | 60% | 10 µm | 50 mm | 50°C | ○ | ○ |
| Example 2-8 | 60% | 500 µm | 50 mm | 50°C | ○ | ○ |
| Example 2-9 | 60% | 2000 µm | 50 mm | 50°C | ○ | ○ |
| comparative example 2-1 | 70% | 10 µm | 50 mm | 50°C | × | × |
| comparative example 2-2 | 70% | 500 µm | 50 mm | 50°C | × | - |
| comparative example 2-3 | 70% | 2000 µm | 50 mm | 50°C | × | - |
| comparative example 2-4 | 30% | 3000 µm | 50 mm | 50°C | × | - |
| comparative example 2-5 | 70% | 3000 µm | 50 mm | 50°C | × | - |

It was confirmed that all of the microfluidic chips according to Example 2-1 to Example 2-9 in the 1.2-th Examples suffered neither damage nor warpage after bonding and no liquid leakage occurred after liquid flowed. In contrast, the microfluidic chips according to the comparative example 2-1 to the comparative example 2-5 in the 1.2-th Examples each suffered damage or warpage after bonding. Further, liquid leakage was confirmed after liquid flowed.

As the results described above, it was confirmed that the barrier layer formed a channel section and a covering member support section, and the opening area ratio of the barrier layer and the dimensions (e.g., the opening width of the channel and the gap between the covering member support sections) of an opening section formed in the barrier layer were controlled in each of the microfluidic chips according to the 1.2-th Examples to satisfy the specific conditions, thereby increasing the bonding stability of bonding a plurality of members (the wall section and the covering member here), preventing members (the substrate, the wall section, and the covering member) from receiving warpage in addition to damage due to pressure and heating at the time of bonding the barrier layer and the cover layer, and without liquid leakage occurring when liquid flowed.

Specifically, it was confirmed that when a channel section was formed in the barrier layer as an opening section having an opening width of 2000 µm or less and the barrier layer had an opening area ratio of 20% or more and 60% or less as in each of the microfluidic chips according to Example 2-1 to Example 2-9 in the 1.2-th Examples, that this prevented members from suffering damage or warpage due to pressure and heating at the time of bonding the barrier layer and the cover layer and cause no liquid leakage when liquid flowed.

It is to be noted that the microfluidic chip and the method for manufacturing the microfluidic chip according to the first embodiment are not limited to the embodiment and Examples described above. It is possible to make a variety of modifications within the scope that does not impair the features of the invention.

**In** addition, for example, it is possible for the first embodiment described above to adopt configurations as follows.
(1) A microfluidic chip including:
   a substrate;
   a barrier section including a resin material, the barrier section being provided on the substrate, the barrier section forming a channel; and
   a cover section that is provided on an opposite surface of the barrier section to the substrate and covers the channel, characterized in that
   the channel is formed in the barrier section as an opening section having an opening width of 2000 µm or less, and
   the barrier section has an opening area ratio of 60% or less.
(2) The microfluidic chip according to (1), characterized in that
   the barrier section and the cover section are joined together by thermocompression bonding, and
   the barrier section has an opening area ratio of 20% or more and 60% or less.
(3) The microfluidic chip according to (1) or (2), characterized in that a plurality of the channels is formed in the barrier section.
(4) The microfluidic chip according to any one of (1) to (3), characterized in that the barrier section includes a channel region in which at least one of the channels is formed and a non-channel region in which the channels are not formed.
(5) The microfluidic chip according to any one of (1) to (4), characterized in that an adhesive layer is provided between the barrier section and the substrate.
(6) The microfluidic chip according to any one of (1) to (5), characterized in that the resin material that forms the barrier section is a photosensitive resin having photosensitivity to light having a wavelength of 190 nm or more and 400 nm or less included in an ultraviolet region.
(7) A method for manufacturing a microfluidic chip, including:
   a step of coating a substrate with resin;
   a step of exposing the resin used for the coating;
   a step of developing and cleaning the exposed resin to form a barrier section that defines a channel on the substrate;
   a step of conducting post-baking treatment on the barrier section; and
   a step of bonding a cover section to an opposite surface of the barrier section to the substrate, characterized in that
   redundant resin on the substrate is removed by the developing to form an opening section having an opening width of 2000 µm or less in the barrier section and cause the barrier section to have an opening area ratio of 60% or less, the opening section serving as the channel.
(8) The method for manufacturing the microfluidic chip according to (7), characterized in that pressure is applied to narrow a gap between the barrier section and the cover section and bond the barrier section and the cover section with no gap in between in the step of bonding the cover section to the opposite surface of the barrier section to the substrate.
(9) The method for manufacturing the microfluidic chip according to (7) or (8), characterized in that
   the barrier section has an opening area ratio of 20% or more and 60% or less due to the developing, and
   the barrier section and the cover section are bonded by thermocompression bonding in the step of bonding the cover section to the opposite surface of the barrier section to the substrate.
(10) The method for manufacturing the microfluidic chip according to any one of (7) to (9), characterized in that a photosensitive resin is sensitized to light having a wavelength of 190 nm or more and 400 nm or less in an ultraviolet region in the step of exposing the resin.

### 2. Second Embodiment

A second embodiment of the present disclosure will be described. The second embodiment of the present disclosure relates to a microfluidic chip and a method for manufacturing the microfluidic chip.

As described above, µ-TAS uses micrometer-sized channels (microfluidic channels or microchannels) formed on substrates in many cases. Such substrates are each referred to as a chip, a microchip, a microfluidic chip, or the like.

Conventionally, such microfluidic chips have been fabricated by using technology such as injection molding, molding, cutting, and etching. In addition, glass substrates have been chiefly used as substrates of microfluidic chips because glass substrates are easy to manufacture and also allow for optical detection. Meanwhile, microfluidic chips including light and inexpensive resin materials less prone to damage than glass substrates also have been under development. Methods for manufacturing microfluidic chips including resin materials include a method for fabricating a microfluidic chip by forming a resin pattern for a channel chiefly by photolithography and bonding a covering member to the resin pattern. This method makes it possible to form even a fine channel pattern that is difficult to form by the conventional technology in some cases.

Such a microfluidic chip has been conventionally fabricated by bonding a plurality of members to each other. For example, a microfluidic chip has been proposed that is formed in a method in which a plurality of members is bonded to each other with an adhesive in between. In addition, for example, a method has also been proposed in which process gas is converted to plasma under atmospheric pressure or pressure near atmospheric pressure to modify a substrate surface and members are bonded to each other with no adhesive.

As described above, when a microfluidic chip is fabricated, a plurality of members is bonded to each other. It is therefore necessary to apply pressure corresponding to the bonding method to the members. For example, when a wall section (barrier section) in which a channel is formed and a covering member are bonded, these members are pressed in accordance with the bonding method. For example, a thermocompression bonding method is used as the bonding method.

A channel portion (an opening region of a wall section) has occupied a larger surface area in a microfluidic chip in recent years as a channel pattern structure has been more complicated. When the wall section and a covering member have smaller contact area as the wall section has larger opening area or greater opening width, resistance to pressure at the time of bonding the wall section and the covering member reduces and pressure at the time of bonding in a thermocompression bonding method may cause members (such as a substrate, the wall section, or the covering member) to suffer damage.

To increase the resistance to pressure, it is conceivable to excessively decrease the opening area or the opening width of the wall section and increase the contact area between the wall section and the covering member. However, in a case where the contact area is excessively increased, deformation caused by the expansion and the subsequent contraction of members due to heating at the time of bonding in a thermocompression bonding method may cause the members to suffer warpage and bonding failure or may cause the members to suffer damage. **In** addition, if the members suffer damage or warpage when the wall section and the covering member are bonded, liquid leakage occurs in some cases when liquid flows through the microfluidic chip.

Thus, in a case where the members are bonded to each other by thermocompression bonding, it is necessary to increase the bonding stability by preventing the resistance to pressure from reducing and preventing the members (the substrate, the wall section, and the covering member) from being deformed because of heating when the wall section and the covering member are bonded, prevent damage and warpage due to pressure and heating, and prevent liquid leakage when liquid flows.

Accordingly, an object of the second embodiment according to the present disclosure is to provide a microfluidic chip in which members are prevented from suffering damage and warpage due to pressure and heating at the time of bonding a wall section and a covering member by thermocompression bonding and no liquid leakage occurs when liquid flows, and a method for manufacturing the microfluidic chip.

To achieve the object described above, a microfluidic chip according to an aspect of the second embodiment includes: a substrate; a channel; a covering member; and a barrier section. The channel is provided on the substrate. The covering member serves as a cover of the channel. The barrier section includes a resin material. The barrier section is disposed between the substrate and the covering member. The barrier section forms a channel and a covering member support section on the substrate. The covering member support section supports the covering member. The microfluidic chip is characterized in that the channel is formed in the barrier section as an opening section having an opening width of 2000 µm or less, the barrier section has an opening area ratio of 20% or more and 60% or less, the barrier section and the covering member are bonded by thermocompression bonding, and the covering member is bonded to an opposite surface of the barrier section to the substrate.

In addition, a method for manufacturing a microfluidic chip according to an aspect of the second embodiment includes: a step of coating a substrate with resin; a step of exposing the resin used for the coating; a step of developing and cleaning the exposed resin to form a barrier section on the substrate; a step of conducting post-baking treatment on the barrier section; and a step of bonding a covering member to an opposite surface of the barrier section to the substrate by thermocompression bonding. The method is characterized in that redundant resin on the substrate is removed by the developing in a step of forming the channel so that the barrier section forms a channel and a covering member support section on the substrate, forms an opening section having an opening width of 2000 µm or less in the barrier section as the channel, and so that the barrier section has an opening area ratio of 20% or more and 60% or less. The covering member support section supports the covering member.

According to an aspect of the second embodiment of the present disclosure, it is possible to provide a microfluidic chip in which members are prevented from suffering damage and warpage due to pressure and heating at the time of bonding a wall section and a covering member by thermocompression bonding and no liquid leakage occurs when liquid flows.

A microfluidic chip according to the second embodiment of the present disclosure will be described. It is to be noted that the side of the microfluidic chip closer to a substrate will be described as "down" and the opposite side of the microfluidic chip to the substrate (closer to a covering member) will be described as "up" in the following description in some cases.

As a result of intensive studies, the present inventors have found that a wall section forms a channel and a covering member support section which supports a covering member, and the opening area ratio of the wall section and the dimensions (e.g., the opening width of the channel and the gap between the covering member support sections) of an opening section formed in the wall section are controlled in a microfluidic chip to satisfy the specific conditions, thereby preventing resistance to pressure at the time of bonding a plurality of members (the wall section and the covering member here) from reducing, preventing the members from being deformed because of heating, and increasing the bonding stability. The present inventors have hereby invented a microfluidic chip in which members (a substrate, a wall section, and a covering member) are prevented from suffering damage and warpage because of pressure and heating at the time of bonding the wall section and the covering member and no liquid leakage occurs when liquid flows, and a method for manufacturing the microfluidic chip. It is to be noted that details of the opening area ratio of the wall section will be described below.

The respective aspects (a 2-1-th embodiment and a 2-2-th embodiment) of the second embodiment of the present disclosure will be described below with reference to the drawings.

### (2.1) 2-1-th Embodiment

### (2.1.1) Basic Configuration of Microfluidic Chip

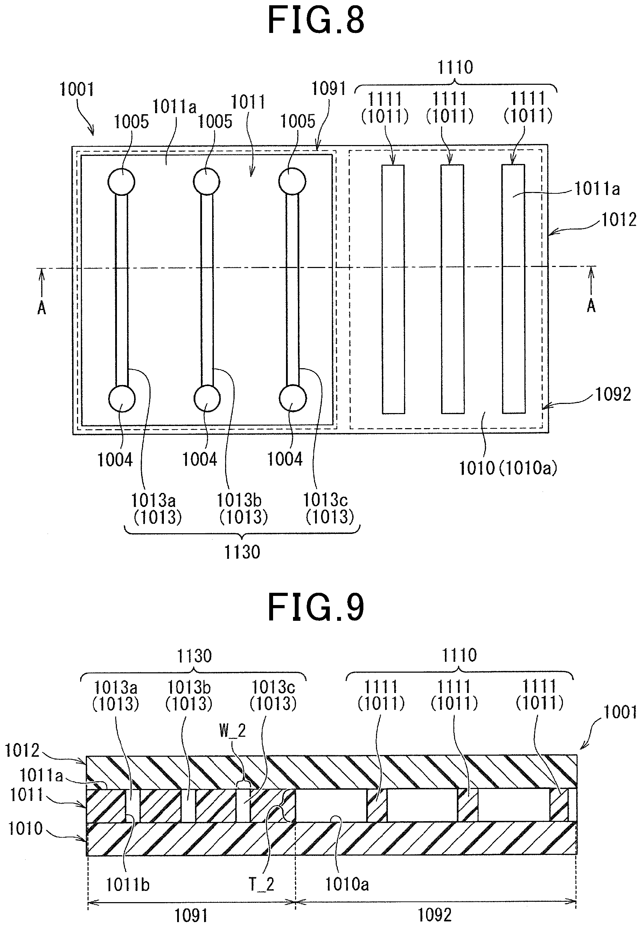

Each of Figs. 8 and 9 is an outline diagram for describing a configuration example of a microfluidic chip 1001 according to the 2-1-th embodiment (referred to as "the present embodiment" below) of the present disclosure. Specifically, Fig. 8 is an outline plan view of the microfluidic chip 1001 according to the present embodiment. In addition, Fig. 9 is an outline cross-sectional view of a cross section of the microfluidic chip 1001 taken along a line A-A illustrated in Fig. 8.

As illustrated in Fig. 8, the microfluidic chip 1001 includes input sections 1004 each for introducing a fluid (e.g., liquid), channel sections 1013 each formed on a substrate 1010, and output sections 1005 each for discharging a fluid from the channel section 1013. The fluid introduced from the input section 1004 flows in the channel section 1013. Each of the output sections 1005 is not limited to a component (discharge section) that discharges a fluid and may be a component (drug fixation section) that brings the fluid and a drug solution into contact. A component that functions as at least one of the discharge section or the drug solution fixation section of a fluid will be generically referred to as the "output section" below.

A barrier layer (barrier section) 1011 that defines each of the channel sections 1013 is formed on the substrate 1010. The channel section 1013 is an opening section that opens on a front surface 1011a. In the microfluidic chip 1001, the channel section 1013 is covered with a cover layer 1012 that is a covering member. The input sections 1004 and the output sections 1005 are through holes provided in the cover layer 1012. In addition, the microfluidic chip 1001 includes a covering member support section 1111 that is part of the barrier layer 1011 formed on the substrate 1010 and supports the covering member. Details of the respective components will be described below.

Fig. 8 illustrates the substrate 1010, the barrier layer 1011, the channel sections 1013, and the covering member support sections 111 visually recognized through the cover layer 1012 having transparency.

It is sufficient if the microfluidic chip 1001 is provided with the at least one or more input sections 1004 and the at least one or more output sections 1005. The microfluidic chip 1001 may be provided with the plurality of input sections 1004 and the plurality of output sections 1005. In addition, it is sufficient if the one or more channel sections 1013 are provided in the microfluidic chip 1001. The plurality of channel sections 1013 may be provided. The channel sections 1013 may be designed to allow fluids introduced from the input sections 1004 to merge or be separated. Specifically, the plurality of input sections 1004 may be provided for the one channel section 1013 or the one input section 1004 may be provided for the plurality of channel sections 1013. In addition, similarly, the plurality of output sections 1005 may be provided for the one channel section 1013 or the one output section 1005 may be provided for the plurality of channel sections 1013.

The microfluidic chip 1001 illustrated in each of Figs. 8 and 9 includes the channel group 130 including the three channel sections 1013 (channel sections 1013a, 1013b, and 1013c) as an example.

First, details of the members (the substrate 1010, the barrier layer 1011, and the cover layer 1012) included in the channel sections 1013 (channel sections 1013a to 1013c) in the microfluidic chip 1001 will be described here.

As illustrated in Fig. 9, the barrier layer (an example of the barrier section) 11 that is a wall section sandwiched between two base members (the first base member and the second base member) defines the channel sections 1013 that are channels in each of which a fluid flows in the microfluidic chip 1001. In this example, the cover layer 1012 that is provided on the upper surface side of the barrier layer 1011 and covers the upper section of the channel section 1013 corresponds to the first base member. The substrate 1010 that is provided on the bottom surface side of the barrier layer 1011 and forms the bottom section of the channel section 1013 corresponds to the second base member. That is, the microfluidic chip 1001 includes the channel sections 1013 provided on the substrate 1010, the cover layer 1012 that serves as a cover of the channel sections 1013, the substrate 1010, and the barrier layer 1011 that is disposed between the cover layer 1012 and the substrate 1010 and forms the channel section 1013 and the covering member support section 111 on the substrate 1010. More specifically, the microfluidic chip 1001 includes the substrate 1010, the barrier layer 1011 that is provided on the substrate 1010 and forms a channel, and the cover layer 1012 that is bonded to the opposite surface of the barrier layer 1011 to the substrate 1010 and covers the channel sections 1013. Although described in detail below, the barrier layer 1011 and the cover layer 1012 are bonded by thermocompression bonding in this example.

Each of the channel sections 1013 in which a fluid introduced from the input section 1004 flows is a region surrounded by the substrate 1010, the barrier layer 1011, and the cover layer 1012. The channel section 1013 is defined by the barrier layer 1011 provided on the substrate 1010 to be opposed to the substrate 1010. The opposite side of the channel section 1013 to the substrate 1010 is covered with the cover layer 1012 that serves as a covering member. As described above, a fluid is introduced to the channel section 1013 from the input section 1004 provided in the cover layer 1012 and the fluid flowing in the channel section 1013 is discharged from the output section 1005.

### (2.1.1.1) Substrate

The substrate 1010 is a member that serves as the base of the microfluidic chip 1001. The barrier layer 1011 provided on the substrate 1010 is included in the channel sections 1013. That is, the substrate 1010 and the barrier layer 1011 can be regarded as the body section of the microfluidic chip 1001.

In addition, as illustrated in Fig. 9, the substrate 1010 includes a channel region (an example of a substrate channel region) 1091 in which the channel sections 1013 are provided and a non-channel region (an example of a substrate non-channel region) 1092 in which the channel sections 1013 are not provided on the opposed surface (front surface 1010a) to the cover layer 1012. That is, the channel sections 1013 are formed on the channel region 1091 on the substrate 1010 by the barrier layer 1011 and the covering member support sections 1111 that support the cover layer 1012 are formed on the non-channel region 1092. In addition, in the non-channel region 1092, the front surface 1010a of the substrate 1010 is exposed at a portion at which the covering member support sections 1111 are not formed. That is, the barrier layer 1011 is not provided at a portion on the non-channel region 1092 other than the covering member support sections 1111.

It is possible to form the substrate 1010 by using any of a light-transmissive material or a non-light-transmissive material. For example, in a case where the internal state (the state of a fluid) of each of the channel sections 1013 is detected and observed by using light, it is possible to use a material that is excellent in transparency to the light. This allows the inner state of the channel section 1013 to be observed, for example, from the substrate 1010 side. It is possible to use resin, glass, or the like as the light-transmissive material. The resin used for the light-transmissive material that is used to form the substrate 1010 includes an acrylic resin, a methacrylic resin, polypropylene, a polycarbonate resin, a cycloolefin resin, a polystyrene resin, a polyester resin, a urethane resin, a silicone resin, a fluororesin , and the like from the perspective of the suitability for the formation of the body section of the microfluidic chip 1001.

In addition, for example, in a case where it is unnecessary to detect or observe the internal (the state of a fluid) state of each of the channel sections 1013 by using light, a non-light-transmissive material may be used. The non-light-transmissive material includes a silicon wafer, a copper plate, and the like. The thickness of the substrate 1010 is not limited in particular, but a certain level of rigidity is necessary in a channel formation step and it is thus preferable that the thickness of the substrate 1010 be within a range of 10 µm (0.01 mm) or more and 10 mm or less.

### (2.1.1.2) Barrier Layer

The barrier layer 1011 is a component that is provided on the substrate 1010 and forms the channel sections 1013. Specifically, the channel section 1013 is defined by opposed side surfaces 1011b of the barrier layers 1011. As illustrated in Fig. 9, in the present embodiment, the barrier layer 1011 forms a channel group 1130 including the plurality of channel sections 1013 (channel sections 1013a, 1013b, and 1013c) on the substrate 1010. The microfluidic chip 1001 includes the plurality of channel sections 1013, thereby making it possible, for example, to carry out a plurality of tests at the same time or carry out tests in which different types of fluids are used, making it possible to use the microfluidic chip more widely. The plurality of respective channel sections 1013 may be independent or some of the plurality of channel sections 1013 may cross each other.

It is possible to form the barrier layer 1011 by using a resin material. It is possible to use, for example, a photosensitive resin as the resin material of the barrier layer 1011.

It is desirable that the photosensitive resin that forms the barrier layer 1011 have photosensitivity to light having a wavelength of 190 nm or more and 400 nm or less, which is in the ultraviolet region. It is possible to use a photoresist such as a liquid resist or a dry film resist as the photosensitive resin. These photosensitive resins may be either positive photosensitive resins in which the photosensitive regions are dissolved or negative photosensitive resins in which the photosensitive regions are insoluble. A photosensitive resin composition suitable for the formation of the barrier layer 1011 in the microfluidic chip 1001 includes a radical negative photosensitive resin including an alkali-soluble polymer, an additional polymerizable monomer, and a photopolymerization initiator. It is possible to use, for example, an acryl-based resin, an acrylic urethane-based resin (urethane acrylate-based resin), an epoxy-based resin, a polyamide-based resin, a polyimide-based resin, a polyurethane-based resin, a polyester-based resin, a polyether-based resin, a polyolefin-based resin, a polycarbonate-based resin, a polystyrene-based resin, a norbornene-based resin, a phenolic novolac-based resin, and another resin having photosensitivity alone, or use a mixture of some of the resins or use copolymerized resins as the photosensitive resin material.

It is to be noted that the resin material of the barrier layer 1011 is not limited to the photosensitive resin in the present embodiment. For example, silicone rubber (PDMS: polydimethylsiloxane) or synthetic resin may be used. It is possible to use, for example, a polymethyl methacrylate resin (PMMA), polycarbonate (PC), a polystyrene resin (PS), polypropylene (PP), a cycloolefin polymer (COP), a cycloolefin copolymer (COC), or the like as the synthetic resin. It is desirable to select the resin material of the barrier layer 1011 as appropriate depending on the application.

### (2.1.1.2.1) Covering Member Support Section

Next, a covering member support section formed on the substrate 1010 by the barrier layer 1011 will be described.

The barrier layer 1011 forms the channel section 1013 on the channel region 1091 of the substrate 1010 and forms a covering member support section (e.g., covering member support section 1111) on the non-channel region 1092. The covering member support section is formed as a resin structure including part of the barrier layer 1011. That is, in the present embodiment, the microfluidic chip 1001 is also provided with the part of the barrier layer 1011 (covering member support section 1111) on the non-channel region 1092 in addition to the channel region 1091. This makes it possible to reliably secure the contact area between the barrier layer 1011 and the cover layer 1012, increase resistance to pressure by dispersing pressing force (preventing pressing force from concentrating) at the time of bonding the barrier layer 1011 and the cover layer 1012, and prevent release defects after bonding. In addition, the barrier layer 1011 forms the covering member support section 1111, thereby making it possible to increase the rigidity of the microfluidic chip 1001 itself and also prevent members from suffering damage or warpage due to pressure applied at the time of storage or use.

The shape of a covering member support section and the number of covering member support sections are not limited in the microfluidic chip 1001. It is, however, preferable to form one or more resin structures each including part of the barrier layer 1011 on the non-channel region 1092 as covering member support sections from the perspective of the increased contact area between the barrier layer 1011 and the cover layer 1012. That is, it is preferable that one or more resin structures be formed on the non-channel region 1092 in the microfluidic chip 1001 as covering member support sections. This makes it possible to secure the contact area between the barrier layer 1011 and the cover layer 1012 more reliably and further increase resistance to pressure at the time of bonding the barrier layer 1011 and the cover layer 1012.

As illustrated in each of Figs. 8 and 9, the three covering member support sections 1111 are formed on the substrate 1010 (specifically, on the non-channel region 1092) in this example.

In addition, a thickness T_2 of the barrier layer 1011 does not vary on the substrate 1010 in the microfluidic chip 1001. That is, the barrier layer 1011 does not vary in thickness between the channel region 1091 and the non-channel region 1092. Therefore, the barrier layer 1011 that forms the channel sections 1013 in the channel region 1091 and the barrier layer 1011 that forms the covering member support sections 1111 have the equal thickness T_2. The barrier layer 1011 is thus stably bonded to the cover layer 1012 on the opposite surface (front surface 1011a) to the substrate 1010.

In addition, the barrier layer 1011 is bonded to the cover layer 1012 on the opposite surface (front surface 1011a) to the substrate 1010 on any of the channel region 1091 and the non-channel region 1092. That is, the covering member support sections 1111 on the non-channel region 1092 are also bonded to the cover layer 1012 on the opposite surfaces (front surfaces 1011a) to the substrate 1010. In the present embodiment, the covering member support sections 1111 are each in surface contact with the cover layer 1012 on the opposite surface (front surface 1011a) of the covering member support section 1111 to the substrate 1010, that is, the surface closer to the cover layer 1012. This more stably bonds the barrier layer 1011 including the covering member support sections 1111 to the cover layer 1012 on the opposite surfaces (front surfaces 1011a) to the substrate 1010.

In addition, in the present embodiment, the front surface 1011a of the barrier layer 1011 including the covering member support sections 1111 is flat. This bonds the barrier layer 1011 to the cover layer 1012 more stably. It is to be noted that the front surface 1011a of the barrier layer 1011 may be provided with minute irregularities as long as the stability of bonding to the cover layer 1012 is not affected.

The shape of each of the covering member support sections 1111 is not limited in particular in the present embodiment and it is possible to adopt various shapes. As illustrated in Fig. 8, in this example, each of the covering member support sections 1111 is a resin structure having a rectangular shape in a plan view. Here, the plan view is a view from the direction orthogonal to the front surface 1011a of the barrier layer 1011. That is, the shape of the covering member support section 1111 in a plan view is the shape of the front surface 1011a.

More specifically, in this example, the plurality of (three) covering member support sections 1111 is disposed on the non-channel region 1092 to be parallel with the long sides of the rectangles, which are the planar shapes of the resin structures. That is, the plurality of covering member support sections 1111 forms a striped (linear) pattern 1110 on the non-channel region 1092 of the substrate 1010. In addition, in this example, the plurality of covering member support sections 1111 is disposed such that the long sides of the rectangles, which are the planar shapes, and the channel sections 1013 are parallel with each other.

It is to be noted that the present disclosure is not limited to this. It is sufficient if the two or more covering member support sections 1111 are disposed on the non-channel region 1092 as the plurality of covering member support sections 1111 which forms the striped pattern 1110. In addition, the covering member support sections 1111 may be disposed such that the long sides of the rectangles, which are the planar shapes, are parallel with a virtual straight line orthogonal to the channel sections 1013 or may be disposed such that the long sides of the rectangles, which are the planar shapes, are parallel with a diagonal line of the non-channel region 1092 having a rectangular shape in a plan view. In addition, the arrangement of the covering member support sections 1111 each having a rectangular shape in a plan view is not limited to the striped pattern 1110. For example, the covering member support sections 1111 may be disposed along the four sides of the non-channel region 1092 having a rectangular shape in plan view to surround the inner periphery of the non-channel region 1092.

In a case where the plurality of covering member support sections 1111 forms the striped pattern 1110, it is preferable that the long sides of the covering member support sections 1111 on the front surface 1011a each have a length equal to or more than the length (a channel length L_2 described below) of each of the channel sections 1013. This makes it possible to compensate for the contact area between the barrier layer 1011 and the cover layer 1012 decreased by the channel sections 1013 each of which is an opening section and increase the bonding stability of bonding to the cover layer 1012.

It is to be noted that the planar shape of each of the covering member support sections 1111 included in the striped pattern 1110 is not limited to a rectangle and may be a rounded-corner shape or an elliptical shape. In addition, each side of the planar shape of the covering member support section 1111 is not limited to a straight line and may include a wavy or serrated portion.

It is to be noted that Figs. 8 and 9 each exemplify a configuration in which a plurality of covering member support sections (the covering member support sections 1111 in this example) is formed, but the present disclosure is not limited to this. First, the pattern of covering member support sections is not limited to the striped pattern 1110 and it is possible to form the pattern of covering member support sections as various patterns. In addition, as described above, one covering member support section may be formed on the substrate 1010 (specifically, on the non-channel region 1092) in a microfluidic chip. In a case where one covering member support section is formed, it is preferable that the area of the front surface 1011a of the covering member support section be larger than the area of the front surface 1011a of one covering member support section in a case where a plurality of covering member support sections is formed. That is, in a case where one covering member support section is formed, it is preferable that the area of the front surface 1011a of the covering member support section be larger than the area of the front surface 1011a of one covering member support section of a plurality of covering member support sections (e.g., the three covering member support sections 1111).

In addition, in a case where one covering member support section is formed, it is preferable that the area of the front surface 1011a of the one covering member support section be equal to or more than the total area (the sum of areas) of the front surfaces 1011a of a plurality of covering member support sections. For example, in a case where one covering member support section is formed, it is sufficient if the area of the front surface 1011a of the one covering member support section is equal to or more than the sum (the total area of the three covering member support sections 1111) of the areas of the front surfaces 1011a of the three covering member support sections 1111. This makes it possible to secure the contact area between the barrier layer 1011 and the cover layer 1012 and increase the bonding stability even in a case where one covering member support section is formed as in a case where a plurality of covering member support sections is formed (e.g., in a case where the striped pattern 1110 is formed).

It is to be noted that, in a case where one covering member support section is formed, the shape (the shape of the front surface 1011a) of the covering member support section in a plan view is not limited in particular and may be a polygonal shape, a circular shape, or a letter or character shape.

### (2.1.1.3) Cover Layer

In the microfluidic chip 1001 according to the present embodiment, the cover layer 1012 is provided on the opposite surface (front surface 1011a) of the barrier layer 1011 to the substrate 1010. As illustrated in Fig. 8, the cover layer 1012 is a covering member that covers the channel sections 1013. As described above, the cover layer 1012 is bonded to the opposite surface of the barrier layer 1011 to the substrate 1010 and is opposed to the substrate 1010 across the barrier layer 1011. More specifically, as illustrated in Fig. 9, the cover layer 1012 is supported by the barrier layer 1011 including the covering member support section 1111 in a cross-sectional view. The cover layer 1012 is opposed to the substrate 1010 in an opening section on the front surface 1011a of the barrier layer 1011 in which the channel section 1013 is formed. The surface of the cover layer 1012 opposed to the substrate 1010 defines the upper section of the channel section 1013. The cover layer 1012 is supported by the barrier layer 1011 on the channel region 1091 of the substrate 1010 and the covering member support section 1111 on the non-channel region 1092, thereby securing the sufficient contact area (bonding area) between the barrier layer 1011 and the cover layer 1012 and increasing the bonding stability of bonding to the barrier layer 1011.

It is possible to form the cover layer 1012 by using any of a light-transmissive material or a non-light-transmissive material. For example, in a case where the internal state of each of the channels is detected and observed using light, it is possible to use a material that is excellent in transparency to the light. The light-transmissive material is not limited in particular and it is possible to use resin, glass, or the like. The resin that forms the cover layer 1012 includes an acrylic resin, a methacrylic resin, polypropylene, a polycarbonate resin, a cycloolefin resin, a polystyrene resin, a polyester resin, a urethane resin, a silicone resin, a fluororesin, and the like from the perspective of the suitability for the formation of the body section of the microfluidic chip 1001. The thickness of the cover layer 1012 is not limited in particular, but it is preferable that the thickness of the cover layer 1012 be within a range of 10 µm or more and 10 mm or less in view of the provision of respective through holes corresponding the input sections 1004 and the output sections 1005 in the cover layer 1012. In addition, it is desirable that the cover layer 1012 have, in advance, respective holes corresponding to the input sections 1004 from each of which a fluid (liquid) is introduced and the output sections 1005 from each of which the fluid is discharged in the cover layer 1012 before the cover layer 1012 is bonded to the barrier layer 1011.

### (2.1.1.4) Configuration of Opening Region of Barrier Layer

A configuration regarding an opening region of the barrier layer 1011 on the substrate 1010 in the microfluidic chip 1001 according to the present embodiment will be described here in detail by using Figs. 8 to 10.

The dimensions of the channel section 1013 in the microfluidic chip 1001 and the opening area ratio of the barrier layer 1011 that forms the channel sections 1013 will be described below.

As described above, the microfluidic chip has a complicated channel pattern structure and more opening regions tend to occupy the wall section. These increased opening regions reduce the bonding stability of bonding the wall section and the covering member in some cases. The reduced bonding stability may cause a defect such as damage or warpage to respective members (the substrate, the wall section, and the covering member in this example) included in the microfluidic chip 1001, for example, when the covering member and the wall section are bonded, for example, at the time of fabricating the microfluidic chip 1001.

For example, when the bonding stability reduces because of the increased opening regions in the wall section, the resistance of the wall section to pressure reduces, the wall section suffers damage at the time of bonding the wall section and the covering member, and even the covering member and the substrate further suffer damage in some cases. Meanwhile, in a case where opening regions are excessively decreased in the wall section and the contact area between the wall section and the covering member is excessively increased, deformation caused by the expansion and the subsequent contraction of members due to heating at the time of bonding in a thermocompression bonding method may cause the members to suffer damage. In particular, in the case of a microfluidic chip in which the wall section and the covering member include different types of materials, the respective materials have different thermal expansion coefficients. The members thus easily suffer damage and warpage because of the difference between expansion and subsequent contraction due to heating at the time of thermocompression bonding.

In addition, if members such as the substrate, the wall section, and the covering member suffer damage, liquid leakage occurs in some cases when liquid flows through the microfluidic chip. Thus, in a case where members are bonded to each other by thermocompression bonding in the microfluidic chip, it is necessary to prevent resistance for pressure from reducing and prevent members (the substrate, the wall section, and the covering member) from being deformed because of heating when the wall section and the covering member are bonded, and increase the bonding stability.

As described below, the microfluidic chip 1001 according to the present embodiment has a configuration in which the dimensions of the channel section 1013 that is an opening section in the barrier layer 1011 and the opening area ratio of the barrier layer 1011 satisfy the specific conditions. Further, as described above, the microfluidic chip 1001 includes the covering member support sections 1111 formed by the barrier layer 1011. This makes it possible to provide a microfluidic chip in which the resistance of a wall section to pressure is increased, members (a substrate, the wall section, and a covering member) are prevented from suffering damage or warpage, and no liquid leakage occurs when liquid flows.

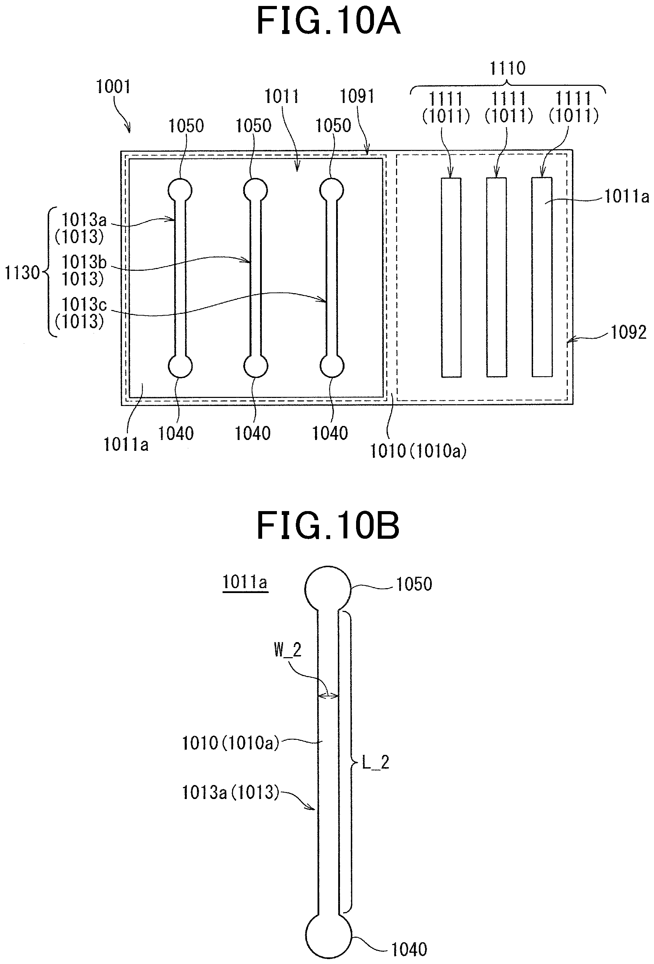

Fig. 10A is an outline plan view of the channel sections 1013 formed in the barrier layer 1011 in the microfluidic chip 1001 illustrated in Fig. 8. Fig. 10B is an enlarged view of the channel section 1013 (channel section 1013a) illustrated in Fig. 10A. To facilitate understandings, each of Figs. 10A and 10B does not illustrate the cover layer 1012.

In the microfluidic chip 1001, the channel sections 1013 are each formed in the barrier layer 1011 (specifically, the front surface 1011a) on the channel region 1091 as an opening section. As illustrated in Fig. 10A, the substrate 1010 (front surface 1010a) included in the bottom sections of the channel sections 1013 is exposed in the channel sections 1013 each of which is an opening section formed on the front surface 1011a of the barrier layer 1011. It is to be noted that the configuration according to the present disclosure is not limited to this. A configuration may be adopted in which the substrate 1010 is not exposed on the bottom sections of the channel sections 1013 (e.g., a configuration in which the bottom sections of the channel sections 1013 are covered with the barrier layer 1011 or another member).

In addition, the channel section 1013 is formed between an input section 1040 and an output section 1050. The input section 1040 is an opening section formed in the barrier layer 1011 and is a component for receiving a fluid introduced through the input section 1004 of the cover layer 1012 and introducing the fluid to the channel section 1013. In addition, the output section 1050 is an opening section formed in the barrier layer 1011 and is a component for receiving a fluid passing through the channel section 1013 and discharging the fluid to the output section 1005 of the cover layer 1012. Each of the output sections 1050 is not limited to a component (discharge section) for discharging a fluid and may be a component (drug fixation section) for bringing the fluid and a drug solution into contact. For example, a drug solution may be introduced to the output section 1050 in advance, thereby making it possible to bring a fluid transferred in the channel section 1013 toward the output section 1050 and the drug solution into contact. A component that functions as the discharge section or the drug solution fixation section of a fluid will be generically referred to as the "output section" below.

In the microfluidic chip 1001, the input section 1040 of the barrier layer 1011 is provided at the position opposed to the input section 1004 of the cover layer 1012 and the output section 1050 of the barrier layer 1011 is provided at the position opposed to the output section 1005 of the cover layer 1012.

In the present embodiment, the channel group including the plurality of channel sections 1013 may be regarded as a component including the input sections 1040 and the output sections 1050, and the channel sections 1013. This allows the channel group to be regarded as a component including even regions that each introduce/discharge a fluid.

The cover layer 1012 is bonded to the barrier layer 1011 in which the channel sections 1013 are formed, thereby surrounding each of the channel sections 1013 with the substrate 1010, the barrier layer 1011, and the cover layer 1012 and configuring the channel section 1013 to allow a fluid to be transferred with no liquid leakage.

The dimensions of each of the channel sections 1013 formed in the barrier layer 1011 will be described. As illustrated in each of Fig. 9 and 10B, a width W_2 of the channel section 1013 is the width between the opposed barrier layers 1011 (specifically, between the side surfaces 1011b) and indicates the width (opening width) between the opening ends of an opening section formed in the barrier layer 1011.

The channel sections 1013 in the microfluidic chip 1001 according to the present embodiment are each formed in the barrier layer 1011 as an opening section having an opening width of 2000 µm (2 mm) or less. In the present embodiment, setting the width W_2 of the channel section 1013 to 2000 µm or less makes it possible to prevent pressure applied to the region near the channel section 1013 in the barrier layer 1011 from increasing in comparison with other regions in the barrier layer 1011 when the cover layer 1012 that is a covering member is bonded to the barrier layer 1011. That is, it is possible to increase the bonding stability of bonding the barrier layer 1011 and the cover layer 1012.

It is to be noted that the channel sections 1013 may be each configured to increase or decrease in opening width (width W_2) between the input section 1040 and the output section 1050 in the microfluidic chip 1001. For example, the channel sections 1013 may each have a shape in which the width W_2 increases toward the intermediate region between the input section 1040 and the output section 1050. It is thus sufficient if the width W_2 of the channel section 1013 in the microfluidic chip 1001 is 2000 µm or less in the region of the greatest opening width (the region of the greatest width between the side surfaces 1011b of the barrier layers 1011).

In addition, it is preferable that the width W_2 of the channel section 1013 defined by the barrier layer 1011 be 5 µm or more because the channel section 1013 has to be greater in width than a substance to be analyzed/tested as with the thickness (the height of the channel section 1013) of the barrier layer 1011 described below. That is, it is preferable that the width W_2 of the channel section 1013 be within a range of 5 µm or more and 2000 µm or less. This makes it possible to increase the bonding stability of bonding the barrier layer 1011 and the cover layer 1012 and increase the liquid transferability of a fluid including a substance to be analyzed/tested in the channel section 1013.

In addition, as illustrated in Fig. 10B, the channel length L_2 of the channel section 1013 indicates the length of the channel section 1013 formed in the barrier layer 1011 as an opening section. That is, the channel length L_2 indicates the length between the opening ends between the input section 1004 and the output section 1005. That is, the channel length L_2 is the length of a liquid transfer section in which a fluid introduced from the input section 1004 is discharged from the output section 1005. In the present embodiment, it is preferable that the channel length L_2 of the channel section 1013 be within a range of 10 mm or more and 100 mm or less. It is more preferable that the channel length L_2 of the channel section 1013 be within a range of 30 mm or more and 70 mm or more. It is still more preferable that the channel length L_2 of the channel section 1013 be within a range of 40 mm or more and 60 mm or less. Setting the channel length L_2 within a range of 10 mm or more and 100 mm or less makes it possible to secure sufficient reaction time for a reaction solution.

In addition, the height of each of the channel sections 1013 illustrated in Fig. 9, that is, the thickness T_2 of the barrier layer 1011 on the substrate 1010, is not limited in particular. The height (the thickness T_2 of the barrier layer 1011) of the channel section 1013, however, has to be greater than a substance (e.g., drugs, bacteria, cells, white blood cells, red blood cells, or the like) to be analyzed/tested included in a fluid introduced to the channel section 1013. It is therefore preferable that the height (the thickness T_2 of the barrier layer 1011) of the channel section 1013 be within a range of 5 µm or more and 500 µm or less.

Next, the opening area ratio of the barrier layer 1011 will be described. An opening area ratio (Ar_2) of the barrier layer 1011 is the ratio (Ar_2 (%) = opening area OA_2/superimposition area SA_2) of the area (opening area OA_2) of the opening regions of the barrier layer 1011 to the area (superimposition area SA_2) of the whole of the region that forms the barrier layer 1011 where the substrate 1010 and the cover layer 1012 overlap in plan view in the microfluidic chip 1001.

It is to be noted that the cover layer 1012 is provided with the input sections 1004 and the output sections 1005 as through holes as illustrated in Fig. 8. The superimposition area SA_2 does not therefore include the area of the regions in which the input sections 1004 and the output sections 1005 overlap with the substrate 1010. In addition, similarly, the opening area OA_2 does not include the input sections 1040 and the output sections 1050 formed in the barrier layer 1011 at the positions opposed to the input sections 1004 and the output sections 1005 of the cover layer 1012.

For example, in the case of the microfluidic chip 1001 illustrated in each of Figs. 8 and 9, the cover layer 1012 overlaps with the whole of the front surface 1010a of the substrate 1010, that is, the channel region 1091 and the non-channel region 1092. The superimposition area SA_2 in this example is therefore the value (superimposition area SA_2 = area of front surface 1010a of substrate 1010 - area of input sections 1004 and output sections 1005) obtained by subtracting the area of the input sections 1004 and the output sections 1005 from the area of the upper surface of the substrate 1010.

In addition, in the microfluidic chip 1001 in this example, the barrier layer 1011 forms the plurality of channel sections 1013 (channel group 1130) in the channel region 1091 of the substrate 1010. In addition, as described above, the portions other than the covering member support sections 1111 in the non-channel region 1092 on the substrate 1010 are opening regions in which the substrate 1010 is exposed. Therefore, the opening area OA_2 in this example is the sum of the opening area OA_2 (= width W_2 of channel sections 1013a to 1013c ×channel length L_2) of the channel group 1130 (channel sections 1013a to 1013c) on the channel region 1091 and the opening area (= area of non-channel region 1092 in front surface 1010a - areas of front surfaces 1011a of covering member support sections 1111) on the non-channel region 1092. The opening area ratio Ar_2 of the microfluidic chip 1001 illustrated in each of Figs. 8 and 2 is therefore calculated as follows. opening area ratio Ar_2 (%) = (sum of opening areas of channel sections 1013a to 1013c and opening area of non-channel region 1092/superimposition area SA_2)

Additionally, it is sufficient if the cover layer 1012 functions as a covering member of the microfluidic chip 1001. It is possible to design the cover layer 1012 in various shapes depending on application. It is sufficient if the cover layer 1012 is designed to cover at least part of the substrate 1010, that is, a channel region 1091, on which the channel sections 1013 are formed. For example, it is possible to design the cover layer 1012 to cover the whole of the substrate 1010 on which the barrier layer 1011 is formed in a plan view.

In the microfluidic chip 1001 according to the present embodiment, thermocompression bonding is used as a method for bonding the barrier layer 1011 and the cover layer 1012. In a case where the barrier layer 1011 and the cover layer 1012 are bonded by thermocompression bonding, it is necessary to prevent deformation of the barrier layer 1011 and the cover layer 1012 due to the thermal expansion coefficients at the time of heating from causing defects (bonding failure) in the bonding of the cover layer 1012 and the barrier layer 1011 in addition to increasing the resistance of the barrier layer 1011 to pressure.

Accordingly, in a case where the barrier layer 1011 and the cover layer 1012 are bonded (joined together) by thermocompression bonding in the microfluidic chip 1001, it is preferable that the opening area ratio Ar_2 of the barrier layer 1011 be within a range of 20% or more and 60% or less. That is, the one or more channel sections 1013 and covering member support sections 1111 are formed in the microfluidic chip 1001 so that the opening area ratio Ar_2 of the barrier layer 1011 is 20% or more and 60% or less. Setting the opening area ratio Ar_2 of the barrier layer 1011 within this range makes it possible to prevent pressure applied to the region near the channel section 1013 in the barrier layer 1011 from increasing in comparison with other regions in the barrier layer 1011 when the cover layer 1012 that is a covering member is bonded to the barrier layer 1011. Further, setting the opening area ratio Ar_2 of the barrier layer 1011 within this range makes it possible to prevent members (the substrate 1010, the barrier layer 1011, and the cover layer 1012) from suffering damage and warpage caused by the deformation of the barrier layer 1011 and the cover layer 1012 due to the thermal expansion coefficients at the time of heating and further prevent damage and the warpage from causing a defect (bonding failure) in the bonding of the cover layer 1012 and the barrier layer 1011. That is, setting the opening area ratio Ar_2 of the barrier layer 1011 within this range makes it possible to prevent the resistance of members included in the microfluidic chip 1001 to pressure from reducing at the time of bonding the wall section and the covering member and prevent the members from being deformed because of heating, and increase the bonding stability.

In addition, the microfluidic chip 1001 satisfies the condition that the width W_2 (opening width) of the channel section 1013 is 2000 µm or less as described above in addition to the condition that the opening area ratio Ar_2 is 20% or more and 60% or less, thereby making it possible to further increase the bonding stability of the barrier layer 1011 and the cover layer 1012 and prevent the substrate 1010, the barrier layer 1011, and the cover layer 1012 from suffering damage at the time of bonding.

That is, in the microfluidic chip 1001, the channel sections 1013 are each formed in the barrier layer 1011 as an opening section having an opening width of 2000 µm or less and the barrier layer 1011 has an opening area ratio of 20% or more and 60% or less. This makes it possible to provide a microfluidic chip in which the bonding stability (e.g., the resistance of the barrier layer 1011 to pressure) is increased, members (the substrate 1010, the barrier layer 1011, and the cover layer 1012) are prevented from suffering damage and warpage due to pressure (pressing) and heating at the time of bonding the members by thermocompression bonding, and no liquid leakage occurs when liquid flows.

If the condition that the barrier layer 1011 has an opening area ratio of 20% or more and 60% or less is satisfied, it is possible for the barrier layer 1011 to form the one or more channel sections 1013 on the channel region 1091 and form the plurality of covering member support sections 1111 having various shapes on the non-channel region 1092 in the microfluidic chip 1001 according to the present embodiment.

In addition, in the microfluidic chip 1001, the area of the barrier layer 1011 other than the area of the opening regions, that is, the area (resin area RA_2) of the region (front surface 1011a) of the barrier layer 1011 in which resin remains, is calculated as the difference between the superimposition area SA_2 and the opening area OA_2 (resin area RA_2 = superimposition area SA_2 - opening area OA_2). The remainder of the ratio of the opening area OA_2 to the superimposition area SA_2 is thus a resin area ratio RAr_2 (%). Accordingly, when the opening area ratio is 20%, the resin area ratio is 80%. When the opening area ratio is 60%, the resin area ratio RAr_2 is 40%. The resin area RA_2 indicates the contact area between the barrier layer 1011 and the cover layer 1012. That is, to increase the resistance of the barrier layer 1011 to pressure and increase the bonding stability of bonding the barrier layer 1011 and the cover layer 1012, it is sufficient if the resin area ratio RAr_2 that is the contact area between the barrier layer 1011 and the cover layer 1012 is within a range of 40% or more and 80% or less. That is, it is sufficient if the channel sections 1013 and the covering member support sections 1111 are formed in the microfluidic chip such that the resin area ratio RAr_2 is within a range of 40% or more 80% or less. Additionally, it is possible to easily control the adjustment of the resin area ratio RAr_2 by adjusting the shape and the size of each of the covering member support sections 1111.

### (2.1.2) Method for Manufacturing Microfluidic Chip

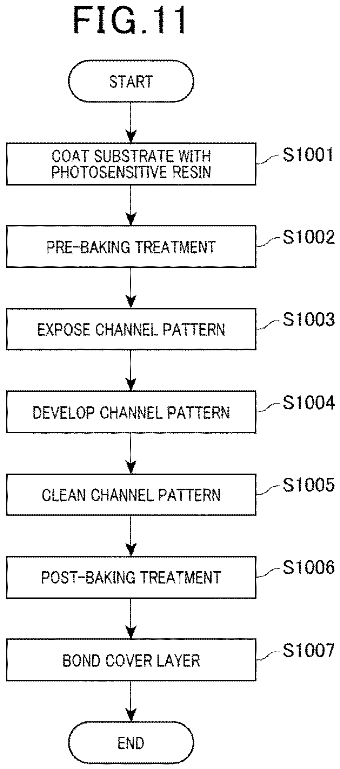

Next, a method for manufacturing the microfluidic chip 1001 according to the present embodiment will be described. Fig. 11 is a flowchart illustrating an example of the method for manufacturing the microfluidic chip 1001 according to the present embodiment.

A case where the barrier layer 1011 is formed by using a photosensitive resin will be described here as an example.

### (Step S1001)

In the method for manufacturing the microfluidic chip 1001 according to the present embodiment, a step of coating the substrate 1010 with resin is first performed. A resin layer that forms the barrier layer 1011 is thus provided on the substrate 1010. In the method for manufacturing the microfluidic chip 1001 according to the present embodiment, for example, a resin layer (photosensitive resin layer) including a photosensitive resin is formed on the substrate 1010.

Examples of a method for forming the photosensitive resin layer on the substrate 1010 include coating the substrate 1010 with a photosensitive resin. It is possible to conduct the coating, for example, by spin coating, spray coating, bar coating, or the like. Among these, spin coating is preferable from the perspective of the controllability of the film thickness. It is possible to coat the substrate 1010 with, for example, photosensitive resins having a variety of forms such as a liquid photosensitive resin, a solid photosensitive resin, a gel photosensitive resin, and a film photosensitive resin. Among these, it is preferable to form a photosensitive resin layer by using a liquid resist.

In addition, it is preferable that the substrate 1010 be coated with resin (e.g., photosensitive resin) such that the thickness of the resin layer (e.g., photosensitive resin layer), that is, the thickness T_2 of the barrier layer 1011 is within a range of 5 µm or more and 500 µm or less. It is to be noted that the thickness of the barrier layer 1011 is not limited to this.

### (Step S1002)

Once the photosensitive resin is formed on the substrate 1010, a step of conducting heating treatment (pre-baking treatment) is then performed for the purpose of removing a solvent medium (solvent) included in the resin (e.g., photosensitive resin) with which the substrate 1010 is coated. It is to be noted that the pre-baking treatment is not an essential step for the method for manufacturing the microfluidic chip 1001 according to the present embodiment. It is sufficient if the pre-baking treatment is conducted as appropriate at the optimum temperature and time depending on the characteristics of the resin. For example, in a case where the resin layer on the substrate 1010 is a photosensitive resin, the pre-baking temperature and time are adjusted to the optimum conditions as appropriate depending on the characteristics of the photosensitive resin.

### (Step S1003)

Next, a step of exposing the resin (e.g., photosensitive resin) with which the substrate 1010 is coated is performed. Specifically, the photosensitive resin with which the substrate 1010 is coated is exposed to have a channel pattern drawn thereon. In addition, in this step, a groove section (gap pattern) for forming the covering member support section 1111 is drawn by exposure on a photosensitive resin for forming the barrier layer 1011 as with the channel pattern. As illustrated in each of Figs. 8 to 3, the plurality of covering member support sections 1111 formed by the barrier layer 1011 is formed with a gap provided in between. That is, the covering member support sections 1111 are formed to have the shape (the striped pattern in this example) illustrated in each of Figs. 8 to 3 by drawing a gap pattern for defining the covering member support sections 1111 on a photosensitive resin for forming the barrier layer 1011. This makes it possible to form the plurality of covering member support sections 1111 each of which is a resin structure formed as part of the barrier layer 1011.

For example, an exposure apparatus or a laser lithography apparatus producing ultraviolet light as a light source allows for the exposure. Among these, exposure is preferable in which a proximity exposure or contact exposure apparatus producing ultraviolet light as a light source is used. In the case of a proximity exposure apparatus, exposure is performed through a photomask having a channel pattern arrangement and a gap pattern arrangement in the microfluidic chip 1001. It is sufficient if a photomask or the like having a two-layer structure of chromium and chromium oxide as a light-shielding film is used as the photomask.

In addition, as described above, a photosensitive resin having photosensitivity to light having a wavelength of 190 nm or more and 400 nm or less, which is in the ultraviolet region, is used for the barrier layer 1011. It is thus sufficient if the photosensitive resin with which the substrate 1010 is coated is sensitized to light having a wavelength of 190 nm or more and 400 nm or less in this step (exposure step).

It is to be noted that, in a case where a chemically amplified resist or the like is used to form a resin layer on the substrate 1010, it is favorable to further conduct heating treatment (post-exposure bake: PEB) after exposure to accelerate an acid catalyst reaction caused by the exposure.

### (Step S1004)

Next, a step of developing the exposed photosensitive resin to form a channel pattern and a gap pattern that defines the covering member support sections 1111 is performed.

The development is conducted by reacting a photosensitive resin and a development liquid, for example, in a development apparatus of a spraying type, a dipping type, a puddle type, or the like. It is possible to use, for example, a sodium carbonate aqueous solution, tetramethyl ammonium hydroxide, potassium hydroxide, an organic solvent, or the like for the development liquid. It is sufficient if the optimum development liquid depending on the characteristics of the photosensitive resin is used as appropriate. The development liquid is not limited to them. In addition, it is possible to adjust the concentration or the development processing time to the optimum condition as appropriate depending on the characteristics of the photosensitive resin.

### (Step S1005)

Next, a step of cleaning the resin layer (photosensitive resin layer) on the substrate 1010 to completely remove the development liquid used for the development is performed. It is possible to carry out the cleaning, for example, by a cleaning apparatus of a spraying type, a showering type, an immersing type, or the like. It is sufficient if the optimum cleaning water for removing the development liquid used for the development process is used as the cleaning water as appropriate, for example, from pure water, isopropyl alcohol, or the like. After being cleaned, the resin layer is, for example, dried by a spin dryer or an IPA vapor dryer, or naturally dried.

### (Step S1006)

Next, a step of conducting heating treatment (post-bake) on the channel pattern, that is, the barrier layer 1011 that forms the channel section 1013 and the covering member support sections 1111 is performed. The residual moisture at the time of development or cleaning is removed through this post-baking treatment. The post-baking treatment is conducted by using, for example, a hot plate, an oven, or the like. In the case of insufficient drying in the cleaning step of step S1005 described above, the development liquid or the moisture at the time of cleaning remains in the barrier layer 1011 in some cases. In addition, the solvent that is not removed through the pre-baking treatment also remains in the barrier layer 1011 in some cases. It is possible to remove them by conducting post-baking treatment.

### (Step S1007)

Next, a step of bonding the cover layer 1012 to the barrier layer 1011 subjected to the post-baking treatment is performed. In this step, the cover layer 1012 is bonded to the opposite surface of the barrier layer 1011 to the substrate 1010 by thermocompression bonding as illustrated in Fig. 8. This causes the barrier layer 1011 that forms the channel sections 1013 and the covering member support sections 1111 to be covered with the cover layer 1012 and the microfluidic chip 1001 illustrated in Fig. 8 is formed. This step includes a step ( pressing step) of applying pressure to bond the barrier layer 1011 and the cover layer 1012 with no gap in between and a step (heating step) of heating the barrier layer 1011 and the cover layer 1012. It is to be noted that such an extremely minute gap that causes no liquid leakage when liquid flows through the microfluidic chip 1001 is permitted in the barrier layer 1011 and the cover layer 1012 "bonded with no gap in between".

In the thermocompression bonding method described above, for example, surface modification treatment is conducted on the bonding surfaces of the barrier layer 1011 and the cover layer 1012 and thermocompression bonding is then conducted. An example of the surface modification treatment includes, for example, plasma treatment. The surface modification treatment includes corona discharge treatment, excimer laser treatment, and the like in addition to the plasma treatment. It is sufficient if the reactivity of the surface of the barrier layer 1011 is increased and the optimum treatment method is selected as appropriate as the type of surface modification treatment depending on the affinity and the adhesion compatibility between the barrier layer 1011 and the cover layer 1012.

When members (the barrier layer 1011 and the cover layer 1012 in this example) are bonded to each other by thermocompression bonding, it is preferable to conduct thermocompression bonding in which a thermal press machine or a thermal roll machine is used, for example, after the surface modification treatment is conducted. The microfluidic chip 1001 according to the present embodiment is provided with the cover layer 1012 on the barrier layer 1011 by thermocompression bonding with no adhesive. This makes it possible to prevent an adhesive component from being eluted into a channel and prevent reaction of a solution in a channel from being inhibited.

**In** addition, it is desirable that the cover layer 1012 have holes corresponding to the input sections 1004 and the output sections 1005 (see Fig. 8) of fluids formed therein in advance before the cover layer 1012 is bonded to the barrier layer 1011. This makes it possible to prevent problems with the occurrence of debris and contamination in comparison with a case where holes are made after the barrier layer 1011 is bonded. It is preferable that the cover layer 1012 be formed to have a thickness which is within a range of 10 µm or more and 10 mm or less in consideration of through holes to be provided. **In** addition, it is possible to form the cover layer 1012 by using any of a light-transmissive material or a non-light-transmissive material. It is preferable to use resin, glass, or the like as the light-transmissive material. It is to be noted that the thickness and the material of the cover layer 1012 are not limited to the configuration described above in the present invention.

**In** this way, it is possible to form the barrier layer 1011 included in the channel sections 1013 on the substrate 1010 by using photolithography in the method for manufacturing the microfluidic chip 1001 according to the present embodiment.

For example, in a case where the photosensitive resin with which the substrate 1010 is coated is a positive resist, the exposure region is dissolved at the time of development to serve as the channel sections 1013. The photosensitive resin remaining in the non-exposure region serves as the barrier layer 1011. **In** addition, in a case where the photosensitive resin with which the substrate 1010 is coated is a negative resist, the photosensitive resin remaining in the exposure region serves as the barrier layer 1011 and the non-exposure region is dissolved at the time of development to serve as the channel sections 1013.

In this way, it is possible to form the barrier layer 1011 included in the channel sections 1013 on the substrate 1010 by using photolithography in the method for manufacturing the microfluidic chip 1001 according to the present embodiment.

For example, in a case where the photosensitive resin with which the substrate 1010 is coated is a positive resist, the exposure region is dissolved at the time of development to serve as the channel sections 1013. The photosensitive resin remaining in the non-exposure region serves as the barrier layer 1011. In addition, in a case where the photosensitive resin with which the substrate 1010 is coated is a negative resist, the photosensitive resin remaining in the exposure region serves as the barrier layer 1011 and the non-exposure region is dissolved at the time of development to serve as the channel sections 1013.

As described above, the method for manufacturing the microfluidic chip 1001 according to the present embodiment includes the step (step S1001 described above) of coating the substrate 1010 with resin, the step (step S1003 described above) of exposing the resin used for the coating, the steps (step S1004 described above and step S1005 described above) of developing and cleaning the exposed resin to form the barrier layer 1011 on the substrate 1010, the step (step S1006 described above) of conducing post-baking treatment on the barrier layer 1011, and the step (step S1007 described above) of bonding the cover layer 1012 to the opposite surface of the barrier layer 1011 to the substrate 1010 by thermocompression bonding. Further, the redundant resin (photosensitive resin layer) on the substrate 1010 is removed in the development step (step S1004 described above) of forming the barrier layer 1011, thereby forming the channel sections 1013 and the covering member support sections 1111 that support the cover layer 1012 on the substrate 1010, forming opening sections (channel pattern) each having an opening width of 2000 µm or less and serving as the channel section 1013 in the barrier layer 1011, so that the barrier layer 1011 has an opening area ratio of 20% or more and 60% or less.

This makes it possible to fabricate the microfluidic chip 1001 in which the resistance of the barrier layer 1011 to pressurization is prevented from reducing, the barrier layer 1011 and the cover layer 1012 are prevented from being deformed because of the thermal expansion coefficients at the time of heating, the bonding stability increases, members (the substrate 1010, the barrier layer 1011, and the cover layer 1012) are prevented from suffering damage and warpage due to pressure and heating at the time of bonding the barrier layer 1011 and the cover layer 1012, and no liquid leakage occurs when liquid flows.

In addition, when the microfluidic chip 1001 is fabricated, a seal is pasted or predetermined information (e.g., the identification number of the microfluidic chip, or the like) is printed in some cases by an ink jet printer in the region of the cover layer 1012 that does not overlap with the channel section 1013 in a plan view, that is, the region of the cover layer 1012 that is not opposed to the channel section 1013. As described above, the microfluidic chip 1001 has increased bonding stability. This also makes it possible to prevent members (the substrate 1010, the barrier layer 1011, and the cover layer 1012) from suffering damage or warpage due to pressure at the time of pasting a seal to or printing predetermined information on the cover layer 1012 bonded to the barrier layer 1011.

Further, in the method for manufacturing the microfluidic chip 1001 according to the present embodiment, the step (step S1007 described above) of bonding the barrier layer 1011 and the cover layer 1012 includes a step of applying pressure to bond the barrier layer 1011 and the cover layer 1012 with no gap in between and a step of heating the barrier layer 1011 and the cover layer 1012. As described above, in the method for manufacturing the microfluidic chip 1001 according to the present embodiment, the barrier layer 1011 forms the channel sections 1013 and the covering member support sections 1111 that support the cover layer 1012, the channel sections 1013 each have an opening width of 2000 µm or less, and the barrier layer 1011 has an opening area ratio of 20% or more and 60% or less. This increases the resistance of the barrier layer 1011 to pressure and heating and increases the bonding stability (the resistance of the substrate and the wall section to pressure) in the step of bonding a plurality of members (the barrier layer 1011 and the cover layer 1012 in this example) when the microfluidic chip 1001 is fabricated. It is therefore possible to provide a microfluidic chip in which members (the substrate 1010, the barrier layer 1011, and the cover layer 1012) are prevented from suffering damage and warpage due to pressure and heating at the time of bonding and no liquid leakage occurs when liquid flows. In addition, the increased bonding stability eliminates the necessity of bonding at low pressure and at low temperature to prevent damage due to pressure and heating when the microfluidic chip 1001 is fabricated. It is thus possible to prevent a defect (bonding failure) such as insufficiently bonding members to each other because of the bonding at low pressure and at low temperature.

### (2.1.3) Modification Examples

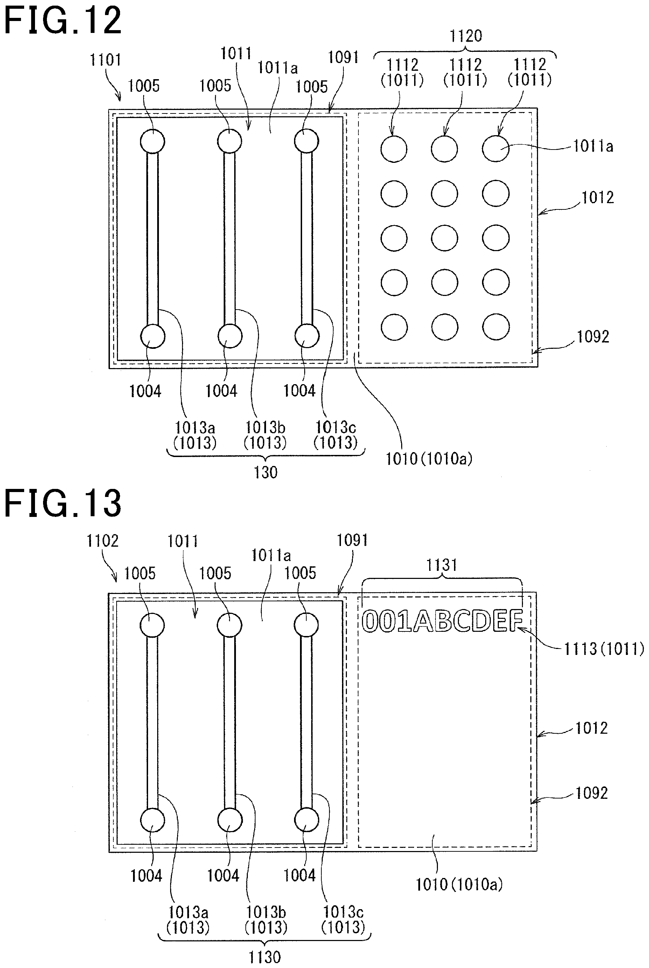

A microfluidic chip according to a modification example of the present embodiment will be described below by using Figs. 12 to 14.

Fig. 12 is an outline plan view for describing a configuration example of a microfluidic chip 1101 according to the modification example of the present embodiment.

As with the microfluidic chip 1001, the microfluidic chip 1101 includes the substrate 1010, the barrier layer 1011 that forms the channel group 1130 including the plurality of channel sections 1013 (channel sections 1013a to 1013c) on the substrate 1010, and the cover layer 1012.

As illustrated in Fig. 12, the microfluidic chip 1101 is different from the microfluidic chip 1001 in that covering member support sections 1112 are formed on the non-channel region 1092 by the barrier layer 1011. The covering member support sections 1112 support the cover layer 1012. The covering member support sections 1112 will be described below.

As illustrated in Fig. 12, in this example, each of the covering member support sections 1112 is a resin structure having a circular shape in a plan view. More specifically, in this example, the 15 (= 3 columns × 5 rows) covering member support sections 1112 are aligned and disposed on the non-channel region 1092. That is, the plurality of covering member support sections 1112 forms a dot (dotted) pattern 1120 on the non-channel region 1092 of the substrate 1010. The covering member support sections 1112 form the dot (dotted) pattern 1120, thereby making it possible to easily adjust the contact area between the barrier layer 1011 and the cover layer 1012 and appropriately control the opening area ratio Ar_2 of the barrier layer 1011. In addition, the dot (dotted) pattern 1120 allows the plurality of respective covering member support sections 1112 to be disposed at any positions in the non-channel region 1092 by design. It is therefore possible to flexibly dispose the covering member support sections 1112 depending on the purpose of the use of the microfluidic chip 1101, the materials of the barrier layer 1011 and the cover layer 1012, and the like.

It is possible to form each of the covering member support sections 1112 as part of the barrier layer 1011 by forming a gap pattern corresponding to the dot (dotted) pattern 1120 in the exposure step (step S1003 described above) and the development step (step S1004 described above) as with the covering member support section 1111 of the microfluidic chip 1001.

It is to be noted that the present disclosure is not limited to this. It is sufficient if at least the two or more covering member support sections 1112 are disposed on the non-channel region 1092 as the plurality of covering member support sections 1112 which forms the dot pattern 1120. It is then sufficient if the covering member support sections 1112 are disposed in the regions (the regions of the first and fifth covering member support sections 1112 from the top in the third column of the dot pattern 1120 illustrated in Fig. 12) corresponding to at least corner sections of the substrate 1010 in the non-channel region 1092. In addition, the plurality of covering member support sections 1112 that forms the dot pattern 1120 does not each have to have a circular planar shape. For example, the planar shape of each of the covering member support sections 1112 may be a polygonal shape. That is, the covering member support sections 1112 are resin structures each formed by part of the barrier layer 1011 to have a polygonal shape or a circular shape in a plan view. The plurality of resin structures may be disposed on the non-channel region 1092 to form dots. In addition, in this case, the polygonal shape may include an L shape. In a case where the planar shape of each of the covering member support sections 1112 is an L shape, the bent portion of the L may be disposed to match a corner section of the non-channel region 1092.

In addition, covering member support sections 1113 that support the cover layer 1012 may be formed on the non-channel region 1092 by the barrier layer 1011 as in a microfluidic chip 1102 illustrated in Fig. 13. As illustrated in Fig. 13, in this example, each of the covering member support sections 1113 is a resin structure having a character shape in a plan view. More specifically, in this example, the nine covering member support sections 1113 each having a character shape are linearly disposed in a row on the non-channel region 1092. That is, the plurality of covering member support sections 1113 forms a character string pattern 1131 on the non-channel region 1092 of the substrate 1010. The covering member support sections 1113 form the character string pattern 1131, thereby making it possible to display various kinds of information (e.g., an identification number, a product name, and the like) for the microfluidic chip 1102 on the non-channel region 1092 while securing the contact area between the barrier layer 1011 and the cover layer 1012.

It is possible to form each of the covering member support sections 1113 as part of the barrier layer 1011 by forming a gap pattern corresponding to the character string pattern 1131 in the exposure step (step S1003 described above) and the development step (step S1004 described above) as with the covering member support section 1111 of the microfluidic chip 1001.

It is to be noted that the present disclosure is not limited to this. It is sufficient if at least the two or more covering member support sections 1113 are provided on the non-channel region 1092 as the plurality of covering member support sections 1113 which forms the character string pattern 1131. In addition, each of the covering member support sections 1113 included in the letter string pattern 1131 may be any character such as an alphabetic character, a numeral, a katakana character, a hiragana character, or a kanji character. Alternatively, each of the covering member support sections 1113 may include a symbol. In addition, the covering member support section 1113 is not limited to the letter shape. The covering member support section 1113 may include a predetermined pattern (such as a geometric pattern, a woodgrain pattern, or a Japanese pattern) or various shapes such as an animal or person character.

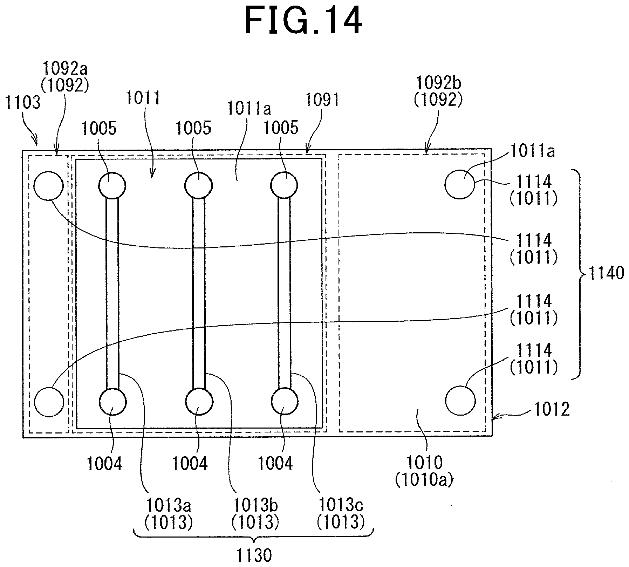

In addition, the plurality of non-channel regions 1092 may be formed as in a microfluidic chip 1103 illustrated in Fig. 14. In this case, the channel region 1091 may be disposed between the plurality of non-channel regions 1092. In Fig. 14, the non-channel region 1092 is divided into two regions (non-channel regions 1092a and 1092b) and the channel region 1091 is provided between the non-channel regions 1092a and 1092b. In this example, the substrate 1010 has a quadrangular shape as in the microfluidic chips 1001, 1101, and 1102 and the two non-channel regions 1092 are formed to include the four corner sections of the substrate 1010.

In addition, covering member support sections 1114 in the microfluidic chip 1103 are formed at the four corner sections of the substrate included in the non-channel regions 1092a and 1092b. More specifically, the covering member support sections 1114 each have a circular planar shape as with the covering member support section 1112 illustrated in Fig. 12 and are disposed at the four corner sections to form dots. That is, the plurality of covering member support sections 1114 forms a locally dotted pattern 1140 on the non-channel region 1092 of the substrate 1010.

It is to be noted that the present disclosure is not limited to this. It is sufficient if the covering member support sections 1114 are formed at two or more corner sections of the four corner sections of the substrate 1010 included in the non-channel regions 1092a and 1092b. This makes it possible in the microfluidic chip 1103 to secure the bonding area between the barrier layer 1011 and the cover layer 1012 and increase the bonding stability by locally disposing the covering member support sections 1114 at corner sections of the substrate 1010 that easily reduce in bonding stability. In addition, disposing the covering member support sections 1114 in the locally dotted pattern 1140 makes it possible to effectively increase the bonding stability without disposing a large number of covering member support sections 1114.

In addition, the present disclosure is not limited to this. The covering member support sections 1114 may each have a polygonal shape including an L shape as with the covering member support section 1112. In addition, the covering member support section 1114 may have a character shape.

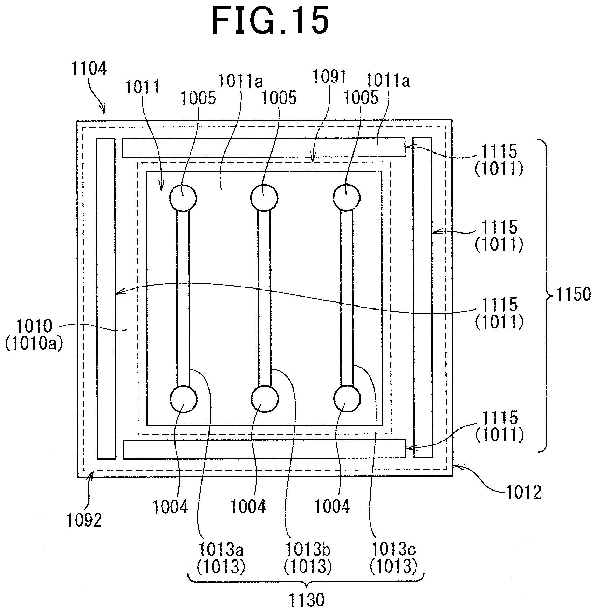

In addition, the non-channel region 1092 may be provided to surround the channel region 1091 as in a microfluidic chip 1104 illustrated in Fig. 15. That is, the non-channel region 1092 may be formed in the peripheral section of the front surface 1010a of the substrate 1010 and the channel region 1091 may be formed in the middle region of the front surface 1010a.

In addition, covering member support sections 1115 in the microfluidic chip 1104 are disposed to surround the inner periphery of the front surface 1010a of the substrate 1010 in the non-channel region 1092. More specifically, the covering member support sections 1115 each have a rectangular planar shape as with the covering member support section 1111 illustrated in Fig. 8 and are disposed along the four sides of the front surface 1010a of the substrate 1010. That is, the plurality of covering member support sections 1115 forms a frame pattern 1150 on the non-channel region 1092 of the substrate 1010. This makes it possible in the microfluidic chip 1104 to secure the bonding area between the barrier layer 1011 and the cover layer 1012 and increase the bonding stability by disposing the covering member support sections 1115 at peripheral sections of the substrate 1010 that easily suffer bonding failure.

### (2.2) 2-2-th Embodiment

### (2.2.1) Overview of Microfluidic Chip

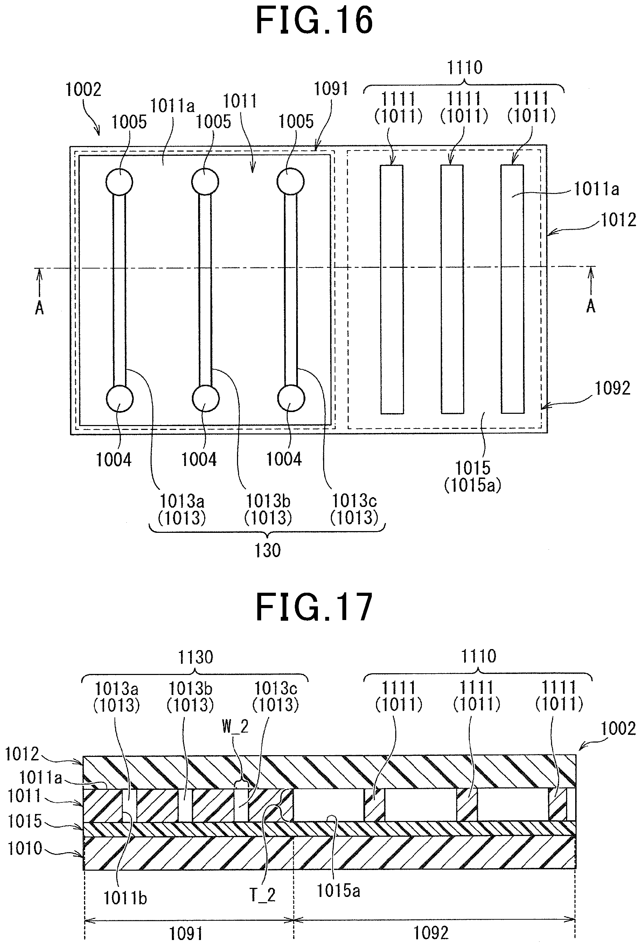

A microfluidic chip 1002 according to the 2-2-th embodiment of the present disclosure will be described below by using Figs. 16 and 17. Fig. 16 is an outline plan view describing a configuration example of the microfluidic chip 1002 according to the 2-2-th embodiment of the present disclosure. Fig. 17 is a cross-sectional view for describing the configuration example of the microfluidic chip 1002 according to the 2-2-th embodiment of the present disclosure.

As illustrated in each of Figs. 16 and 17, the microfluidic chip 1002 includes the substrate 1010, an adhesive layer 1015 disposed on the substrate 1010, the barrier layer 1011 that forms the channel group 1130 including the channel sections 1013a to 1013c and the covering member support sections 1111 above the substrate 1010, and the cover layer 1012. Specifically, the microfluidic chip 1002 includes the adhesive layer 1015 between the barrier layer 1011 and the substrate 1010. The microfluidic chip 1002 is different from the microfluidic chip 1001 according to the 2-1-th embodiment described above in that the microfluidic chip 1002 includes the adhesive layer 1015.

### (2.2.2) Configuration of Adhesive Layer

The adhesive layer 1015 will be described below. It is to be noted that the respective components (the substrate 1010, the barrier layer 1011, the cover layer 1012, and the channel sections 1013) other than the adhesive layer 1015 are similar to those of the microfluidic chip 1001, and will be thus denoted by the same reference signs and the description thereof will be omitted.

The substrate 1010 of the microfluidic chip 1002 may be subjected to hydrophobization surface treatment (HMDS treatment) or coated with a thin film of resin for the purpose of increasing the adhesion between the substrate 1010 and the resin layer (e.g., photosensitive resin layer), that is, the barrier layer 1011. In particular, for example, in a case where glass is used for the substrate 1010, the thin adhesive layer 1015 may be provided between the substrate 1010 and the barrier layer 1011 (photosensitive resin layer) as illustrated in Fig. 12. In this case, a fluid (e.g., liquid) flowing in each of the channel sections 1013 comes into contact with the adhesive layer 1015 instead of the substrate 1010. It is therefore sufficient if the adhesive layer 1015 has resistance to the fluid introduced to the channel section 1013. Providing the adhesive layer 1015 on the substrate 1010 also makes it possible to contribute to an increase in the resolution of a channel pattern by the photosensitive resin, or the like.

As described above, the adhesive layer 1015 is formed on the substrate 1010. Therefore, as illustrated in each of Figs. 16 and 17, in the microfluidic chip 1002 according to the present embodiment, the bottom section of each of the channel sections 1013 is formed by the adhesive layer 1015. The adhesive layer 1015 (specifically, a front surface 1015a of the adhesive layer 1015) included in the bottom section of the channel section 1013 is exposed in the channel section 1013.

### <Second Examples>

Examples (second Examples) of the second embodiment of the present disclosure will be specifically described below, but the second embodiment of the present disclosure is not limited to them.

### [Fabrication of Microfluidic Chip]

### <Example 1>

The present inventor manufactured a microfluidic chip by forming a barrier layer on a substrate and bonding the barrier layer and a cover layer as illustrated in each of Figs. 8 and 9.

A method for manufacturing the microfluidic chip 1001 according to Example 1 in the second Examples will be described. First, glass was used as a substrate.

The glass substrate was coated with a transparent photosensitive resin to form a photosensitive resin layer. An acryl-based photosensitive resin was used for the photosensitive resin. The glass substrate was coated with the photosensitive resin by using a spin coater at a rotation speed of 1100 rpm for 30 seconds. The rotation speed and the time were adjusted to obtain a film thickness of 50 µm. Next, heating treatment (pre-bake) was conducted on a hot plate for the purpose of removing a residual solvent medium included in the photosensitive resin. Pre-baking was carried out at a temperature of 90°C for 20 minutes.

Next, the photosensitive resin layer on the glass substrate was exposed to draw a channel pattern and a gap pattern for forming a covering member support section. Specifically, the photosensitive resin was subjected to pattern exposure through a photomask having a microfluidic channel pattern arrangement and a photomask having a gap pattern arrangement of a covering member support section. A photomask having a two-layer structure of chromium and chromium oxide as a light-shielding film was used as the photomask. In addition, a proximity exposure apparatus was used for the exposure. The exposure apparatus carried out exposure by using a highpressure mercury lamp as a light source and having a cut filter of an i-line filter therein. The exposure value was 170 mJ/cm².

Next, the exposed photosensitive resin layer was developed and used as a barrier layer in which the channel pattern and the gap pattern for forming a covering member support section were formed. Specifically, the photosensitive resin layer was developed for 60 seconds by using an alkali development liquid (TMAH 2.38%) to dissolve unexposed portions and pattern channel structures.

Subsequently, shower washing with ultrapure water was performed to remove the development liquid from the photosensitive resin layer on the substrate, and the substrate was dried using a spin dryer.

Next, members (a substrate and a barrier layer) for a microfluidic chip in which the channel pattern and the gap pattern for forming a covering member support section were formed was subjected to heating treatment (post-bake) in an oven at 100°C for ten minutes.

In the development step described above, channel structures and covering member support sections were formed (patterned) so that a channel section had an opening width (channel width) of 10 µm and a channel length of 500 mm and so that opening area ratio Ar_2 of the barrier layer was 20% in the barrier layer subjected to the post-baking (the remaining moisture was removed). As illustrated in Fig. 14, the covering member support sections each had a circular planar shape and were formed in a locally dotted pattern (see Fig. 14) in which the covering member support sections were disposed at the four respective corner sections on the substrate 1010. The opposite surface (the surface having a circular shape) of each of the covering member support sections to the substrate had a diameter of 500 µm.

Next, the bonding surfaces of the barrier layer in which a channel section was formed and the separately fabricated cover layer were subjected to surface modification treatment and the barrier layer and the cover layer were then bonded by thermocompression bonding while being heated to 60°C. A polycarbonate having a channel inlet and a channel outlet formed in advance and having a thickness of 5 mm was used for the cover layer. This offered a microfluidic chip according to this Example.

### <Example 2>

Channel structures were formed by development in a barrier layer formed on a glass substrate so that the channel sections had an opening width of 500 µm. Except for this, a microfluidic chip according to Example 2 was obtained as in Example 1 described above in the second Examples.

### <Example 3>

Channel structures were formed by development in a barrier layer formed on a glass substrate so that channel sections had an opening width of 2000 µm. Except for that, a microfluidic chip according to Example 3 was obtained as in Example 1 described above in the second Examples.

### <Example 4>

Covering member support sections each had a rectangular planar shape and were formed in a frame pattern (see Fig. 15) in which the covering member support sections were disposed on the four sides of the substrate 1010. The size (the area of the opposite surface to a substrate) of each covering member support section was 25 square millimeters (0.5 mm (500 µm) × 50 mm = 25 mm²). Except for that, a microfluidic chip according to Example 4 was obtained as in Example 1 described above in the second Examples.

### <Example 5>

Channel structures were formed by development in a barrier layer formed on a glass substrate so that the channel sections had an opening width of 500 µm. Except for that, a microfluidic chip according to Example 5 was obtained as in Example 4 described above in the second Examples.

### <Example 6>

Channel structures were formed by development in a barrier layer formed on a glass substrate so that channel sections had an opening width of 2000 µm. Except for that, a microfluidic chip according to Example 6 was obtained as in Example 4 described above in the second Examples.

### <Example 7>

Channel structures and covering member support sections were formed by development in a barrier layer formed on a glass substrate such that the opening area ratio Ar_2 of the barrier layer was 60%. Except for that, a microfluidic chip according to Example 7 was obtained as in Example 1 described above in the second Examples.

### <Example 8>

Channel structures were formed by development in a barrier layer formed on a glass substrate so that the channel sections had an opening width of 500 µm. Except for that, a microfluidic chip according to Example 8 was obtained as in Example 7 described above in the second Examples.

### <Example 9>

Channel structures were formed by development in a barrier layer formed on a glass substrate so that channel sections had an opening width of 2000 µm. Except for that, a microfluidic chip according to Example 9 was obtained as in Example 7 described above in the second Examples.

### <Example 10>

Channel structures and covering member support sections were formed by development in a barrier layer formed on a glass substrate such that the opening area ratio Ar_2 of the barrier layer was 60%. Except for that, a microfluidic chip according to Example 10 was obtained as in Example 4 described above in the second Examples.

### <Example 11>

Channel structures were formed by development in a barrier layer formed on a glass substrate so that the channel sections had an opening width of 500 µm. Except for that, a microfluidic chip according to Example 11 was obtained as in Example 10 described above in the second Examples.

### <Example 12>

Channel structures were formed by development in a barrier layer formed on a glass substrate so that channel sections had an opening width of 2000 µm. Except for that, a microfluidic chip according to Example 12 was obtained as in Example 10 described above in the second Examples.

### <Comparative Example 1>

Channel structures and covering member support sections were formed by development in a barrier layer formed on a glass substrate such that the opening area ratio Ar_2 of the barrier layer was 10%. Except for that, a microfluidic chip according to a comparative example 1 was obtained as in Example 1 described above in the second Examples.

### <Comparative Example 2>

Channel structures were formed by development in a barrier layer formed on a glass substrate so that channel sections had an opening width of 3000 µm. Except for that, a microfluidic chip according to a comparative example 2 was obtained as in Example 1 described above in the second Examples.

### <Comparative Example 3>

Channel structures and covering member support sections were formed by development in a barrier layer formed on a glass substrate such that the opening area ratio Ar_2 of the barrier layer was 80% and a channel section had an opening width of 500 µm. Except for that, a microfluidic chip according to a comparative example 3 was obtained as in Example 1 described above in the second Examples.

### <Comparative Example 4>

Channel structure were formed and no covering member support sections were formed by development in a barrier layer formed on a glass substrate such that the opening area ratio Ar_2 of the barrier layer was 20% and a channel section had an opening width of 500 µm. Except for that, a microfluidic chip according to a comparative example 4 was obtained as in Example 1 described above in the second Examples.

### [Assessment Methods]

The presence or absence of damage and warpage and the presence or absence of liquid leakage at the time of bonding the cover layers were assessed for the microfluidic chips according to Example 1 to Example 12 and the comparative example 1 to the comparative example 4 described above in the second Examples in the following methods after the bonding.

### (Presence or Absence of Damage and Warpage)

The presence or absence of damage was visually confirmed for each of the microfluidic chips according to Example 1 to Example 12 and the comparative example 1 to the comparative example 4 described above in the second Examples. "∘ (acceptable)" indicates that none of damage and warpage was visually confirmed and "× (unacceptable)" indicates that at least one of damage or warpage was visually confirmed.

### (Presence or Absence of Liquid Leakage)

A 10-µL colored reaction solution was collected by a pipette and introduced from an inlet channel of the cover layer for each of the microfluidic chips according to Example 1 to Example 12 and the comparative example 1 to the comparative example 4 described above in the second Examples. The transfer of the solution was observed with a microscope.

The liquid leakage state of each microfluidic chip was assessed in the two levels of "∘" and " ×" by the following criterion on the basis of a result of the observation.

### <Assessment Criterion>

∘: no liquid leakage was observed from the channel at a portion at which the barrier layer and the cover layer are bonded
×: liquid leakage was observed from the channel at a portion at which the barrier layer and the cover layer are bonded

It is to be noted that "-" describes that it is not possible for liquid to flow because of damage to a microfluidic chip.

Assessment results of the Examples and the comparative examples in the second Examples will be shown in Table 3 along with the opening area ratios of the barrier layers in the microfluidic chips, the opening widths of the channels, the channel lengths, and the configurations of the covering member support sections.

**[Table 3]**

| | Barrier layer | | | Covering member support section | | | Assessment | |
|---|---|---|---|---|---|---|---|---|
| | opening area ratio | opening width of channel | channel length | shape | size | disposition | damage state after bonding | liquid leakage |
| Example 1 | 20% | 10 µm | 50 mm | dot (circle) | diameter of 500 µm | four corners | ○ | ○ |
| Example 2 | 20% | 500 µm | 50 mm | | | | ○ | ○ |
| Example 3 | 20% | 2000 µm | 50 mm | | | | ○ | ○ |
| Example 4 | 20% | 10 µm | 50 mm | frame | 500 µm × 50 mm | four sides | ○ | ○ |
| Example 5 | 20% | 500 µm | 50 mm | | | | ○ | ○ |
| Example 6 | 20% | 2000 µm | 50 mm | | | | ○ | ○ |
| Example 7 | 60% | 10 µm | 50 mm | dot (circle) | diameter of 500 µm | four corners | ○ | ○ |
| Example 8 | 60% | 500 µm | 50 mm | | | | ○ | ○ |
| Example 9 | 60% | 2000 µm | 50 mm | | | | ○ | ○ |
| Example 10 | 60% | 10 µm | 50 mm | frame | 500 µm × 50 mm | four sides | ○ | ○ |
| Example 11 | 60% | 500 µm | 50 mm | | | | ○ | ○ |
| Example 12 | 60% | 2000 µm | 50 mm | | | | ○ | ○ |
| comparative example 1 | 10% | 10 µm | 50 mm | dot (circle) | diameter of 500 µm | four corners | × | × |
| comparative example 2 | 20% | 3000 µm | 50 mm | | | | × | - |
| comparative example 3 | 80% | 500 µm | 50 mm | | | | × | - |
| comparative example 4 | 20% | 500 µm | 50 mm | - | - | - | × | - |

It was confirmed that all of the microfluidic chips according to Example 1 to Example 12 in the second Examples suffered neither damage nor warpage after bonding and no liquid leakage occurred after liquid flowed. In contrast, the microfluidic chips according to the comparative example 1 to the comparative example 4 described above in the second Examples each suffered damage or warpage after bonding and liquid leakage was further confirmed after liquid flowed through the microfluidic chip according to the comparative example 1 of the comparative examples. In addition, the microfluidic chips according to the comparative example 2 to the comparative example 4 each suffered significant damage and it was not possible for liquid to flow.

As the results described above, it was confirmed that the barrier layer formed a channel section and a covering member support section, and the opening area ratio of the barrier layer and the dimensions (e.g., the opening width of the channel and the gap between the covering member support sections) of an opening section formed in the barrier layer were controlled in each of the microfluidic chips according to the respective Examples of the second Examples to satisfy the specific conditions, thereby increasing the bonding stability of bonding a plurality of members (the wall section and the covering member here), preventing members from suffering damage and warpage due to pressure at the time of bonding the barrier layer and the cover layer, and without liquid leakage occurring when liquid flowed.

Specifically, as in each of the microfluidic chips according to Example 1 to Example 12 described above in the second Examples, it was confirmed that a channel section and a covering member support section which supported the cover layer were formed in the barrier layer on the substrate, the channel section was formed as an opening section having an opening width of 2000 µm or less, and the barrier layer had an opening area ratio of 20% or more and 60% or less, thereby preventing members from suffering damage and warpage due to pressure and heating at the time of bonding the barrier layer and the cover layer by thermocompression bonding and without liquid leakage occurring when liquid flowed.

**In** addition, for example, it is possible for the second embodiment described above to adopt configurations as follows.
(1) A microfluidic chip including:
   a substrate;
   a channel provided on the substrate;
   a covering member that serves as a cover of the channel; and
   a barrier section including a resin material, the barrier section being disposed between the substrate and the covering member, the barrier section forming a channel and a covering member support section on the substrate, the covering member support section supporting the covering member, characterized in that
   the channel is formed in the barrier section as an opening section having an opening width of 2000 µm or less,
   the barrier section has an opening area ratio of 20% or more and 60% or less,
   the barrier section and the covering member are bonded by thermocompression bonding, and
   the covering member is bonded to an opposite surface of the barrier section to the substrate.
(2) The microfluidic chip according to (1), characterized in that
   the substrate includes a channel region in which the channel is provided and a non-channel region in which the channel is not provided on a surface opposed to the covering member,
   the channel is formed on the channel region by the barrier section, and
   one or more resin structures each including part of the barrier section are formed on the non-channel region as covering member support sections that each support the covering member.
(3) The microfluidic chip according to (2), characterized in that the barrier section does not vary in thickness between the channel region and the non-channel region.(4) The microfluidic chip according to (2) or (3), characterized in that
   the covering member support section is the resin structure formed by the part of the barrier section, the resin structure having a rectangular shape in a plan view, and
   a plurality of the covering member support sections is disposed on the non-channel region to be parallel with long sides of the rectangles.
(5) The microfluidic chip according to (4), characterized in that
   the covering member support section is the resin structure formed by the part of the barrier section, the resin structure having a polygonal shape or a circular shape in a plan view, and
   a plurality of the resin structures is disposed on the non-channel region to form dots.
(6) The microfluidic chip according to any one of (2) to (5), characterized in that
   the substrate has a quadrangular shape,
   the non-channel region includes four corner sections of the substrate, and
   the covering member support sections are formed at two or more corner sections of the four corner sections of the substrate included in the non-channel region.
(7) The microfluidic chip according to any one of (1) to (6), characterized in that the covering member support section that is the part of the barrier section is in surface contact with the covering member on an opposite surface to the substrate.
(8) The microfluidic chip according to any one of (1) to (7), characterized in that the barrier section forms a channel group including a plurality of the channels on the substrate.
(9) The microfluidic chip according to any one of (1) to (8), characterized in that an adhesive layer is provided between the substrate, and the barrier section and the covering member support section.
(10) The microfluidic chip according to any one of (1) to (9), characterized in that the resin material that forms the barrier section is a photosensitive resin having photosensitivity to light having a wavelength of 190 nm or more and 400 nm or less which is in an ultraviolet region.
(11) A method for manufacturing a microfluidic chip, including:
   a step of coating a substrate with resin;
   a step of exposing the resin used for the coating;
   a step of developing and cleaning the exposed resin to form a barrier section on the substrate;
   a step of conducting post-baking treatment on the barrier section; and
   a step of bonding a covering member to an opposite surface of the barrier section to the substrate by thermocompression bonding, characterized in that
   redundant resin on the substrate is removed by the developing in a step of forming the channel so that the barrier section forms a channel and a covering member support section on the substrate, forms an opening section having an opening width of 2000 µm or less in the barrier section as the channel, and so that the barrier section has an opening area ratio of 20% or more and 60% or less, the covering member support section supporting the covering member.
(12) The method for manufacturing the microfluidic chip according to (11), characterized in that the step of bonding the covering member to the opposite surface of the barrier section to the substrate includes a step of applying pressure to bond the barrier section and the covering member with no gap in between and a step of heating the barrier section and the covering member.
(13) The method for manufacturing the microfluidic chip according to (11) or (12), characterized in that a photosensitive resin is sensitized to light having a wavelength of 190 nm or more and 400 nm or less in an ultraviolet region in the step of exposing the resin.

### 3. Third Embodiment

A third embodiment of the present disclosure will be described. The third embodiment of the present disclosure relates to a microfluidic base member used to form a channel in a microfluidic chip and a method for manufacturing the microfluidic base member.

As described above, µ-TAS uses micrometer-sized channels (microfluidic channels or microchannels) formed on substrates in many cases. Such substrates are each referred to as a chip, a microchip, a microfluidic chip, or the like. It is to be noted that the substrate and the wall section which forms a channel on the substrate in the microfluidic chip are generically referred to as a microfluidic base member.

Conventionally, such microfluidic chips have been fabricated by using technology such as injection molding, molding, cutting, and etching. In addition, glass substrates have been chiefly used as substrates of base members (microfluidic base members) that form microfluidic chips because the glass substrates are easy to manufacture and also allow for optical detection. Meanwhile, microfluidic chips formed by using microfluidic base members including light and inexpensive resin materials less prone to damage than glass substrates also have been under development. Methods for manufacturing microfluidic chips by microfluidic base members including resin materials include a method for fabricating a microfluidic chip by forming a resin pattern for a channel on a substrate as a microfluidic base member chiefly by photolithography and bonding a covering member to the microfluidic base member. This method makes it possible to form even a fine channel pattern that is difficult to form by the conventional technology in some cases.

Such a microfluidic chip is fabricated by bonding a plurality of members (e.g., a microfluidic base member and a covering member) to each other. For example, a microfluidic chip has been proposed that is formed in a method in which a plurality of members is bonded to each other with an adhesive in between. In addition, for example, a method has also been proposed in which process gas is converted to plasma under atmospheric pressure or pressure near atmospheric pressure to modify a substrate surface and members are bonded to each other with no adhesive.

As described above, when a microfluidic chip is fabricated, a plurality of members such as a microfluidic base member and a covering member are bonded to each other. It is therefore necessary to apply the pressure corresponding to the bonding method to the members. For example, when a wall section (barrier section) of a microfluidic base member in which a channel is formed and a covering member are bonded, these members are pressed in accordance with the bonding method. A channel portion (an opening region of the wall section) has occupied larger surface area in a microfluidic chip in recent years as a channel pattern structure has become more complicated. When the wall section has a larger opening area or greater opening width, the stability of bonding the wall section and the covering member reduces and members of the microfluidic chip, that is, a microfluidic base member (a substrate and the wall section), a cover layer, and the like may suffer damage. **In** addition, if the members suffer damage when the members are bonded to each other, liquid leakage occurs in some cases when liquid flows through the microfluidic chip formed by using these members.

Accordingly, an object of the third embodiment of the present disclosure is to provide a microfluidic base member that allows a microfluidic chip to be formed in which members are prevented from suffering damage due to pressure at the time of bonding members included in the microfluidic chip to each other and no liquid leakage occurs when liquid flows, and a method for manufacturing the microfluidic base member.

To achieve the object described above, a microfluidic base member according to the third embodiment includes: a substrate; and a barrier section including a resin material. The barrier section is provided on the substrate. The barrier section forms a channel on the substrate. The microfluidic base member is characterized in that the channel is formed in the barrier section as an opening section having an opening width of 2000 µm or less, and the barrier section has an opening area ratio of 60% or less in a covering member bonded state in which a covering member is provided on an opposite surface of the barrier section to the substrate. The covering member serves as a cover of the channel.

**In** addition, a method for manufacturing a microfluidic base member according to an aspect of the third embodiment includes: a step of coating a substrate with resin; a step of exposing the resin used for the coating; a step of developing and cleaning the exposed resin to form a barrier section that defines a channel on the substrate; and a step of conducting post-baking treatment on the barrier section. The method is characterized in that redundant resin on the substrate is removed by the developing to form an opening section having an opening width of 2000 µm or less in the barrier section and cause the barrier section to have an opening area ratio of 60% or less in a covering member bonded state in which a covering member is provided on an opposite surface of the barrier section to the substrate. The opening section serves as the channel. The covering member serves as a cover of the channel.

According to an aspect of the third embodiment of the present disclosure, it is possible to provide a microfluidic base member that allows a microfluidic chip to be formed in which members are prevented from suffering damage due to pressure at the time of bonding members included in the microfluidic chip to each other and no liquid leakage occurs when liquid flows.

The microfluidic base member according to the third embodiment of the present disclosure and a microfluidic chip fabricated by using the microfluidic base member will be described. It is to be noted that the sides of the microfluidic base member and the microfluidic chip closer to a substrate will be described as "down" and the opposite sides of the microfluidic base member and the microfluidic chip to the substrate (closer to a covering member) will be described as "up" in the following description in some cases.

As a result of intensive studies, the present inventors have found that the opening area ratio of a wall section and the dimensions (e.g., the opening width of a channel) of an opening section formed in the wall section are controlled in a microfluidic base member which forms a microfluidic chip to satisfy the specific conditions, thereby increasing the bonding stability at the time of bonding the microfluidic base member and a covering member which are members included in the microfluidic chip. The present inventors have hereby invented a microfluidic base member that allows a microfluidic chip to be formed in which respective members (a substrate and a wall section) of the microfluidic base member and a covering member are prevented from suffering damage due to pressure at the time of bonding members (the microfluidic base member and the covering member) included in the microfluidic chip to each other and no liquid leakage occurs when liquid flows, and a method for manufacturing the microfluidic base member. It is to be noted that details of the opening area ratio of the wall section will be described below.

The respective aspects (a 3-1-th embodiment and a 3-2-th embodiment) of the third embodiment of the present disclosure will be described below with reference to the drawings.

### (3.1) 3-1-th Embodiment

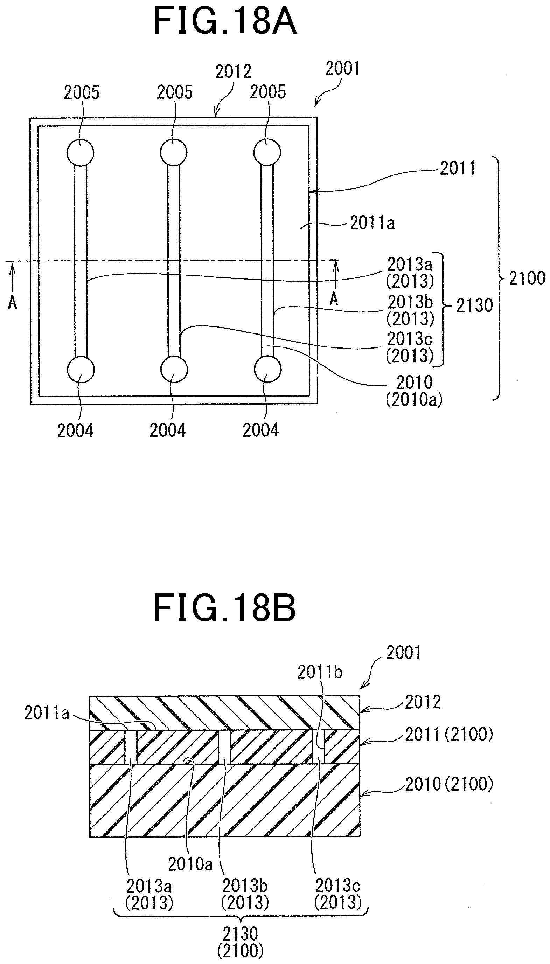

The configurations of a microfluidic chip 2001 and a microfluidic base member 2100 used for the microfluidic chip 2001 will be described below with reference to Figs. 18A to 20.

### (3.1.1) Basic Configuration of Microfluidic Chip

Fig. 18 is an outline diagram for describing a configuration example of the microfluidic chip 2001 according to the 3-1-th embodiment (referred to as "the present embodiment" below) of the present disclosure. Specifically, Fig. 18A is an outline plan view of the microfluidic chip 2001 according to the present embodiment. In addition, Fig. 18B is an outline cross-sectional view of a cross section of the microfluidic chip 2001 taken along a line A-A illustrated in Fig. 18A.

As illustrated in each of Figs. 18A and 18B, the microfluidic chip 2001 includes the microfluidic base member 2100 and a cover layer 2012 that is a covering member. A component obtained by removing the cover layer 2012 from the microfluidic chip 2001 corresponds to the microfluidic base member 2100. The basic configuration serving as the whole of the microfluidic chip 2001 will be described below. It is to be noted that the specific configurations of the microfluidic base member 2100 and the cover layer 2012 will be described below.

As illustrated in Fig. 18A, the microfluidic chip 2001 includes input sections 2004 each for introducing a fluid (e.g., liquid), channel sections 2013 each formed on a substrate 2010, and output sections 2005 each for discharging a fluid from the channel section 2013. The fluid introduced from the input section 2004 flows in the channel section 2013. Of these members, the input sections 2004 and the output sections 2005 are provided in the cover layer 2012 and the channel sections 2013 are formed in the microfluidic base member 2100.

Each of the output sections 2005 is not limited to a component (discharge section) for discharging a fluid and may be a component (drug fixation section) for bringing the fluid and a drug solution into contact. A component that functions as at least one of the discharge section or the drug solution fixation section of a fluid will be generically referred to as the "output section" below.

A barrier layer (an example of the barrier section) 2011 that defines each of the channel sections 2013 is formed on the substrate 2010 of the microfluidic base member 2100. The channel section 2013 is an opening section that opens on a front surface 2011a. **In** the microfluidic chip 2001, the channel section 2013 is covered with a cover layer (an example of the covering member) 2012 that is a covering member. The input sections 2004 and the output sections 2005 are through holes provided in the cover layer 2012. Details of the respective components will be described below.

Fig. 18A illustrates the substrate 2010, the barrier layer 2011, and the channel sections 2013 that are visually recognized through the cover layer 2012 having transparency.

It is sufficient if the microfluidic chip 2001 is provided with the at least one or more input sections 2004 and the at least one or more output sections 2005. The microfluidic chip 2001 may be provided with the plurality of input sections 2004 and the plurality of output sections 2005. In addition, it is sufficient if the one or more channel sections 2013 are provided in the microfluidic chip 2001. The plurality of channel sections 2013 may be provided. The channel sections 2013 may be designed to allow fluids introduced from the input sections 2004 to merge or be separated. Specifically, the plurality of input sections 2004 may be provided for the one channel section 2013 or the one input section 2004 may be provided for the plurality of channel sections 2013. In addition, similarly, the plurality of output sections 2005 may be provided for the one channel section 2013 or the one output section 2005 may be provided for the plurality of channel sections 2013.

The microfluidic chip 2001 illustrated in each of Figs. 18A and 18B includes the microfluidic base member 2100 including a channel group 2130 including the three channel sections 2013 (channel sections 2013a, 2013b, and 2013c) as an example.

Details of the members (the substrate 2010, the barrier layer 2011, and the cover layer 2012) included in the channel sections 2013 (channel sections 2013a to 2013c) in the microfluidic chip 2001 will be described here.

As illustrated in Fig. 18B, the barrier layer 2011 that is a wall section sandwiched between two substrate members (a first substrate member and a second substrate member) defines the channel sections 2013 that are channels in each of which a fluid flows in the microfluidic chip 2001. In this example, the cover layer (an example of the covering member) 2012 that is provided on the upper surface side of the barrier layer 2011 and covers the upper section of the channel section 2013 corresponds to the first substrate member. The substrate 2010 that is provided on the bottom surface side of the barrier layer 2011 and forms the bottom section of the channel section 2013 corresponds to the second substrate member. That is, the microfluidic chip 2001 includes the substrate 2010, the channel sections 2013 provided on the substrate 2010, the cover layer 2012 that serves as a cover of the channel sections 2013, and the pair of barrier layers 2011 that is disposed between the cover layer 2012 and the substrate 2010 and forms the channel section 2013 on the substrate 2010. More specifically, the microfluidic chip 2001 includes the microfluidic base member 2100 including the substrate 2010, the barrier layer 2011 that is provided on the substrate 2010 and forms channels, and the channel sections 2013 that are the channels on the substrate 2010, and the cover layer 2012 that is a covering member which is provided on the opposite surface of the barrier layer 2011 to substrate 2010 and covers the channel sections 2013.

Each of the channel sections 2013 in which a fluid introduced from the input section 2004 flows is a region surrounded by the substrate 2010, the barrier layer 2011, and the cover layer 2012. The channel section 2013 is defined by the barrier layer 2011 provided on the substrate 2010 to be opposed to the substrate 2010. The opposite side of the channel section 2013 to the substrate 2010 is covered with the cover layer 2012 that serves as a covering member. As described above, a fluid is introduced to the channel section 2013 from the input section 2004 provided in the cover layer 2012 and the fluid flowing in the channel section 2013 is discharged from the output section 2005.

### (3.1.2) Microfluidic Base Member

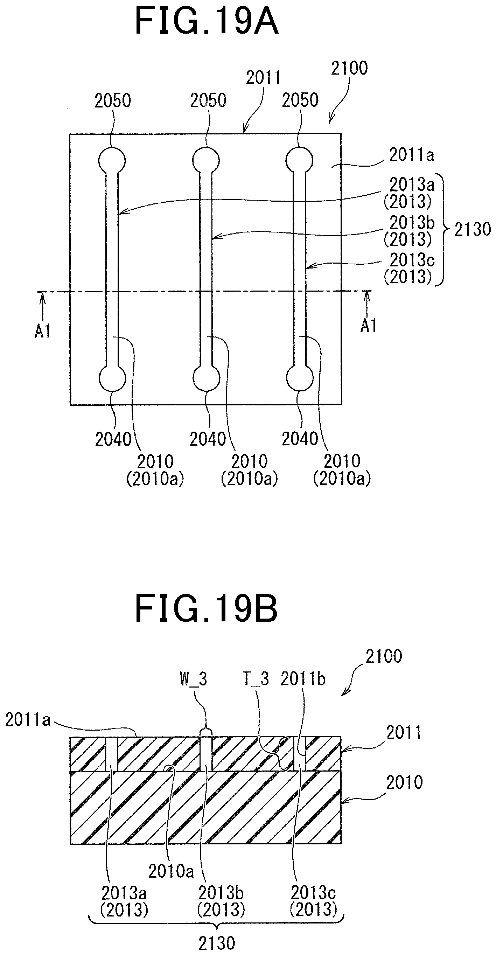

Next, the respective members of the microfluidic base member will be described by using Figs. 19A and 19B with reference to Figs. 18A and 18B.

Each of Figs. 19A and 19B is an outline diagram for describing a configuration example of the microfluidic base member 2100 according to the present embodiment. Specifically, Fig. 19A is an outline plan view of the microfluidic base member 2100 according to the present embodiment. In addition, Fig. 19B is an outline cross-sectional view of a cross section of the microfluidic base member 2100 taken along a line A1-A1 illustrated in Fig. 19A.

As illustrated in each of Figs. 19A and 19B, the microfluidic base member 2100 includes the substrate 2010 and the barrier layer 2011 that includes a resin material and is provided on the substrate 2010 to form channels on the substrate 2010. The respective members included in the microfluidic base member 2100 will be described in detail below.

### (3.1.2.1) Substrate

The substrate 2010 is a member serving as the base of the microfluidic base member 2100, that is, the base of the microfluidic chip 2001. The barrier layer 2011 provided on the substrate 2010 is included in the channel sections 2013. That is, the substrate 2010 and the barrier layer 2011 included in the microfluidic base member 2100 can be regarded as the body section of the microfluidic chip 2001.

It is possible to form the substrate 2010 by using any of a light-transmissive material or a non-light-transmissive material. For example, in a case where the internal state (the state of a fluid) of each of the channel sections 2013 is detected and observed by using light, it is possible to use a material that is excellent in transparency to the light. This allows the inner state of the channel section 2013 to be observed, for example, from the substrate 2010 side. It is possible to use resin, glass, or the like as the light-transmissive material. The resin used for the light-transmissive material that is used to form the substrate 2010 includes an acrylic resin, a methacrylic resin, polypropylene, a polycarbonate resin, a cycloolefin resin, a polystyrene resin, a polyester resin, a urethane resin, a silicone resin, a fluororesin, and the like from the perspective of the suitability for the formation of the body section of the microfluidic chip 2001.

**In** addition, for example, in a case where it is unnecessary to detect or observe the internal state (the state of a fluid) of each of the channel sections 2013 by using light, a non-light-transmissive material may be used. The non-light-transmissive material includes a silicon wafer, a copper plate, and the like. The thickness of the substrate 2010 is not limited in particular, but a certain level of rigidity is necessary in a channel formation step and it is thus preferable that the thickness of the substrate 2010 be within a range of 10 µm (0.01 mm) or more and 10 mm or less.

### (3.1.2.2) Barrier Layer

The barrier layer 2011 is a component that is provided on the substrate 2010 and forms the channel sections 2013. Specifically, the channel section 2013 is defined by opposed side surfaces 2011b of the barrier layers 2011. As illustrated in each of Figs. 19A and 19B, the channel group 2130, that is, the plurality of channel sections 2013 (channel sections 2013a, 2013b, and 2013c), is formed in the barrier layer 2011 in the present embodiment. That is, the barrier layer 2011 forms the channel group 2130 including the plurality of channel sections 2013 on the substrate 2010. The microfluidic chip 2001 includes the microfluidic base member 2100 including the plurality of channel sections 2013, thereby making it possible, for example, to carry out a plurality of tests at the same time or carry out tests in which different types of fluids are used. It is possible to use the microfluidic chip more widely. The plurality of respective channel sections 2013 may be independent or some of the plurality of channel sections 2013 may cross each other.

It is possible to form the barrier layer 2011 by using a resin material. It is possible to use, for example, a photosensitive resin as the resin material of the barrier layer 2011.

It is desirable that the photosensitive resin that forms the barrier layer 2011 have photosensitivity to light having a wavelength of 190 nm or more and 400 nm or less, which is in the ultraviolet region. It is possible to use a photoresist such as a liquid resist or a dry film resist as the photosensitive resin. These photosensitive resins may be either positive photosensitive resins in which the photosensitive regions are dissolved or negative photosensitive resins in which the photosensitive regions are insoluble. A photosensitive resin composition suitable for the formation of the barrier layer 2011 in the microfluidic base member 2100 includes a radical negative photosensitive resin including an alkali-soluble polymer, an additional polymerizable monomer, and a photopolymerization initiator. It is possible to use, for example, an acryl-based resin, an acrylic urethane-based resin (urethane acrylate-based resin), an epoxy-based resin, a polyamide-based resin, a polyimide-based resin, a polyurethane-based resin, a polyester-based resin, a polyether-based resin, a polyolefin-based resin, a polycarbonate-based resin, a polystyrene-based resin, a norbornene-based resin, a phenolic novolac-based resin, and another resin having photosensitivity alone, or use a mixture of some of the resins or use copolymerized resins as the photosensitive resin material.

It is to be noted that the resin material of the barrier layer 2011 is not limited to the photosensitive resin in the present embodiment. For example, silicone rubber (PDMS: polydimethylsiloxane) or synthetic resin may be used. It is possible to use, for example, a polymethyl methacrylate resin (PMMA), polycarbonate (PC), a polystyrene resin (PS), polypropylene (PP), a cycloolefin polymer (COP), a cycloolefin copolymer (COC), or the like as the synthetic resin. It is desirable to select the resin material of the barrier layer 2011 as appropriate depending on the application.

In addition, in the present embodiment, the front surface 2011a of the barrier layer 2011 is flat. This bonds the barrier layer 2011 to the cover layer 2012 more stably in the covering member bonded state. It is to be noted that the front surface 2011a of the barrier layer 2011 may be provided with minute irregularities as long as the stability of bonding to the cover layer 2012 is not affected.

### (3.1.2.3) Configuration of Channel

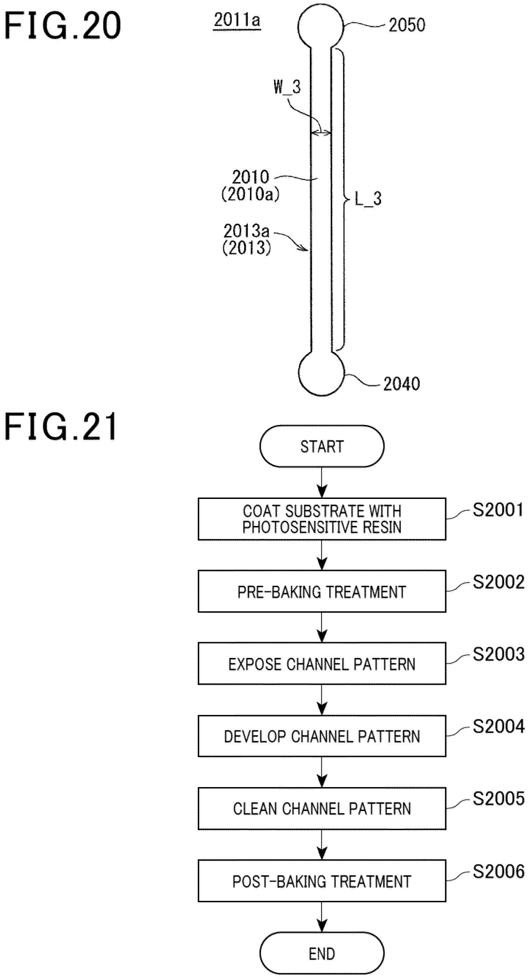

The configuration of each of the channel sections 2013 formed in the microfluidic base member 2100 according to the present embodiment will be described here in detail by using Fig. 20 with reference to Figs. 18A and 18B and Figs. 19A and 19B. Fig. 20 is an enlarged view of the channel section 2013 (channel section 2013a) of the microfluidic base member 2100 illustrated in Fig. 19A.

The dimensions of the channel section 2013 in the microfluidic base member 2100 and the opening area ratio of the barrier layer 2011 that forms the channel sections 2013 will be described below.

As described above, the microfluidic base member has a complicated channel pattern structure and more opening regions tend to occupy the wall section. These increased opening regions reduce the bonding stability of bonding members (e.g., the wall section of the microfluidic base member and the covering member) included in the microfluidic chip to each other in some cases. If the bonding stability reduces, respective members (the substrate and the wall section of the microfluidic base member and the covering member in this example) to be bonded which are included in the microfluidic chip 2001 may suffer defects such as damage, for example, when the covering member and the microfluidic base member (the wall section in particular) are bonded, for example, at the time of fabricating the microfluidic chip 2001.

For example, when the bonding stability reduces because of the increased opening regions in the wall section, the resistance of the wall section to pressure reduces, the wall section suffers damage at the time of bonding the wall section and the covering member, and even the covering member and the substrate further suffer damage in some cases. **In** addition, if members such as the substrate, the wall section, and the covering member suffer damage, liquid leakage occurs in some cases when liquid flows through the microfluidic chip formed by using the respective members. The microfluidic base member (the wall section and the substrate) included in the body of the microfluidic chip is thus requested to have the higher bonding stability of bonding to the covering member. As described below, the microfluidic base member 2100 according to the present embodiment has a configuration in which the dimensions of the channel section 2013 and the opening area ratio of the barrier layer 2011 satisfy the specific conditions. This makes it possible to provide a microfluidic base member that allows a microfluidic chip to be formed in which the resistance of the microfluidic base member (a wall section in particular) to pressure is increased, members (a substrate, the wall section, and a covering member) are prevented from suffering damage due to pressure at the time of fabricating the microfluidic chip, and no liquid leakage occurs when liquid flows.

In the microfluidic base member 2100, the channel sections 2013 are each formed in the barrier layer 2011 as an opening section. As illustrated in each of Figs. 19A and 19B, the substrate 2010 included in the bottom sections of the channel sections 2013 is exposed in the channel sections 2013 each of which is an opening section formed on the front surface 2011a of the barrier layer 2011. It is to be noted that the configuration according to the present disclosure is not limited to this. A configuration may be adopted in which the substrate 2010 is not exposed on the bottom sections of the channel sections 2013 (e.g., a configuration in which the bottom sections of the channel sections 2013 are covered with the barrier layer 2011 or another member). In addition, the channel section 2013 is formed between an input section 2040 and an output section 2050. The input section 2040 is an opening section formed in the barrier layer 2011. The input section 2040 is a component for receiving a fluid introduced through the input section 2004 of the cover layer 2012 in the microfluidic chip 2001 (see Fig. 18A) formed by using the microfluidic base member 2100 and introducing the fluid to the channel section 2013. In addition, the output section 2050 is an opening section formed in the barrier layer 2011. The output section 20050 is a component for receiving a fluid passing through the channel section 2013 in the microfluidic chip 2001 formed by the microfluidic base member 2100 and discharging the fluid to the output section 2005 of the cover layer 2012. Each of the output sections 2050 is not limited to a component (discharge section) for discharging a fluid and may be a component (pharmaceutical fixation section) for bringing the fluid and a drug solution into contact. For example, a drug solution is introduced into the output section 2050 in advance, thereby making it possible to bring a fluid transferred in the channel section 2013 toward the output section 2050 and the drug solution into contact. A component that functions as the discharge section or the drug solution fixation section of a fluid will be generically referred to as the "output section" below.

As illustrated in Fig. 18A, in the microfluidic chip 2001, the input section 2040 of the barrier layer 2011 is provided at the position opposed to the input section 2004 of the cover layer 2012 and the output section 2050 of the barrier layer 2011 is provided at the position opposed to the output section 2005 of the cover layer 2012.

In the microfluidic base member 2100 according to the present embodiment, the channel group including the plurality of channel sections 2013 may be regarded as a component including the input sections 2040 and the output sections 2050, and the channel sections 2013. This allows the channel group to be regarded as a component including even regions that each introduce/discharge a fluid.

The cover layer 2012 is bonded to the barrier layer 2011 of the microfluidic base member 2100 in which the channel sections 2013 are each formed, thereby surrounding the channel section 2013 in the microfluidic chip 2001 with the cover layer 2012, and the substrate 2010 and the barrier layer 2011 of the microfluidic base member 2100 and offering a configuration in which a fluid is transferable without any liquid leakage occurring.

The dimensions of each of the channel sections 2013 formed in the barrier layer 2011 will be described. As illustrated in each of Fig. 19B and 20, a width W_3 of the channel section 2013 is the width between the opposed barrier layers 2011 (specifically, between the side surfaces 2011b) and indicates the width (opening width) between the opening ends of an opening section formed in the barrier layer 2011.

The body of the microfluidic chip 2001, that is, the channel sections 2013 in the microfluidic base member 2100 according to the present embodiment, is formed in the barrier layer 2011 as an opening section having an opening width of 2000 µm (2 mm) or less. Setting the width W_3 of the channel section 2013 to 2000 µm or less makes it possible to prevent pressure applied to the region near the channel section 2013 in the barrier layer 2011 from increasing in comparison with other regions in the barrier layer 2011 when the cover layer 2012 that is a covering member is bonded to the barrier layer 2011 of the microfluidic base member 2100. That is, it is possible to increase the bonding stability of bonding the microfluidic base member 2100 including the barrier layer 2011 and the cover layer 2012.

It is to be noted that the channel sections 2013 may be each configured to increase or decrease in opening width (width W_3) between the input section 2040 and the output section 2050 in the microfluidic base member 2100 according to the present embodiment. It is thus sufficient if the width W_3 of the channel section 2013 in the microfluidic base member 2100 is 2000 µm or less in the region of the greatest opening width (the region of the greatest width between the side surfaces 2011b of the barrier layers 2011).

In addition, it is preferable that the width W_3 of the channel section 2013 defined by the barrier layer 2011 be 5 µm or more because the channel section 2013 has to be greater in width than a substance to be analyzed/tested as with the thickness (the height of the channel section 2013) of the barrier layer 2011 described below. That is, it is preferable that the width W_3 of the channel section 2013 be within a range of 5 µm or more and 2000 µm or less. This makes it possible to increase the bonding stability of bonding the microfluidic base member 2100 (specifically, the barrier layer 2011) and the cover layer 2012 and increase the liquid transferability of a fluid including a substance to be analyzed/tested in the channel section 2013.

In addition, as illustrated in Fig. 20, a channel length L_3 of the channel section 2013 indicates the length of the channel section 2013 formed in the barrier layer 2011 as an opening section. That is, the channel length L_3 indicates the length between the opening ends between the input section 2004 and the output section 2005. That is, the channel length L_3 is the length of a liquid transfer section in which a fluid introduced from the input section 2004 is discharged from the output section 2005. In the present embodiment, it is preferable that the channel length L_3 of the channel section 2013 be within a range of 10 mm or more and 100 mm or less. It is more preferable that the channel length L_3 of the channel section 2013 be within a range of 30 mm or more and 70 mm or more. It is still more preferable that the channel length L_3 of the channel section 2013 be within a range of 40 mm or more and 60 mm or less. Setting the channel length L_3 within a range of 10 mm or more and 100 mm or less makes it possible to secure sufficient reaction time for a reaction solution.

In addition, the height of each of the channel sections 2013 illustrated in Fig. 19B, that is, a thickness T_3 of the barrier layer 2011 on the substrate 2010 of the microfluidic base member 2100, is not limited in particular. The height (the thickness T_3 of the barrier layer 2011) of the channel section 2013, however, has to be greater than a substance (e.g., drugs, bacteria, cells, white blood cells, red blood cells, or the like) to be analyzed/tested included in a fluid introduced to the channel section 2013. It is therefore preferable that the height (the thickness T_3 of the barrier layer 2011) of the channel section 2013 be within a range of 5 µm or more and 500 µm or less. It is to be noted that the thickness of the barrier layer 2011 is not limited to this.

Next, the opening area ratio of the barrier layer 2011 of the microfluidic base member 2100 will be described. An opening area ratio (Ar_3) of the barrier layer 2011 is the ratio (Ar_3 (%) = opening area OA_3/superimposition area SA_3) of the area (opening area OA_3) of the opening regions of the barrier layer 2011 to the area (superimposition area SA_3) of the whole of the region that forms the barrier layer 2011 where the substrate 2010 and the cover layer 2012 overlap in a plan view in the microfluidic chip 2001. That is, the opening area ratio (Ar_3) is the ratio of the opening area OA_3 to the superimposition area SA_3 in a case where the microfluidic base member 2100 is provided with the cover layer 2012 that is a covering member which serves as a cover of the channel section 2013. Here, the state in which the microfluidic base member 2100 is provided with the cover layer 2012 that is a covering member which serves as a cover of the channel section 2013, that is, the state in which the microfluidic base member 2100 is included in the microfluidic chip 2001 and the cover layer 2012 is included in the microfluidic chip 2001, is referred to as a covering member bonded state. The covering member bonded state indicates a state in which the microfluidic base member 2100 is provided with the cover layer 2012 that serves as a cover of the channel section 2013 on the opposite surface (front surface 2011a) of the barrier layer 2011 to the substrate 2010.

It is to be noted that the cover layer 2012 is provided with the input sections 2004 and the output sections 2005 as through holes as illustrated in Fig. 1. The superimposition area SA_3 does not therefore include the area of the regions in which the input sections 2004 and the output sections 2005 overlap with the substrate 2010. In addition, similarly, the opening area OA_3 does not include the input sections 2040 and the output sections 2050 formed in the barrier layer 2011 of the microfluidic base member 2100 at the positions opposed to the input sections 2004 and the output sections 2005 of the cover layer 2012.

For example, in the case of the microfluidic chip 2001 illustrated in each of Figs. 1(a) and 1(b), the cover layer 2012 overlaps with the whole of a front surface 10a of the substrate 2010. That is, in a case where the microfluidic base member 2100 is in the covering member bonded state, the cover layer 2012 overlaps with the whole of the front surface 2010a of the substrate 2010. The superimposition area SA_3 in this example is therefore the value (superimposition area SA_3 = area of front surface 2010a of substrate 2010 - area of input sections 2004 and output sections 2005) obtained by subtracting the area of the input sections 2004 and the output sections 2005 from the area of the upper surface of the substrate 2010.

In addition, in the microfluidic base member 2100 in this example, the plurality of channel sections 2013 (channel group 2130) is formed in the barrier layer 2011. The opening area A2 in this example is therefore the sum of the opening areas (= width W_3 × channel length L_3 of channel sections 2013a to 2013c) of the channel group 2130 (channel sections 2013a to 2013c). Therefore, the opening area ratio Ar_3 of the microfluidic chip 2001 illustrated in each of Figs. 1(a) and 1(b), that is, the opening area ratio Ar_3 in a case where the microfluidic base member 2100 illustrated in each of Figs. 19A and 19B is in the covering member bonded state, is calculated as follows. opening area ratio Ar_3 (%) = (sum of opening areas of channel sections 2013a to 2013c/superimposition area SA_3)

Additionally, it is sufficient if the cover layer 2012 functions as a covering member of the microfluidic chip 2001. It is possible to design the cover layer 2012 in various shapes depending on application. It is sufficient if the cover layer 2012 is designed to cover at least part of the substrate 2010, that is, a barrier channel region 2031 described below, on which the channel sections 2013 are formed in the microfluidic base member 2100. For example, it is possible to design the cover layer 2012 to cover the whole of the substrate 2010 on which the barrier layer 2011 is formed in a plan view.

The opening area ratio Ar_3 of the barrier layer 2011 of the microfluidic base member 2100 according to the present embodiment in the covering member bonded state is 60% or less. That is, the one or more channel sections 2013 are formed in the microfluidic base member 2100 so that the opening area ratio Ar_3 of the barrier layer 2011 in the covering member bonded state is 60% or less. In other words, the opening area ratio Ar_3 of the barrier layer 2011 of the microfluidic chip 2001 is 60% or less. That is, the one or more channel sections 2013 are formed in the microfluidic chip 2001 so that the opening area ratio Ar_3 of the barrier layer 2011 is 60% or less.

In the microfluidic base member 2100 according to the present embodiment, setting the opening area ratio Ar_3 of the barrier layer 2011 in the covering member bonded state to 60% or less makes it possible to prevent an increase in pressure applied to a region near the channel section 2013 in the barrier layer 2011 when the cover layer 2012 that is a covering member of the microfluidic chip 2001 is bonded to the barrier layer 2011 of the microfluidic base member 2100 in comparison with other regions of the barrier layer 2011. That is, the increased resistance of the barrier layer 2011 to pressure makes it possible to increase the bonding stability of bonding the microfluidic base member 2100 including the barrier layer 2011 and the cover layer 2012.

In addition, the microfluidic base member 2100 satisfies the condition that the width W_3 (opening width) of each of the channel sections 2013 is 2000 µm or less as described above in addition to the condition that the opening area ratio Ar_3 of the barrier layer 2011 is 60% or less, thereby making it possible to further increase the bonding stability of the barrier layer 2011 and the cover layer 2012 and prevent the microfluidic base member 2100 (the substrate 2010 and the barrier layer 2011) and the cover layer 2012 from suffering damage.

That is, in the microfluidic base member 2100, the channel sections 2013 are each formed in the barrier layer 2011 as an opening section having an opening width of 2000 µm or less and the barrier layer 2011 has an opening area ratio of 60% or less in the covering member bonded state. This makes it possible to provide a microfluidic chip in which the bonding stability (e.g., the resistance of the barrier layer 2011 to pressure) is increased, members (the substrate 2010, the barrier layer 2011, and the cover layer 2012) are prevented from suffering damage due to pressure at the time of fabricating the microfluidic chip 2001, and no liquid leakage occurs when liquid flows.

It is sufficient if the microfluidic base member 2100 according to the present embodiment satisfies the conditions that the channel sections 2013 formed in the barrier layer 2011 as opening sections each have an opening width of 2000 µm or less and the barrier layer 2011 has an opening area ratio of 60% or less in the covering member bonded state. It is possible to form the one or more channel sections 2013 in the barrier layer 2011.

In addition, in the microfluidic base member 2100, the area of the barrier layer 2011 other than the area of the opening regions in the covering member bonded state, that is, the area (resin area RA_3) of the region of the barrier layer 2011 in which resin remains, is calculated as the difference between the superimposition area SA_3 and the opening area OA_3 (resin area RA_3 = superimposition area SA_3 - opening area OA _3). That is, the resin area RA_3 is calculated as the difference between the superimposition area SA_3 and the opening area OA_3 in the microfluidic base member 2100. The remainder of the ratio of the opening area OA_3 to the superimposition area SA_3 is thus a resin area ratio RAr_3 (%). The resin area ratio RAr_3 is therefore 40% in the microfluidic base member 2100 when the opening area ratio in the covering member bonded state is 60%. That is, to increase the resistance of the barrier layer 2011 to pressure and increase the bonding stability of bonding the barrier layer 2011 and the cover layer 2012, it is sufficient if the resin area ratio RAr_3 of the barrier layer 2011 is 40% or more.

In addition, although described in detail below, thermocompression bonding is favorably used as a method for bonding the barrier layer 2011 of the microfluidic base member 2100 and the cover layer 2012 when the microfluidic chip 2001 is fabricated. In a case where the barrier layer 2011 and the cover layer 2012 are bonded by thermocompression bonding, it is necessary to avoid a defect in the bonding of the cover layer 2012 and the microfluidic base member 2100 (the barrier layer 2011 in particular) caused by the deformation of the barrier layer 2011 due to the thermal expansion coefficient.

Accordingly, in a case where the barrier layer 2011 of the microfluidic base member 2100 and the cover layer 2012 are bonded (joined together) by thermocompression bonding, it is preferable that the opening area ratio Ar_3 of the barrier layer 2011 in the covering member bonded state be within a range of 20% or more and 60% or less. Setting the opening area ratio of the barrier layer 2011 in the covering member bonded state within this range makes it possible to prevent the barrier layer 2011 from being deformed because of the thermal expansion coefficient and prevent a defect from being caused by the deformation in the bonding of the cover layer 2012 and the microfluidic base member 2100 (the barrier layer 2011 in particular) (bonding failure). In other words, in the case of the covering member bonded state, it is preferable that the resin area ratio RAr_3 of the barrier layer 2011 be within a range of 40% or more and 80% or less in the microfluidic base member 2100.

### (3.1.3) Cover Layer

In the microfluidic chip 2001 illustrated in each of Figs. 18A and 18B, the cover layer 2012 is provided on the opposite surface of the barrier layer 2011 to the substrate 2010. As illustrated in Fig. 118B, the cover layer 2012 is a covering member that covers the channel sections 2013. As described above, the cover layer 2012 is provided on the opposite surface (front surface 2011a) of the barrier layer 2011 in the microfluidic base member 2100 to the substrate 2010 and is opposed to the substrate 2010 across the barrier layer 2011. More specifically, as illustrated in Fig. 18B, the cover layer 2012 is supported by the barrier layer 2011 in a cross-sectional view. The cover layer 2012 is opposed to the substrate 2010 in an opening section of the barrier layer 2011 in which the channel section 2013 is formed. The opposed surface of the cover layer 2012 to the substrate 2010 defines the upper section of the channel section 2013. That is, not only the microfluidic base member 2100, but also the cover layer 2012 is one of members that form the channel sections 2013.

It is possible to form the cover layer 2012 by using any of a light-transmissive material or a non-light-transmissive material. For example, in a case where the internal state of each of the channels is detected and observed using light, it is possible to use a material that is excellent in transparency to the light. The light-transmissive material is not limited in particular and it is possible to use resin, glass, or the like. The resin that forms the cover layer 2012 includes an acrylic resin, a methacrylic resin, polypropylene, a polycarbonate resin, a cycloolefin resin, a polystyrene resin, a polyester resin, a urethane resin, a silicone resin, a fluororesin, and the like from the perspective of the suitability for the formation of the body section of the microfluidic chip 2001. The thickness of the cover layer 2012 is not limited in particular, but it is preferable that the thickness of the cover layer 2012 be within a range of 10 µm or more and 10 mm or less in view of the provision of respective through holes corresponding the input sections 2004 and the output sections 2005 in the cover layer 2012. **In** addition, it is desirable that the cover layer 2012 have, in advance, respective holes corresponding to the input sections 2004 from each of which a fluid (liquid) is introduced and the output sections 2005 from each of which the fluid is discharged in the cover layer 2012 before the cover layer 2012 is bonded to the barrier layer 2011.

### (3.1.4) Method for Manufacturing Microfluidic Base Member

Next, a method for manufacturing the microfluidic base member 2100 according to the present embodiment will be described. Fig. 21 is a flowchart illustrating an example of the method for manufacturing the microfluidic base member 2100 according to the present embodiment.

A case where the barrier layer 2011 is formed by using a photosensitive resin will be described here as an example.

### (Step S2001)

In the method for manufacturing the microfluidic base member 2100 according to the present embodiment, a step of coating the substrate 2010 with resin is first performed. A resin layer that forms the barrier layer 2011 is thus provided on the substrate 2010. In the method for manufacturing the microfluidic base member 2100 according to the present embodiment, for example, a resin layer (photosensitive resin layer) including a photosensitive resin is formed on the substrate 2010.

Examples of a method for forming the photosensitive resin layer on the substrate 2010 include coating the substrate 2010 with a photosensitive resin. It is possible to conduct the coating, for example, by spin coating, spray coating, bar coating, or the like. Among these, spin coating is preferable from the perspective of the controllability of the film thickness. It is possible to coat the substrate 2010 with, for example, photosensitive resins having a variety of forms such as a liquid photosensitive resin, a solid photosensitive resin, a gel photosensitive resin, and a film photosensitive resin. Among these, it is preferable to form a photosensitive resin layer by using a liquid resist.

In addition, it is preferable that the substrate 2010 be coated with resin (e.g., photosensitive resin) such that the thickness of the resin layer (e.g., photosensitive resin layer), that is, the thickness of the barrier layer 2011 is within a range of 5 µm or more and 500 µm or less. It is to be noted that the thickness of the barrier layer 2011 is not limited to this.

### (Step S2002)

Once the photosensitive resin is formed on the substrate 2010, a step of conducting heating treatment (pre-baking treatment) is then performed for the purpose of removing a solvent medium (solvent) included in the resin (e.g., photosensitive resin) with which the substrate 2010 is coated. It is to be noted that the pre-baking treatment is not an essential step for the method for manufacturing the microfluidic base member 2100 according to the present embodiment. It is sufficient if the pre-baking treatment is conducted as appropriate at the optimum temperature and time depending on the characteristics of the resin. For example, in a case where the resin layer on the substrate 2010 is a photosensitive resin, the pre-baking temperature and time are adjusted to the optimum conditions as appropriate depending on the characteristics of the photosensitive resin.

### (Step S2003)

Next, a step of exposing the resin (e.g., photosensitive resin) with which the substrate 2010 is coated is performed. Specifically, the photosensitive resin with which the substrate 2010 is coated is exposed to have a channel pattern drawn thereon. For example, an exposure apparatus or a laser lithography apparatus producing ultraviolet light as a light source allows for the exposure. Among these, exposure is preferable in which a proximity exposure or contact exposure apparatus producing ultraviolet light as a light source is used. In the case of a proximity exposure apparatus, exposure is performed through a photomask having a channel pattern arrangement in the microfluidic chip 2001. It is sufficient if a photomask or the like having a two-layer structure of chromium and chromium oxide as a light-shielding film is used as the photomask.

**In** addition, as described above, a photosensitive resin having photosensitivity to light having a wavelength of 190 nm or more and 400 nm or less, which is in the ultraviolet region, is used for the barrier layer 2011. It is thus sufficient if the photosensitive resin with which the substrate 2010 is coated is sensitized to light having a wavelength of 190 nm or more and 400 nm or less in this step (exposure step).

It is to be noted that, in a case where a chemically amplified resist or the like is used to form a resin layer on the substrate 2010, it is favorable to further conduct heating treatment (post-exposure bake: PEB) after exposure to accelerate an acid catalyst reaction caused by the exposure.

### (Step S2004)

Next, a step of developing the exposed photosensitive resin to form a channel pattern is performed.

The development is conducted by reacting a photosensitive resin and a development liquid, for example, in a development apparatus of a spraying type, a dipping type, a puddle type, or the like. It is possible to use, for example, a sodium carbonate aqueous solution, tetramethyl ammonium hydroxide, potassium hydroxide, an organic solvent, or the like for the development liquid. It is sufficient if the optimum development liquid depending on the characteristics of the photosensitive resin is used as appropriate. The development liquid is not limited to them. **In** addition, it is possible to adjust the concentration or the development processing time to the optimum condition as appropriate depending on the characteristics of the photosensitive resin.

### (Step S2005)

Next, a step of cleaning the resin layer (photosensitive resin layer) on the substrate 2010 to completely remove the development liquid used for the development is performed. It is possible to carry out the cleaning, for example, by a cleaning apparatus of a spraying type, a showering type, an immersing type, or the like. It is sufficient if the optimum cleaning water for removing the development liquid used for the development process is used as the cleaning water as appropriate, for example, from pure water, isopropyl alcohol, or the like. After being cleaned, the resin layer is, for example, dried by a spin dryer or an IPA vapor dryer, or naturally dried.

### (Step S2006)

Next, a step of conducting heating treatment (post-bake) on the channel pattern, that is, the barrier layer 2011 that forms the channel sections 2013 is performed. The residual moisture at the time of development or cleaning is removed through this post-baking treatment. The post-baking treatment is conducted by using, for example, a hot plate, an oven, or the like. In the case of insufficient drying in the cleaning step of step S2005 described above, the development liquid or the moisture at the time of cleaning remains in the barrier layer 2011 in some cases. In addition, the solvent that is not removed through the pre-baking treatment also remains in the barrier layer 2011 in some cases. It is possible to remove them by conducting post-baking treatment.

In this way, it is possible to form the barrier layer 2011 included in the channel sections 2013 on the substrate 2010 by using photolithography and fabricate the microfluidic base member 2100 in the method for manufacturing the microfluidic base member 2100 according to the present embodiment.

For example, in a case where the photosensitive resin with which the substrate 2010 is coated is a positive resist, the exposure region is dissolved at the time of development to serve as the channel sections 2013. The photosensitive resin remaining in the non-exposure region serves as the barrier layer 2011. **In** addition, in a case where the photosensitive resin with which the substrate 2010 is coated is a negative resist, the photosensitive resin remaining in the exposure region serves as the barrier layer 2011 and the non-exposure region is dissolved at the time of development to serve as the channel sections 2013.

**In** addition, after the microfluidic base member 2100 is fabricated, that is, after the post-baking treatment in step S2006 described above, a step of bonding the cover layer 2012 to the barrier layer 2011 of the microfluidic base member 2100 is performed to allow the microfluidic chip 2001 to be fabricated. In this step, the cover layer 2012 is bonded to the opposite surface of the barrier layer 2011 to the substrate 2010 as illustrated in Fig. 1(b). This covers the channel sections 2013 with the cover layer 2012 to form the microfluidic chip 2001 illustrated in each of Figs. 1(a) and 1(b). In this step, pressure is applied to narrow the gap between the barrier layer 2011 of the microfluidic base member 2100 and the cover layer 2012 and bond the barrier layer 2011 and the cover layer 2012 with no gap in between. It is to be noted that such an extremely minute gap that causes no liquid leakage when liquid flows through the microfluidic chip 2001 is permitted in the barrier layer 2011 and the cover layer 2012 "bonded with no gap in between".

As a method for bonding the barrier layer 2011 of the microfluidic base member 2100 and the cover layer 2012, a thermocompression bonding method, a method in which an adhesive is used, or a method in which contact surfaces are bonded by conducting surface modification treatment on the bonding surfaces of the barrier layer 2011 and the cover layer 2012 may be carried out.

In the thermocompression bonding method described above, for example, surface modification treatment is conducted on the bonding surfaces of the barrier layer 2011 and the cover layer 2012 and thermocompression bonding is then conducted. It is sufficient as the surface modification treatment if a step of conducting surface modification treatment on the barrier layer 2011 of the microfluidic base member 2100 and the cover layer 2012 (covering member) that has not yet been bonded to the barrier layer 2011 is performed, for example, after the post-baking treatment (after step 6 described above is executed) in a step of manufacturing the microfluidic base member 2100. An example of the surface modification treatment includes, for example, plasma treatment.

In a case where members (the barrier layer 2011 of the microfluidic base member 2100 and the cover layer 2012 in this example) included in the microfluidic chip 2001 are bonded to each other by thermocompression bonding, it is preferable to conduct thermocompression bonding that uses a thermal press machine or a thermal roll machine, for example, after surface modification treatment is conducted. Providing the cover layer 2012 on the barrier layer 2011 by thermocompression bonding without using any adhesive makes it possible to prevent an adhesive component from being eluted into a channel and prevent a reaction of a solution in a channel from being inhibited.

It is desirable that the cover layer 2012 have holes corresponding to the input sections 2004 and the output sections 2005 (see Fig. 18A) of fluids formed therein in advance before the cover layer 2012 is bonded to the barrier layer 2011. This makes it possible to prevent problems with the occurrence of debris and contamination in comparison with a case where holes are made after the barrier layer 2011 is bonded.

It is preferable that the cover layer 2012 be formed to have a thickness which is within a range of 10 µm or more and 10 mm or less in consideration of through holes to be provided. In addition, it is possible to form the cover layer 2012 by using any of a light-transmissive material or a non-light-transmissive material. It is preferable to use resin, glass, or the like as the light-transmissive material. It is to be noted that the thickness and the material of the cover layer 2012 are not limited to the configuration described above in the present invention.

In addition, in a case where the barrier layer 2011 of the microfluidic base member 2100 and the cover layer 2012 are bonded by using an adhesive as a method for bonding the barrier layer 2011 and the cover layer 2012, it is possible to decide the adhesive on the basis of the affinity or the like with the materials included in the barrier layer 2011 and the cover layer 2012. The adhesive is not limited in particular as long as the adhesive allows the barrier layer 2011 and the cover layer 2012 to be bonded. For example, it is possible to use an acrylic resin-based adhesive, a urethane resin-based adhesive, an epoxy resin-based adhesive, or the like as the adhesive in the present embodiment.

In addition, the method for bonding by conducting surface modification treatment includes plasma treatment, corona discharge treatment, excimer laser treatment, and the like. In this case, it is sufficient if the reactivity of the surface of the barrier layer 2011 is increased and the optimum treatment method is selected as appropriate depending on the affinity and the adhesion compatibility between the barrier layer 2011 and the cover layer 2012.

In addition, when the microfluidic chip 2001 is fabricated, a seal is pasted or predetermined information (e.g., the identification number of the microfluidic chip, or the like) is printed in some cases by an ink jet printer in the region of the cover layer 2012 that does not overlap with the channel section 2013 in a plan view, that is, the region of the cover layer 2012 that is not opposed to the channel section 2013. As described above, the microfluidic chip 2001 has increased bonding stability. This also makes it possible to prevent the barrier layer 2011 and the cover layer 2012 from suffering damage due to pressure at the time of pasting a seal to or printing predetermined information on the cover layer 2012 bonded to the barrier layer 2011.

In addition, as described above, in the method for manufacturing the microfluidic chip 2001 according to the present embodiment, pressure is applied to narrow the gap between the barrier layer 2011 and the cover layer 2012 and bond the barrier layer 2011 and the cover layer 2012 with no gap in between in the step (step S8 described above) of bonding the barrier layer 2011 and the cover layer 2012. As described above, in the method for manufacturing the microfluidic chip 2001 according to the present embodiment, the channel section 2013 formed in the barrier layer 2011 has an opening width of 2000 µm or less and the barrier layer 2011 has an opening area ratio of 60% or less. This increases the resistance of the barrier layer 2011 to pressure and increases the bonding stability (the resistance of the wall section to pressure) in the step of bonding a plurality of members (the barrier layer 2011 and the cover layer 2012 in this example) when the microfluidic chip 2001 is fabricated. It is therefore possible to provide a microfluidic chip in which members (the substrate 2010, the barrier layer 2011, and the cover layer 2012) are prevented from suffering damage due to pressure at the time of bonding and no liquid leakage occurs when liquid flows. In addition, the increased bonding stability eliminates the necessity of bonding at low pressure to prevent members from suffering damage due to pressure when the microfluidic chip 2001 is fabricated. It is possible to prevent a defect (bonding failure) such as insufficiently bonding members because of the bonding at low pressure.

As described above, the method for manufacturing the microfluidic base member 2100 according to the present embodiment includes the step (step S2001 described above) of coating the substrate 2010 with resin, the step (step S2003 described above) of exposing the resin used for the coating, the steps (step S2004 described above and step S2005 described above) of developing and cleaning the exposed resin to form the barrier layer 2011 that defines the channel section 2013 on the substrate 2010, and the step (step S2006 described above) of conducing post-baking treatment on the barrier layer 2011. Further, the redundant resin (photosensitive resin layer) on the substrate 2010 is removed in the development step (step S2004 described above) to form an opening section (channel pattern) having an opening width of 2000 µm or less and serving as the channel section 2013 in the barrier layer 2011 and cause the barrier layer 2011 to have an opening area ratio of 60% or less in the covering member bonded state.

This makes it possible to offer the microfluidic base member 2100 that allows the microfluidic chip 2001 to be fabricated in which the bonding stability (e.g., the resistance of the barrier layer 2011 to pressure) is increased, members (the substrate 2010, the barrier layer 2011, and the cover layer 2012) are prevented from suffering damage due to pressure at the time of bonding the microfluidic base member 2100 including the barrier layer 2011 and the cover layer 2012, and no liquid leakage occurs when liquid flows.

In addition, a step of bonding the cover layer 2012 to the opposite surface of the barrier layer 2011 of the microfluidic base member 2100 to the substrate 2010 is performed after the post-baking treatment of step S2006 described above is conducted to fabricate the microfluidic base member 2100. This makes it possible to fabricate the microfluidic chip 2001 as described above. In a case where the barrier layer 2011 and the cover layer 2012 are bonded by thermocompression bonding in the bonding step, that is, the microfluidic chip 2001 enters the covering member bonded state due to thermocompression bonding, it is preferable to form a channel pattern, that is, the channel sections 2013, in the barrier layer 2011 in the development step (step S2004) at the time of forming the barrier layer 2011 such that the opening area ratio Ar_3 is 20% or more and 60% or less.

That is, in a case where the barrier layer 2011 and the cover layer 2012 are bonded by thermocompression bonding to produce the covering member bonded state, it is preferable to set the opening area ratio Ar_3 of the barrier layer 2011 to 20% or more and 60% or less in the covering member bonded state in the development step described above in the method for manufacturing the microfluidic base member 2100 according to the present embodiment. This prevents the resistance of the microfluidic base member 2100 including the barrier layer 2011 to pressure from reducing and prevents the barrier layer 2011 and the cover layer 2012 from being deformed because of the thermal expansion coefficients at the time of heating, prevents the bonding of the cover layer 2012 and the microfluidic base member 2100 (the barrier layer 2011 in particular) from receiving a defect (bonding failure) because of the deformation, and increases the bonding stability. In addition, it is possible to fabricate the microfluidic base member 2100 that allows the microfluidic chip 2001 to be formed in which members (the substrate 2010 and the barrier layer 2011) of the microfluidic base member 2100 and the cover layer 2012 are prevented from suffering damage and warpage due to pressure and heating at the time of bonding the barrier layer 2011 and the cover layer 2012 and no liquid leakage occurs when liquid flows.

### (3.1.5) Modification Examples

### (3.1.5.1) First Modification Example

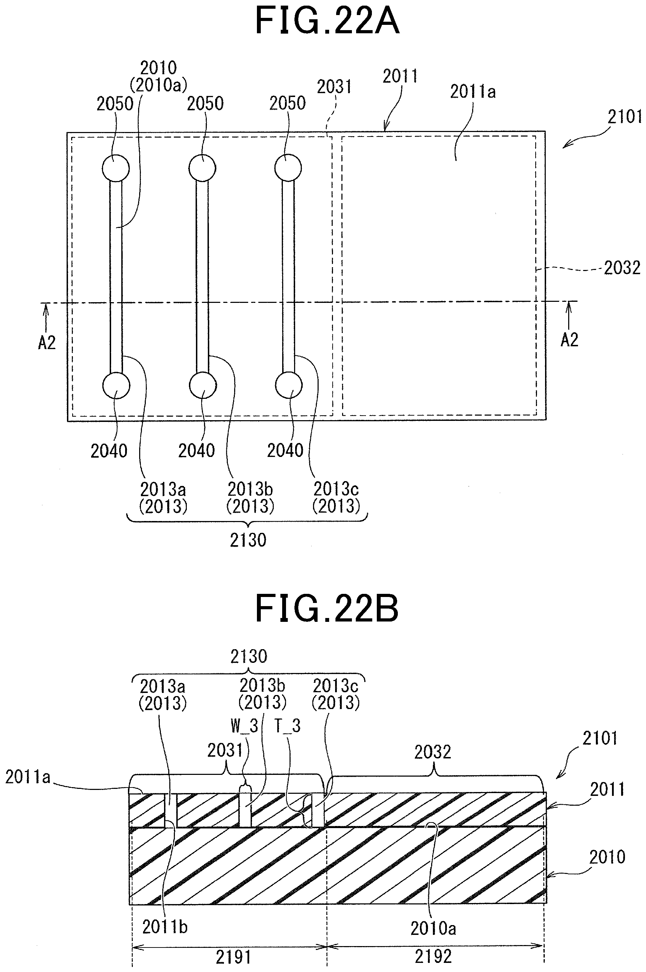

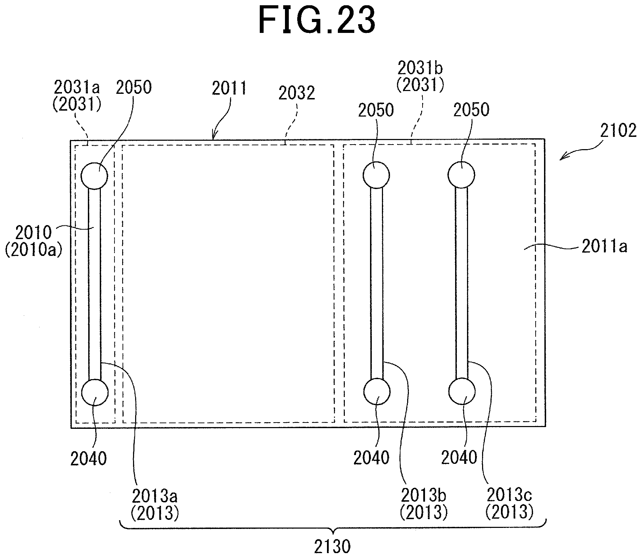

A microfluidic base member according to a first modification example of the present embodiment will be described below by using Figs. 22A, 22B, and 23. First, a configuration example of the first modification example will be described by using Figs. 22A and 22B. Fig. 22A is an outline plan view for describing a configuration example of a microfluidic base member 2101 according to the modification example of the present embodiment. Fig. 22B is an outline cross-sectional view of a cross section of the microfluidic base member 2101 taken along a line A2-A2 illustrated in Fig. 22A.

As with the microfluidic base member 2100, the microfluidic base member 2101 includes the substrate 2010 and the barrier layer 2011 that forms the channel group 2130 including the plurality of channel sections 2013 (channel sections 2013a to 2013c) on the substrate 2010.

As illustrated in Fig. 22A, the microfluidic base member 2101 is different from the microfluidic base member 2100 in that the barrier channel region 2031 and a support region 2032 are formed in the barrier layer 2011.

The barrier channel region 2031 in the barrier layer 2011 is a region in which the channel section 2013 is formed. It is sufficient if the at least one channel section 2013 is formed in the barrier channel region 2031. In this example, the barrier channel region 2031 is provided with the three channel sections 2013a, 2013b, and 2013c. In contrast, the support region 2032 in the barrier layer 2011 is a region in which the channel section 2013 is not provided.

In addition, as illustrated in Fig. 22B, the microfluidic base member 2101 is different from the microfluidic base member 2100 in that a substrate channel region 2191 and a substrate non-channel region 2192 are formed on the substrate 2010.

The substrate channel region 2191 on the substrate 2010 is a region in which the one or more channel sections 2013 are formed by the barrier layer 2011 on the front surface 10a closer to the barrier layer 2011. That is, the substrate channel region 2191 is a region in which the barrier channel region 2031 of the barrier layer 2011 is provided on the substrate 2010. Meanwhile, the substrate non-channel region 2192 on the substrate 2010 is a region in which the channel sections 2013 are not formed by the barrier layer 2011 on the front surface 2010a closer to the barrier layer 2011. That is, the substrate non-channel region 2192 is a region in which the support region 2032 of the barrier layer 2011 is provided on the substrate 2010. In this way, in the microfluidic base member 2101, the substrate 2010 includes the substrate channel region 2191 in which one or more channel sections are formed by the barrier layer 2011 on the front surface 2010a closer to the barrier layer 2011 and the substrate non-channel region 2192 in which the channel section 2013 is not formed.

The channel section 2013 is not formed in the support region 2032 in the barrier layer 2011, leaving more resin than in the barrier channel region 2031. That is, more resin remains on the substrate non-channel region 2192 on the substrate 2010 than on the substrate channel region 2191. This makes it possible to use the support region 2032 of the barrier layer 2011 as a support member, that is, a covering member support section, that supports the cover layer 2012 in the covering member bonded state in which the barrier layer 2011 of the microfluidic base member 2101 is provided with the cover layer 2012 that is a covering member. That is, the support region 2032 of the barrier layer 2011 functions as a covering member support section for a microfluidic chip including the microfluidic base member 2101.

In this way, in the microfluidic base member 2101, the barrier layer 2011 forms, on the substrate non-channel region 2192 of the substrate 2010, the support region 2032 that is a covering member support section which supports the cover layer 2012 serving as a covering member of the channel section 2013 in the covering member bonded state.

That is, the barrier channel region 2031 and the support region 2032 that functions as a covering member support section are formed in the barrier layer 2011 in the microfluidic chip including the microfluidic base member 2101, thereby further increasing the bonding stability of the barrier layer 2011 and the cover layer 2012. This makes it possible to provide a microfluidic base member that reliably allows a microfluidic chip to be formed in which members are further prevented from suffering damage due to pressure at the time of bonding the barrier layer 2011 and the cover layer 2012, such that no liquid leakage occurs.

In addition, the barrier layer 2011 includes the support region 2032 and the rigidity of the microfluidic base member 2101 itself thus increases. It is also possible to prevent members from suffering damage due to pressure applied at the time of storage or use.

It is to be noted that the barrier layer 2011 of the microfluidic base member 2101 is equal in thickness between the barrier channel region 2031 and the support region 2032 in the barrier layer 2011 to increase the bonding stability of bonding to the cover layer 2012 when a microfluidic chip is fabricated. Specifically, the microfluidic base member 2101 is provided with the barrier layer 2011 on the substrate channel region 2191 and the substrate non-channel region 2192 and the barrier layer 2011 does not vary in thickness between the substrate channel region 2191 and the substrate non-channel region 2192. This allows the microfluidic base member 2101 to increase the bonding stability of bonding to the cover layer 2012 at the time of fabricating a microfluidic chip.

In addition, it is possible to impart a function obtained by using the remaining resin material to part of the support region 2032 in which the channel section 2013 is not provided. It is possible to imprint characters indicating predetermined information (e.g., an identification number, a product name, or the like), for example, by printing the characters with an ink jet printer or performing a punching process on part of the resin. This causes the support region 2032 to function as an information display section. The above is not limiting, and it is possible to use the support region 2032 in the barrier layer 2011 for various purposes depending on the application of the microfluidic chip fabricated by using the microfluidic base member 2101, or the like. It is possible to impart various functions.

In each of Figs. 22A and 22B, the barrier channel region 2031 is disposed in the left region of the barrier layer 2011 and the support region 2032 is disposed in the right region of the barrier layer 2011 in a plan view as an example. It is to be noted that the present disclosure is not limited to this. In the barrier layer 2011, the barrier channel region 2031 may be disposed in the right region and the support region 2032 may be disposed in the left region.

Next, another configuration example of the first modification example will be described by using Fig. 23. Fig. 23 is an outline plan view for describing a configuration example of a microfluidic base member 2102 according to the modification example of the present embodiment.

In a case where the plurality of channel sections 2013 is formed in the barrier layer 2011 as in the microfluidic base member 2102 illustrated in Fig. 23, the plurality of barrier channel regions 2031 may be formed. In this case, the support region 2032 may be disposed between the plurality of barrier channel regions 2031. Although not illustrated, the plurality of barrier channel regions 2031 is formed in the barrier layer 2011 in a microfluidic base member 21102. A plurality of substrate channel regions is therefore formed on the substrate 2010. In addition, a substrate non-channel region is disposed between the plurality of channel regions on the substrate 2010.

In Fig. 23, the barrier channel region 2031 is divided into two regions (barrier channel regions 2031a and 2031b) and the support region 2032 is provided between the barrier channel regions 2031a and 2031b. In this example, the channel section 2013a that is one of the plurality of channel sections 2013 is provided in the barrier channel region 2031a and the rest (channel sections 2013b and 2013c) of the channel sections 2013 are provided in the barrier channel region 2031b. In a case where the plurality of channel sections 2013 and the plurality of barrier channel regions 2031 are formed in the barrier layer 2011, it is sufficient if the at least one channel section 2013 of the plurality of channel sections 2013 is formed in each of the barrier channel regions 2031 (the barrier channel regions 2031a and 2031b in this example).

It is to be noted that each of Figs. 22A, 22B, and 23 is a configuration example of a microfluidic chip provided with the barrier channel region 2031 and the support region 2032 in the barrier layer 2011 and Figs. 22A, 22B, and 23 are not limited to the microfluidic base members 2101 and 2102 according to the present modification example. It is possible to adopt various aspects depending on application. For example, the microfluidic base member may be provided with the plurality of support regions 2032 in the barrier layer 2011.

In this way, the barrier layer 2011 of a microfluidic base member (any of microfluidic base members 2101 and 2102) may include the barrier channel region 2031 in which the at least one channel is formed and the support region 2032 in which no channel is formed. This makes it possible to reliably provide a microfluidic base member that allows a microfluidic chip to be formed in which the bonding stability of the barrier layer 2011 and the cover layer 2012 serving as a covering member further increases when the microfluidic chip is fabricated by using the microfluidic base member, members (the substrate 2010, the barrier layer 2011, and the cover layer 2012) are further prevented from suffering damage due to pressure at the time of bonding the microfluidic base member (the barrier layer 2011 in particular) and the cover layer 2012, and no liquid leakage occurs.

### (3.1.5.2) Second Modification Example

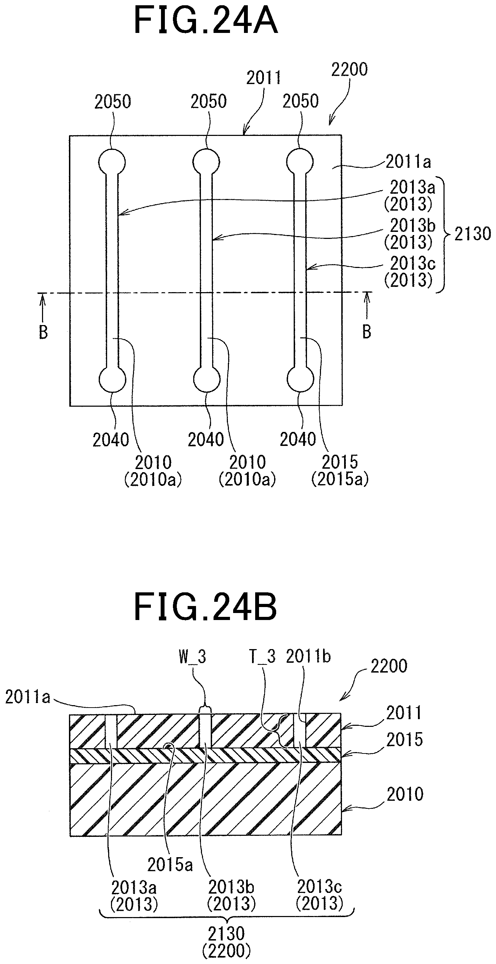

A microfluidic base member 2200 according to a second modification example of the present embodiment will be described below by using Figs. 24A and 24B. Fig. 24A is an outline plan view describing a configuration example of the microfluidic base member 2200 according to the present modification example. Fig. 24B is a cross-sectional view for describing the configuration example of the microfluidic base member 2200 according to the present modification example. Fig. 24B is an outline cross-sectional view of a cross section of the microfluidic base member 2200 taken along a line B-B illustrated in Fig. 24A.

As illustrated in each of Figs. 24A and 24B, the microfluidic base member 2200 includes the substrate 2010, an adhesive layer 2015 disposed on the substrate 2010, and the barrier layer 2011 that forms the channel group 2130 including the plurality of channel sections 2013a to 2013c above the substrate 2010. Specifically, the microfluidic base member 2200 includes the adhesive layer 2015 between the barrier layer 2011 and the substrate 2010. The microfluidic base member 2200 is different from the microfluidic base member 2100 according to the 3-1-th embodiment described above in that the microfluidic base member 2200 includes the adhesive layer 2015.

### (3.1.5.2.1) Configuration of Adhesive Layer

The adhesive layer 2015 will be described below. It is to be noted that the respective components (the substrate 2010, the barrier layer 2011, and the channel sections 2013) other than the adhesive layer 2015 are similar to those of the microfluidic base member 2100, and will be thus denoted by the same reference signs and the description thereof will be omitted.

The substrate 2010 of the microfluidic base member 2200 may be subjected to hydrophobization surface treatment (HMDS treatment) or coated with a thin film of resin for the purpose of increasing the adhesion between the substrate 2010 and the resin layer (e.g., photosensitive resin layer), that is, the barrier layer 2011. In particular, for example, in a case where glass is used for the substrate 2010, the thin adhesive layer 2015 may be provided between the substrate 2010 and the barrier layer 2011 (photosensitive resin layer) as illustrated in Fig. 24B. In this case, a fluid (e.g., liquid) flowing in each of the channel sections 2013 comes into contact with the adhesive layer 2015 instead of the substrate 2010. It is therefore sufficient if the adhesive layer 2015 has resistance to the fluid introduced to the channel section 2013. Providing the adhesive layer 2015 on the substrate 2010 also makes it possible to contribute to an increase in the resolution of a channel pattern by the photosensitive resin, or the like.

As described above, the adhesive layer 2015 is formed on the substrate 2010. Therefore, as illustrated in each of Figs. 24A and 24B, in the microfluidic base member 2200 according to the present modification example, the bottom section of each of the channel sections 2013 is formed by the adhesive layer 2015. The adhesive layer 2015 (specifically, a front surface 2015a of the adhesive layer 2015) included in the bottom section of the channel section 2013 is exposed in the channel section 2013.

### (3.2) 3-2-th Embodiment

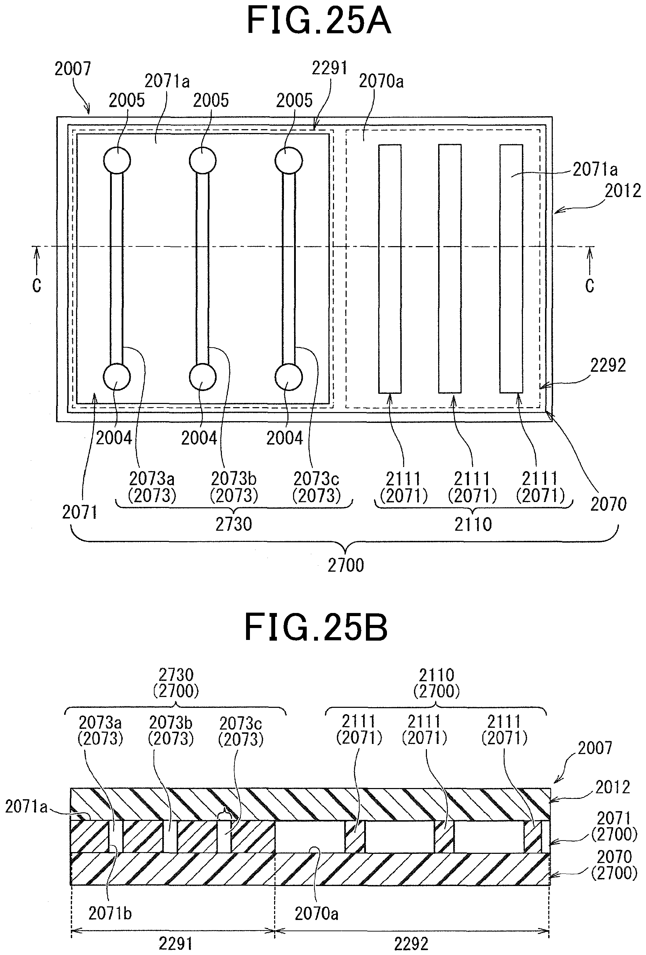

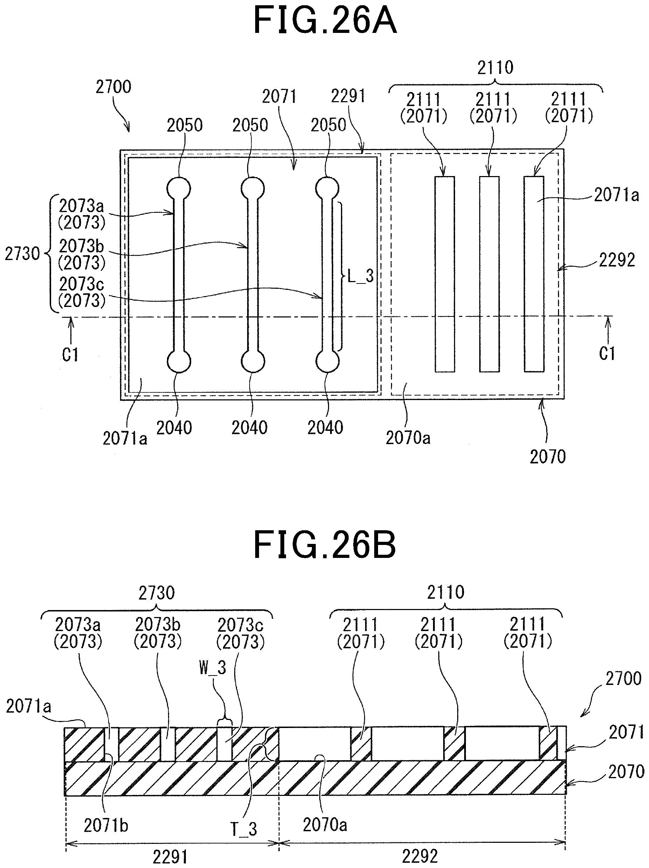

The configurations of a microfluidic chip 2007 according to the 3-2-th embodiment (referred to as "the present embodiment" below) of the present disclosure and a microfluidic base member 2700 used for the microfluidic chip 2007 will be described below with reference to Figs. 25A and 25B and Figs. 26A and 26B.

### (3.2.1) Basic Configuration of Microfluidic Chip

Each of Figs. 25A and 25B is an outline diagram for describing a configuration example of the microfluidic chip 2007 according to the present embodiment. Specifically, Fig. 25A is an outline plan view of the microfluidic chip 2007 according to the present embodiment. In addition, Fig. 25B is an outline cross-sectional view of a cross section of the microfluidic chip 2007 taken along a line C-C illustrated in Fig. 25A.

As illustrated in each of Figs. 25A and 25B, the microfluidic chip 2007 includes the microfluidic base member 2700 and the cover layer 2012. Although described in detail below, the microfluidic base member 2700 is different from the microfluidic base member 2100 according to the 3-1-th embodiment described above in that the microfluidic base member 2700 includes covering member support sections 2111. That is, the microfluidic chip 2007 is different from the microfluidic chip 2001 in that the microfluidic chip 2007 includes the microfluidic base member 2700 including the covering member support sections 2111.

In the microfluidic chip 2007, the components (cover layer 2012) other than the microfluidic base member 2700 are similar to the components of the microfluidic chip 2001, and will be thus denoted by the same reference signs and the description thereof will be omitted.

Here, the relationship between members (the substrate, the barrier layer, and the cover layer) included in each of channel sections 2073 (channel sections 2073a to 2073c) in the microfluidic chip 2007 is similar to that of the microfluidic chip 2001 according to the 3-1-th embodiment described above except that the covering member support sections 2111 are provided.

Specifically, the microfluidic chip 2007 includes a substrate (substrate 2070) in the microfluidic base member 2700, the channel sections 2073 provided on the substrate 2070, the cover layer 2012 serving as a cover of the channel sections 2073, and a barrier layer 2071 that is disposed between the cover layer 2012 and the substrate 2070 and forms the channel sections 2073 and the covering member support sections 2111 on the substrate 2070. More specifically, the microfluidic chip 2007 includes the substrate 2070, the barrier layer 2071 that is provided on the substrate 2070 and forms a channel, and the cover layer 2012 that is bonded to the opposite surface of the barrier layer 2071 to the substrate 2070 and covers the channel sections 2073. Although described in detail below, the barrier layer 2071 and the cover layer 2012 are bonded by thermocompression bonding in this example. In addition, it is sufficient if the one or more channel sections 2073 are provided in the microfluidic chip 2007. The plurality of channel sections 2073 may be provided. The channel sections 2073 may be designed to allow fluids introduced from the input sections 2004 to merge or be separated.

### (3.2.2) Configuration of Microfluidic Base Member

Next, the respective members of the microfluidic base member will be described by using Figs. 26A and 26B with reference to Figs. 25A and 25B.

Each of Figs. 26A and 26B is an outline diagram for describing a configuration example of the microfluidic base member 2700 according to the present embodiment. Specifically, Fig. 26A is an outline plan view of the microfluidic base member 2700 according to the present embodiment. In addition, Fig. 26B is an outline cross-sectional view of a cross section of the microfluidic base member 2700 taken along a line C1-C1 illustrated in 26A.

It is to be noted that the description of the components common to those of the microfluidic base member 2100 according to the 3-1-th embodiment described above will be omitted as appropriate.

As illustrated in each of Figs. 26A and 26B, the microfluidic base member 2700 includes the substrate 2070 and the barrier layer 2071 that includes a resin material and is provided on the substrate 2070 to form channels on the substrate 2070. The respective members included in the microfluidic base member 2700 will be described in detail below.

### (3.2.2.1) Substrate

The substrate 2070 is a member serving as the base of the microfluidic base member 2700, that is, the base of the microfluidic chip 2007. The barrier layer 2071 provided on the substrate 2070 is included in the channel sections 2073. That is, the substrate 2070 and the barrier layer 2071 can be regarded as the body section of the microfluidic chip 2007.

In addition, as illustrated in each of Figs. 26A and 26B, the substrate 2070 includes a substrate channel region 2291 in which the channel sections 2073 are provided and a substrate non-channel region 2292 in which the channel sections 2073 are not provided on the surface (front surface 2070a) opposed to the cover layer 2012 in the covering member bonded state. That is, in the substrate 2010, the channel sections 2073 are formed on the substrate channel region 2291 and the covering member support sections 2111 that each support the cover layer 2012 in the covering member bonded state are formed on the substrate non-channel region 2292 by the barrier layer 2011. That is, the substrate 2070 includes the substrate channel region 2191 in which one or more channel sections 2073 are formed by the barrier layer 2071 on the front surface 2070a closer to the barrier layer 2011 and the substrate non-channel region 2292 in which the channel section 2073 is not formed. In addition, in the substrate non-channel region 2292, the front surface 2070a of the substrate 2070 is exposed at a portion at which the covering member support sections 2111 are not formed. That is, the barrier layer 2071 is not provided at a portion on the substrate non-channel region 2292 other than the covering member support sections 2111.

It is possible to form the substrate 2070 by using any of a light-transmissive material or a non-light-transmissive material as with the substrate 2010 of the microfluidic base member 2100 according to the 3-1-th embodiment described above. For example, in a case where the internal state (the state of a fluid) of each of the channel sections 2073 is detected and observed by using light, it is possible to use a material that is excellent in transparency to the light. This allows the inner state of the channel section 2073 to be observed, for example, from the substrate 2070 side. The light-transmissive material includes a material that is similar to the light-transmissive material used for the substrate 2010.

In addition, for example, in a case where it is unnecessary to detect or observe the internal (the state of a fluid) state of each of the channel sections 2073 by using light, a non-light-transmissive material may be used. The non-light-transmissive material includes a silicon wafer, a copper plate, and the like as with the substrate 2010. The thickness of the substrate 2070 is not limited in particular, but a certain level of rigidity is necessary in a channel formation step and it is thus preferable that the thickness of the substrate 2070 be within a range of 10 µm (0.01 mm) or more and 10 mm or less as with the substrate 2010.

### (3.2.2.2) Barrier Layer

The barrier layer 2071 is a component that is provided on the substrate 2070 and forms the channel sections 2073. Specifically, the channel section 2073 is defined by opposed side surfaces 71b of the barrier layers 2071. As illustrated in Fig. 26B, in the present embodiment, the barrier layer 2071 forms a channel group 2730 including the plurality of channel sections 2073 (channel sections 2073a, 2073b, and 2073c) on the substrate 2070. The microfluidic chip 2007 includes the microfluidic base member 2700 including the plurality of channel sections 2073, thereby making it possible, for example, to carry out a plurality of tests at the same time or carry out tests in which different types of fluids are used. It is possible to use the microfluidic chip more widely. The plurality of respective channel sections 2073 may be independent or some of the plurality of channel sections 2073 may cross each other.

It is possible to form the barrier layer 2071 by using a resin material. It is possible to use, for example, a photosensitive resin as the resin material of the barrier layer 2071.

It is desirable that the photosensitive resin that forms the barrier layer 2011 have photosensitivity to light having a wavelength of 190 nm or more and 400 nm or less which is in the ultraviolet region as with the barrier layer 2011 of the microfluidic base member 2100 according to the 3-1-th embodiment described above. It is possible to use a photoresist such as a liquid resist or a dry film resist as the photosensitive resin as with the barrier layer 2011. These photosensitive resins may be either positive photosensitive resins in which the photosensitive regions are dissolved or negative photosensitive resins in which the photosensitive regions are insoluble. The photosensitive resin composition suitable to form the barrier layer 2071 in the microfluidic base member 2700 includes a radical negative photosensitive resin similar to that of the barrier layer 2011. It is possible to use, for example, a photosensitive resin material similar to that of the barrier layer 2011 as the photosensitive resin material.

It is to be noted that the resin material of the barrier layer 2071 is not limited to the photosensitive resin in the present embodiment. For example, silicone rubber (PDMS: polydimethylsiloxane) or synthetic resin may be used as with the barrier layer 2011. It is possible to use a material similar to that of the barrier layer 2011 as the synthetic resin. It is desirable to select the resin material of the barrier layer 2071 as appropriate depending on the application.

### (3.2.2.2.1) Covering Member Support Section

Next, a covering member support section formed on the substrate 2070 by the barrier layer 2071 will be described.

The barrier layer 2071 forms the channel section 2073 on the substrate channel region 2291 of the substrate 2070 and forms a covering member support section (e.g., covering member support section 2111) on the substrate non-channel region 2292. The covering member support section is formed as a resin structure including part of the barrier layer 2011. That is, in the present embodiment, the microfluidic base member 2700 is also provided with the part of the barrier layer 2071 (covering member support section 2111) on the substrate non-channel region 2292 in addition to the substrate channel region 2291. The barrier layer 2071 is thus provided in the substrate channel region 2291 and the substrate non-channel region 2292 in the microfluidic base member 2700. This makes it possible to obtain a microfluidic base member in which it is possible to reliably secure the covering member bonded state, that is, the contact area between the barrier layer 2071 and the cover layer 2012 in the microfluidic chip 2007, increase resistance to pressure by dispersing pressing force at the time of bonding the microfluidic base member 2700 (the barrier layer 2071 in particular) and the cover layer 2012 (preventing pressing force from concentrating), and prevent release defects after the bonding. In addition, the barrier layer 2071 forms the covering member support section 2111, thereby making it possible to increase the rigidity of the microfluidic base member 2700 itself and also prevent members from suffering damage or warpage due to pressure applied at the time of storage or use.

The shape of a covering member support section and the number of covering member support sections are not limited in the microfluidic base member 2700. It is, however, preferable to form one or more resin structures each including part of the barrier layer 2071 on the substrate non-channel region 2292 as covering member support sections from the perspective of the increased contact area between the barrier layer 2071 and the cover layer 2012 in the covering member bonded state. That is, it is preferable that one or more resin structures be formed on the substrate non-channel region 2292 in the microfluidic base member 2700 as covering member support sections. This makes it possible to secure the contact area between the microfluidic base member 2700 (the barrier layer 2071 in particular) and the cover layer 2012 more reliably and further increase resistance to pressure at the time of bonding the barrier layer 2071 and the cover layer 2012.

As illustrated in each of Figs. 26A and 26B, the three covering member support sections 2111 are formed on the substrate 2070 (specifically, on the substrate non-channel region 2292) in this example.

In addition, in the microfluidic base member 2700, the thickness T_3 of the barrier layer 2071 is equal to the thickness T_3 of the barrier layer 2011 described above and the thickness T_3 of the barrier layer 2071 does not vary on the substrate 2070. That is, the barrier layer 2071 does not vary in thickness between the substrate channel region 2291 and the substrate non-channel region 2292. Therefore, the barrier layer 2071 that forms the channel sections 2073 in the substrate channel region 2291 and the barrier layer 2071 that forms the covering member support sections 2111 have the equal thickness T_3. The barrier layer 2071 in the covering member bonded state is thus stably bonded to the cover layer 2012 on the opposite surface (front surface 2071a) to the substrate 2070.

In addition, as illustrated in Fig. 26B, the barrier layer 2071 in the covering member bonded state is bonded to the cover layer 2012 on any of the substrate channel region 2291 and the substrate non-channel region 2292 on the opposite surface (front surface 2071a) to the substrate 2070. That is, the covering member support sections 2111 on the substrate non-channel region 2292 are also bonded to the cover layer 2012 on the opposite surfaces (front surfaces 2071a) to the substrate 2070. In the present embodiment, the covering member support sections 2111 are each in surface contact with the cover layer 2012 on the opposite surface (front surface 2071a) to the substrate 2070, that is, the surface closer to the cover layer 2012, in the covering member bonded state. This bonds the barrier layer 2071 including the covering member support sections 2111 to the cover layer 2012 more stably on the opposite surface (front surface 2071a) to the substrate 2070 in the case of the covering member bonded state.

In addition, in the present embodiment, the front surface 2071a of the barrier layer 2071 including the covering member support sections 2111 is flat. This bonds the barrier layer 2071 to the cover layer 2012 more stably in the covering member bonded state. It is to be noted that the front surface 2071a of the barrier layer 2071 may be provided with minute irregularities as long as the stability of bonding to the cover layer 2012 is not affected.

The shape of each of the covering member support sections 2111 is not limited in particular in the present embodiment and it is possible to adopt various shapes. As illustrated in Fig. 26A, in this example, each of the covering member support sections 2111 is a resin structure having a rectangular shape in a plan view. Here, the plan view is a view from the direction orthogonal to the front surface 2071a of the barrier layer 2071. That is, the shape of the covering member support section 2111 in a plan view is the shape of the front surface 2071a.

More specifically, in this example, the plurality of (three) covering member support sections 2111 is disposed on the substrate non-channel region 2292 to be parallel with the long sides of the rectangles, which are the planar shapes of the resin structures. That is, the plurality of covering member support sections 2111 forms a striped (linear) pattern 2110 on the substrate non-channel region 2292 of the substrate 2070. In addition, in this example, the plurality of covering member support sections 2111 is disposed such that the long sides of the rectangles, which are the planar shapes, and the channel sections 2073 are parallel with each other.

It is to be noted that the present disclosure is not limited to this. It is sufficient if the two or more covering member support sections 2111 are disposed on the substrate non-channel region 2292 as the plurality of covering member support sections 2111 which forms the striped pattern 2110. In addition, the covering member support sections 2111 may be disposed such that the long sides of the rectangles, which are the planar shapes, are parallel with a virtual straight line orthogonal to the channel sections 2073 or may be disposed such that the long sides of the rectangles, which are the planar shapes, are parallel with a diagonal line of the substrate non-channel region 2292 having a rectangular shape in a plan view. In addition, the arrangement of the covering member support sections 2111 each having a rectangular shape in a plan view is not limited to the striped pattern 2110. For example, the covering member support sections 2111 may be disposed along the four sides of the substrate non-channel region 2292 having a rectangular shape in a plan view to surround the inner periphery of the substrate non-channel region 2292.

In a case where the plurality of covering member support sections 2111 forms the striped pattern 2110, it is preferable that the long sides of the covering member support sections 2111 on the front surface 2071a each have a length equal to or more than the length (the channel length L_3) of each of the channel sections 2073. This makes it possible to compensate in the covering member bonded state for the contact area between the barrier layer 2071 and the cover layer 2012 decreased by the channel sections 2073 each of which is an opening section and increase the bonding stability of bonding to the cover layer 2012.

It is to be noted that the planar shape of each of the covering member support sections 2111 included in the striped pattern 2110 is not limited to a rectangle and may be a rounded-corner shape or an elliptical shape. In addition, each side of the planar shape of the covering member support section 2111 is not limited to a straight line and may include a wavy or serrated portion.

It is to be noted that Figs. 25A and 25B and Figs. 26A and 26B each exemplify a configuration in which a plurality of covering member support sections (the covering member support sections 2111 in this example) is formed, but the present disclosure is not limited to this. First, the pattern of covering member support sections is not limited to the striped pattern 2110 and it is possible to form the pattern of covering member support sections as various patterns. In addition, as described above, one covering member support section may be formed on the substrate 2070 (specifically, on the substrate non-channel region 2292) in the microfluidic base member 2700. In a case where one covering member support section is formed, it is preferable that the area of the front surface 2071a of the covering member support section be larger than the area of the front surface 2071a of one covering member support section in a case where a plurality of covering member support sections is formed. That is, in a case where one covering member support section is formed, it is preferable that the area of the front surface 2071a of the covering member support section be larger than the area of the front surface 2011a of one covering member support section of a plurality of covering member support sections (e.g., the three covering member support sections 2111).

In addition, in a case where one covering member support section is formed, it is preferable that the area of the front surface 2011a of the one covering member support section be equal to or more than the total area (the sum of areas) of the front surfaces 2071a of a plurality of covering member support sections. For example, in a case where one covering member support section is formed, it is sufficient if the area of the front surface 2071a of the one covering member support section is equal to or more than the sum (the total area of the three covering member support sections 2111) of the areas of the front surfaces 2071a of the three covering member support sections 2111. This makes it possible to secure the contact area between the microfluidic base member 2700 (barrier layer 2071) and the cover layer 2012 and increase the bonding stability in the covering member bonded state even in a case where one covering member support section is formed as in a case where a plurality of covering member support sections is formed (e.g., in a case where the striped pattern 2110 is formed).

It is to be noted that, in a case where one covering member support section is formed, the shape (the shape of the front surface 2071a) of the covering member support section in a plan view is not limited in particular and may be a polygonal shape, a circular shape, or a letter or character shape.

### (3.2.2.3) Configuration of Opening Region of Barrier Layer

A configuration regarding an opening region of the barrier layer 2071 on the substrate 2070 of the microfluidic base member 2700 included in the microfluidic chip 2007 according to the present embodiment will be described here in detail by using Figs. 26Aand 26B with reference to Figs. 25A and 25B.

The dimensions of the channel section 2073 in the microfluidic base member 2700 and the opening area ratio of the barrier layer 2071 that forms the channel sections 2073 will be described below.

As described above, the microfluidic base member has a complicated channel pattern structure and the wall section tends to include more opening regions. This reduces the bonding stability of bonding members (e.g., the wall section of the microfluidic base member and the covering member) included in the microfluidic chip to each other in some cases. If the bonding stability reduces, respective members (the substrate and the wall section of the microfluidic base member and the covering member in this example) which are included in the microfluidic chip 2007 may suffer defects such as damage or warpage, for example, when the covering member and the microfluidic base member (the wall section in particular) are bonded, for example, at the time of fabricating the microfluidic chip 2007.

For example, when the bonding stability reduces because of the increased opening regions in the wall section, the resistance of the wall section to pressure reduces, the wall section suffers damage at the time of bonding the wall section and the covering member, and even the covering member and the substrate further suffer damage in some cases. Meanwhile, in a case where opening regions are excessively decreased in the wall section of the microfluidic base member and the contact area between the wall section and the covering member is excessively increased, deformation caused by the expansion and the subsequent contraction of members due to heating at the time of bonding in a thermocompression bonding method may cause the members to suffer damage. In particular, in the case of a microfluidic chip in which the wall section and the covering member include different types of materials, the respective materials have different thermal expansion coefficients. The members thus easily suffer damage and warpage because of the difference between expansion and subsequent contraction due to heating at the time of thermocompression bonding.

In addition, if members such as the substrate, the wall section, and the covering member suffer damage, liquid leakage occurs in some cases when liquid flows through the microfluidic chip formed by using the respective members. Thus, in a case where members are bonded to each other by thermocompression bonding in the microfluidic base member (the wall section and the substrate) included in the body of the microfluidic chip, it is necessary to prevent resistance against pressure from reducing and prevent members (the substrate, the wall section, and the covering member) from being deformed because of heating when the wall section and the covering member are bonded, and increase the bonding stability.

As described below, the microfluidic base member 2700 according to the present embodiment has a configuration in which the dimensions of the channel section 2073 that is an opening section in the barrier layer 2071 and the opening area ratio of the barrier layer 2071 satisfy the specific conditions. Further, as described above, the microfluidic base member 2700 includes the covering member support sections 2111 formed by the barrier layer 2071. This makes it possible to provide a microfluidic base member that allows a microfluidic chip to be formed in which the resistance of the microfluidic base member (a wall section in particular) to pressure is increased, members (a substrate, the wall section, and a covering member) are prevented from suffering damage or warpage, and no liquid leakage occurs when liquid flows.

In the microfluidic chip 2007, the channel sections 2073 are each formed in the barrier layer 2071 (specifically, the front surface 2071a) on the substrate channel region 2291 as an opening section. As illustrated in Fig. 26A, the substrate 2070 (front surface 2070a) included in the bottom sections of the channel sections 2073 is exposed in the channel sections 2073 each of which is an opening section formed on the front surface 2071a of the barrier layer 2071. It is to be noted that the configuration according to the present disclosure is not limited to this. A configuration may be adopted in which the substrate 2010 is not exposed on the bottom sections of the channel sections 2013 (e.g., a configuration in which the bottom sections of the channel sections 2073 are covered with the barrier layer 2011 or another member). In addition, the input sections 2040 and the output sections 2050 are components similar to those of the microfluidic base member 2100 according to the 3-1-th embodiment described above, and will be thus denoted by the same reference signs and the description thereof will be omitted.

In the microfluidic base member 2700 according to the present embodiment, the channel group including the plurality of channel sections 2073 may be regarded as a component including the input sections 2040 and the output sections 2050, and the channel sections 2073. This allows the channel group to be regarded as a component including even regions that each introduce/discharge a fluid.

The cover layer 2012 is bonded to the barrier layer 2071 of the microfluidic base member 2700 in which the channel sections 2073 are each formed, thereby surrounding the channel section 2073 in the microfluidic chip 2007 with the cover layer 2012, and the substrate 2070 and the barrier layer 2071 of the microfluidic base member 2700 and offering a configuration in which a fluid is transferable without any liquid leakage occurring.

The dimensions (the width W_3 and the channel length L_3) of each of the channel sections 2073 formed in the barrier layer 2071 in the microfluidic base member 2700 according to the present embodiment are equal to the width W_3 and the channel length L_3 of each of the channel sections 2013 of the microfluidic base member 2100 according to the 3-1-th embodiment described above, and will be thus denoted by the same reference signs and the detailed description thereof will be omitted.

The body of the microfluidic chip 2007 according to the present embodiment, that is, the channel sections 2073 in the microfluidic base member 2700 according to the present embodiment, is formed in the barrier layer 2071 as an opening section having an opening width of 2000 µm (2 mm) or less as with the channel sections 2013 of the microfluidic base member 2100. In the present embodiment, setting the width W_3 of the channel section 2073 to 2000 µm or less makes it possible to prevent pressure applied to the region near the channel section 2073 in the barrier layer 2071 from increasing in comparison with other regions in the barrier layer 2071 when the cover layer 2012 that is a covering member is bonded to the barrier layer 2071 of the microfluidic base member 2700. That is, it is possible to increase the bonding stability of bonding the microfluidic base member 2700 including the barrier layer 2071 and the cover layer 2012.

It is to be noted that the channel sections 2073 may be each configured to increase or decrease in opening width (width W_3) between the input section 2040 and the output section 2050 in the microfluidic base member 2700 according to the present embodiment. For example, the channel sections 2073 may each have a shape in which the width W_3 increases toward the intermediate region between the input section 2040 and the output section 2050. It is thus sufficient if the width W_3 of the channel section 2073 in the microfluidic base member 2700 is 2000 µm or less in the region of the greatest opening width (the region of the greatest width between the side surfaces 2011b of the barrier layers 2071).

Next, the opening area ratio of the barrier layer 2071 will be described. The opening area ratio (Ar_3) of the barrier layer 2071 is similar to the opening area ratio (Ar_3) of the barrier layer 2011 of the microfluidic base member 2100 according to the 3-1-th embodiment described above. Specifically, the opening area ratio (Ar_3) of the barrier layer 2071 is obtained as the ratio of the area (opening area OA_3) of the opening regions of the barrier layer 2071 to the area (superimposition area SA_3) of the whole of the region in which the substrate 2070 that forms the barrier layer 2071 and the cover layer 2012 overlap in a plan view in the microfluidic chip 2007, that is, the microfluidic base member 2700 in the covering member bonded state (Ar_3 (%) = opening area OA_3/superimposition area SA_3).

As with the calculation of the opening area ratio (Ar_3) of the barrier layer 2011, the superimposition area SA_3 of the microfluidic base member 2700 in the covering member bonded state does not include the area of the regions in which the input sections 2004 and the output sections 2005, and the substrate 2070 overlap. In addition, similarly, the opening area OA_3 does not include the input sections 2040 and the output sections 2050 formed in the barrier layer 2071 of the microfluidic base member 2700 at the positions opposed to the input sections 2004 and the output sections 2005 of the cover layer 2012.

For example, in the case of the microfluidic chip 2007 illustrated in each of Figs. 25A and 25B, the cover layer 2012 overlaps with the whole of the front surface 2070a of the substrate 2070, that is, the substrate channel region 2291 and the substrate non-channel region 2292. That is, in a case where the microfluidic base member 2700 is in the covering member bonded state, the cover layer 2012 overlaps with the whole of the front surface 2070a of the substrate 2070. The superimposition area SA_3 in this example is therefore the value (superimposition area SA_3 = area of front surface 2070a of substrate 2070 - area of input sections 2004 and output sections 2005) obtained by subtracting the area of the input sections 2004 and the output sections 2005 from the area of the upper surface of the substrate 2070.

In addition, in the microfluidic base member 2700 in this example, the barrier layer 2071 forms the plurality of channel sections 2073 (channel group 2730) in the substrate channel region 2291 of the substrate 2070. In addition, as described above, the portions other than the covering member support sections 2111 in the substrate non-channel region 2292 on the substrate 2070 are opening regions in which the substrate 2070 is exposed. Therefore, the opening area OA_3 in this example is the sum of the opening area OA_3 (= width W_3 of channel sections 2073a to 2073c ×channel length L_3) of the channel group 2730 (channel sections 2073a to 2073c) on the substrate channel region 2291 and the opening area (= area of substrate non-channel region 2292 in front surface 2070a - areas of front surfaces 2071a of covering member support sections 2111) on the substrate non-channel region 2292. Therefore, the opening area ratio Ar_3 of the microfluidic chip 2007 illustrated in each of Figs. 25A and 25B, that is, the opening area ratio Ar_3 of the microfluidic base member 2700 in the case of the covering member bonded state, is calculated as follows. opening area ratio Ar_3 (%) = (sum of opening areas of channel sections 2073a to 2073c and opening area of substrate non-channel region 2292/superimposition area SA_3)

Additionally, it is sufficient if the cover layer 2012 functions as a covering member of the microfluidic chip 2007 as in the 3-1-th embodiment described above. It is possible to design the cover layer 2012 in various shapes depending on application. It is sufficient if the cover layer 2012 is designed to cover at least part of the substrate 2070, that is, the substrate channel region 2291, on which the channel sections 2073 are formed. For example, it is possible to design the cover layer 2012 to cover the whole of the substrate 2070 on which the barrier layer 2071 is formed in a plan view.

In the microfluidic chip 2007 according to the present embodiment, thermocompression bonding is used as a method for bonding the barrier layer 2071 of the microfluidic base member 2700 and the cover layer 2012. In a case where the barrier layer 2071 and the cover layer 2012 are bonded by thermocompression bonding, it is necessary to prevent deformation of the barrier layer 2071 and the cover layer 2012 due to the thermal expansion coefficients at the time of heating from causing a defect (bonding failure) in the bonding of the cover layer 2012 and the microfluidic base member 2700 (the barrier layer 2071 in particular) in addition to increasing the resistance of the barrier layer 2071 to pressure.

Accordingly, in a case where the barrier layer 2011 and the cover layer 2012 are bonded (joined together) by thermocompression bonding in the microfluidic base member 2700 according to the present embodiment (in the case of the covering member bonded state), it is preferable that the opening area ratio Ar_3 of the barrier layer 2071 be within a range of 20% or more and 60% or less. That is, the one or more channel sections 2073 and covering member support sections 2111 are formed in the microfluidic chip 2007 (the microfluidic base member 2700 in the covering member bonded state) so that the opening area ratio Ar_3 of the barrier layer 2071 is 20% or more and 60% or less. In the microfluidic base member 2700 according to the present embodiment, setting the opening area ratio Ar_3 of the barrier layer 2071 in the covering member bonded state within this range makes it possible to prevent an increase in pressure applied to a region near the channel section 2073 in the barrier layer 2011 when the cover layer 2012 that is a covering member of the microfluidic chip 2007 is bonded to the barrier layer 2071 in comparison with other regions of the barrier layer 2071. Further, setting the opening area ratio Ar_3 of the barrier layer 2071 within this range makes it possible to prevent respective members (the substrate 2070 and the barrier layer 2071 of the microfluidic base member 2700, and the cover layer 2012) of the microfluidic chip 2007 from suffering damage and warpage caused by the deformation of the barrier layer 2071 and the cover layer 2012 due to the thermal expansion coefficients at the time of heating and further prevent the damage and the warpage from causing a defect in the bonding of the cover layer 2012 and the microfluidic base member (the barrier layer 2071 in particular) (bonding failure). That is, setting the opening area ratio Ar_3 of the barrier layer 2071 within this range makes it possible to prevent the resistance of the members included in the microfluidic chip 2007 to pressure from reducing and prevent the members from being deformed because of heating when the microfluidic base member (the wall section in particular) and the covering member are bonded at the time of fabricating the microfluidic chip 2007, and increase the bonding stability.

In addition, the microfluidic base member 2700 satisfies the condition that the width W_3 (opening width) of each of the channel sections 2073 is 2000 µm or less as described above in addition to the condition that the opening area ratio Ar_3 of the barrier layer 2071 in the covering member bonded state is 20% or more and 60% or less, thereby making it possible to further increase the bonding stability of the microfluidic base member 2700 (the barrier layer 2071 in particular) and the cover layer 2012 and prevent the microfluidic base member 2700 (the substrate 2070 and the barrier layer 2071) and the cover layer 2012 from suffering damage at the time of bonding.

That is, in the microfluidic base member 2700, the channel sections 2073 are each formed in the barrier layer 2071 as an opening section having an opening width of 2000 µm or less and the barrier layer 2071 has an opening area ratio of 20% or more and 60% or less. This makes it possible to provide a microfluidic base member that allows a microfluidic chip to be formed in which the bonding stability (e.g., the resistance of the barrier layer 2071 of the microfluidic base member 2700 to pressure) is increased, respective members (the substrate 2070 and the barrier layer 2071 of the microfluidic base member 2700, and the cover layer 2012) are prevented from suffering damage and warpage due to pressure ( pressing) and heating at the time of bonding the cover layer 2012 by thermocompression bonding, and no liquid leakage occurs when liquid flows.

If the microfluidic base member 2700 according to the present embodiment satisfies the conditions that the channel section 2073 has an opening width of 2000 µm or less and the barrier layer 2071 in the covering member bonded state has an opening area ratio of 20% or more and 60% or less, it is possible for the barrier layer 2071 to form the one or more channel sections 2073 on the substrate channel region 2291 and form the plurality of covering member support sections 2111 having various shapes on the substrate non-channel region 2292.

In addition, in the microfluidic base member 2700, the area of the region of the barrier layer 2071 other than the area of the opening regions, that is, the area (resin area RA_3) of the region (front surface 2071a) of the barrier layer 2071 in which resin remains, is calculated as the difference between the superimposition area SA_3 and the opening area OA_3 (resin area RA_3 = superimposition area SA_3 - opening area OA_3) as with the resin area RA_3 of the microfluidic base member 2100 according to the 3-1-th embodiment described above. That is, the resin area RA_3 is calculated as the difference between the superimposition area SA_3 and the opening area OA_3 in the microfluidic base member 2700. The remainder of the ratio of the opening area OA_3 to the superimposition area SA_3 is thus a resin area ratio RAr_3 (%). The resin area ratio is therefore 80% in the microfluidic base member 2700 when the opening area ratio in the covering member bonded state is 20%. The resin area ratio RAr_3 is 40% when the opening area ratio in the covering member bonded state is 60%. The resin area RA_3 indicates the contact area between the barrier layer 2071 and the cover layer 2012 in the covering member bonded state. That is, to increase the resistance of the barrier layer 2071 to pressure and increase the bonding stability of bonding the barrier layer 2071 and the cover layer 2012, it is sufficient if the resin area ratio RAr_3 that is the contact area between the barrier layer 2071 of the microfluidic base member 2700 and the cover layer 2012 is within a range of 40% or more and 80% or less. That is, it is sufficient if the channel sections 2073 and the covering member support sections 2111 are formed in the microfluidic base member 2700 such that the resin area ratio RAr_3 in the covering member bonded state is within a range of 40% or more and 80% or less. Additionally, it is possible to easily control the adjustment of the resin area ratio RAr_3 by adjusting the shape and the size of each of the covering member support sections 2111.

### (3.2.3) Method for Manufacturing Microfluidic Chip

Next, a method for manufacturing the microfluidic base member 2700 according to the present embodiment will be described. The method for manufacturing the microfluidic base member 2700 according to the present embodiment is similar to the method (see Fig. 21) for manufacturing the microfluidic base member 2100 according to the 3-1-th embodiment described above in principle but the substrate 2010 is replaced with the substrate 2070, the barrier layer 2011 is replaced with the barrier layer 2071, and the channel sections 2013 are replaced with the channel sections 2073. The detailed description thereof will be therefore omitted.

Only differences from the method for manufacturing the microfluidic base member 2100 will be described below.

In the method for manufacturing the microfluidic base member 2700, a groove section (gap pattern) for forming the covering member support section 2111 is drawn by exposure on a photosensitive resin for forming the barrier layer 2071 in the exposure step of step S2003 described above in addition to drawing a channel pattern. As illustrated in each of Figs. 25A and 25B and Figs. 26A and 26B, the plurality of covering member support sections 2111 formed by the barrier layer 2071 is formed with a gap provided in between. That is, the covering member support sections 2111 are formed to have the shape (the striped pattern in this example) illustrated in each of Figs. 25A and 25B and Figs. 26A and 26B by drawing a gap pattern for defining the covering member support sections 2111 on a photosensitive resin for forming the barrier layer 2071. This makes it possible to form the plurality of covering member support sections 2111 each of which is a resin structure formed as part of the barrier layer 2071.

In addition, in the method for manufacturing the microfluidic base member 2700, in the exposure step of step S2004 described above, a step of forming a gap pattern that defines the covering member support sections 2111 in addition to the channel pattern is performed by developing the exposed photosensitive resin. After that, the development liquid is completely removed by cleaning in step S2005 described above and a step of conducting heating treatment (post-bake) on the channel pattern, that is, the barrier layer 2071 that forms the channel sections 2073 and the covering member support sections 2111, is performed in step S2006 described above. This makes it possible to form the barrier layer 2071 included in the channel sections 2073 and the covering member support sections 2111 on the substrate 2070 by using photolithography and fabricate the microfluidic base member 2700.

In addition, after the microfluidic base member 2700 is fabricated, that is, after the post-baking treatment in step S2006 described above, a step of bonding the cover layer 2012 to the barrier layer 2071 of the microfluidic base member 2700 is performed to allow the microfluidic chip 2007 to be fabricated. In the present embodiment, the cover layer 2012 is bonded to the barrier layer 2071 by thermocompression bonding.

The step of bonding the cover layer 2012 is similar to that of the 3-1-th embodiment described above, and the description thereof will be omitted.

In addition, when the microfluidic chip 2007 is fabricated, a seal is pasted or predetermined information (e.g., the identification number of the microfluidic chip, or the like) is printed in some cases by an ink jet printer in the region of the cover layer 2012 that does not overlap with the channel section 2073 in a plan view, that is, the region of the cover layer 2012 that is not opposed to the channel section 2073. As described above, the microfluidic chip 2007 has increased bonding stability. This also makes it possible to prevent respective members (the substrate 2070, the barrier layer 2071, and the cover layer 2012) from suffering damage or warpage due to pressure at the time of pasting a seal to or printing predetermined information on the cover layer 2012 bonded to the barrier layer 2071.

As described above, the method for manufacturing the microfluidic base member 2700 according to the present embodiment includes the step (step S2001 described above) of coating the substrate 2070 with resin, the step (step S2003 described above) of exposing the resin used for the coating, the steps (step S2004 described above and step S2005 described above) of developing and cleaning the exposed resin to form the barrier layer 2071 on the substrate 2070, and the step (step S2006 described above) of conducing post-baking treatment on the barrier layer 2071. Further, the channel sections 2073 and the covering member support sections 2111 that support the cover layer 2012 in the covering member bonded state are formed on the substrate 2070 by removing the redundant resin (photosensitive resin layer) on the substrate 2070 in the development step (step S2004 described above) of forming the barrier layer 2071. In addition, an opening section (channel pattern) having an opening width of 2000 µm or less and serving as the channel section 2073 is formed on the barrier layer 2011. The barrier layer 2071 and the cover layer 2012 are bonded by thermocompression bonding. The barrier layer 2071 has an opening area ratio of 20% or more and 60% or less in the case of the covering member bonded state.

This makes it possible to fabricate the microfluidic base member 2700 that allows the microfluidic chip 2007 to be formed in which the resistance of the barrier layer 2071 of the microfluidic base member 2700 to pressure is prevented from reducing and the barrier layer 2071 and the cover layer 2012 are prevented from being deformed because of the thermal expansion coefficients at the time of heating, the bonding stability is increased, respective members (the substrate 2070, the barrier layer 2071, and the cover layer 2012) of the microfluidic chip 2007 are prevented from suffering damage and warpage due to pressure and heating at the time of bonding the microfluidic base member 2700 (the barrier layer 2071 in particular) and the cover layer 2012, and no liquid leakage occurs when liquid flows.

As described above, in the method for manufacturing the microfluidic chip 2007 according to the present embodiment, that is, in a case where the microfluidic base member 2700 and the cover layer 2012 are bonded, the step of bonding the barrier layer 2071 and the cover layer 2012 includes a step of applying pressure to bond the barrier layer 2071 and the cover layer 2012 with no gap in between and a step of heating the barrier layer 2071 and the cover layer 2012. That is, in the method for manufacturing the microfluidic base member 2700 according to the present embodiment, the barrier layer 2071 forms the channel sections 2073 and the covering member support sections 2111 that support the cover layer 2012 in the covering member bonded state on the substrate 2070, the channel sections 2073 each have an opening width of 2000 µm or less, and the barrier layer 2011 has an opening area ratio of 20% or more and 60% or less. This increases the resistance of the microfluidic base member 2700 (the barrier layer 2071 in particular) to pressure and heating and increases the bonding stability (the resistance of the microfluidic base member 2700 (the substrate and the wall section) to pressure) in the step of bonding a plurality of members (the substrate 2070 and the barrier layer 2071 of the microfluidic base member 2700, and the cover layer 2012 in this example) at the time of fabricating the microfluidic chip 2001. It is therefore possible to provide a microfluidic base member that allows a microfluidic chip to be formed in which respective members (the substrate 2070, the barrier layer 2071, and the cover layer 2012) of the microfluidic chip 2007 are prevented from suffering damage and warpage due to pressure and heating at the time of bonding and no liquid leakage occurs when liquid flows. In addition, the increased bonding stability eliminates the necessity of bonding at low pressure and at low temperature to prevent damage due to pressure and heating when the microfluidic chip 2007 is fabricated. The microfluidic base member 2700 according to the present embodiment thus makes it possible to provide a microfluidic base member that makes it possible to prevent a defect (bonding failure) such as insufficiently bonding members to each other because of bonding at low pressure and at low temperature.

### (3.2.4) Modification Examples

### (3.2.4.1) First Modification Example

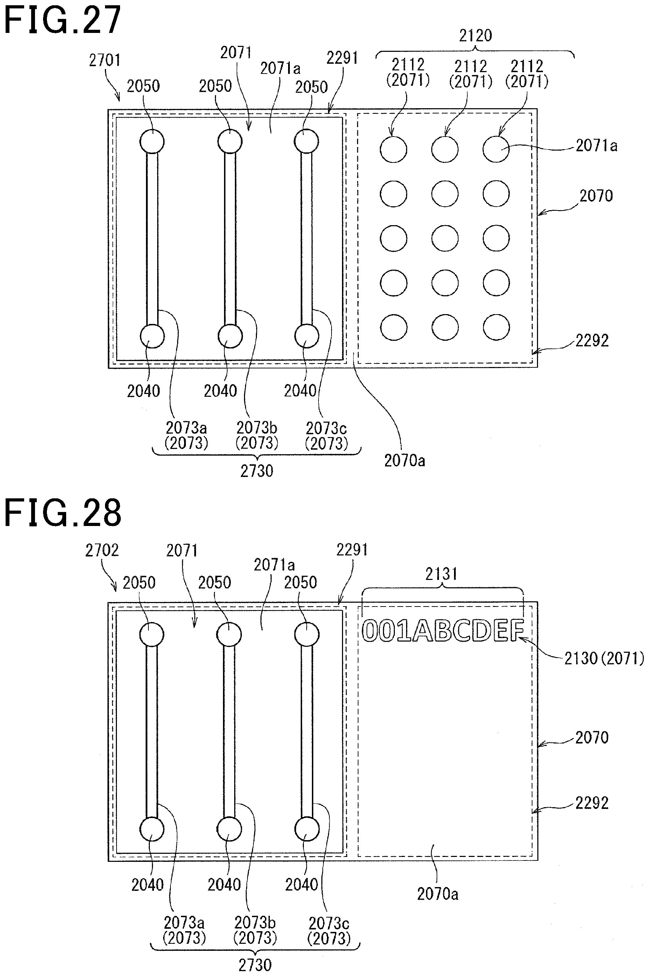

A microfluidic base member according to a modification example of the present embodiment will be described below by using Figs. 27 to 30.

Fig. 27 is an outline plan view for describing a configuration example of a microfluidic base member 2701 according to the modification example of the present embodiment.

As with the microfluidic base member 2700, the microfluidic base member 2701 includes the substrate 2070 and the barrier layer 2071 that forms the channel group 2730 including the plurality of channel sections 2073 (channel sections 2073a to 2073c) on the substrate 2070.

As illustrated in Fig. 27, the microfluidic base member 2701 is different from the microfluidic base member 2700 in that covering member support sections 2112 are formed on the substrate non-channel region 2292 by the barrier layer 2071. The covering member support sections 2112 will be described below.

As illustrated in Fig. 27, in this example, each of the covering member support sections 2112 is a resin structure having a circular shape in a plan view. More specifically, in this example, the 15 (= 3 columns × 5 rows) covering member support sections 2112 are aligned and disposed on the substrate non-channel region 2292. That is, the plurality of covering member support sections 2112 forms a dot (dotted) pattern 2120 on the substrate non-channel region 2292 of the substrate 2070. The covering member support sections 2112 form the dot (dotted) pattern 2120, thereby making it possible to easily adjust the contact area between the barrier layer 2071 and the cover layer 2012 and appropriately control the opening area ratio Ar_3 of the barrier layer 2071. **In** addition, the dot (dotted) pattern 2120 allows the plurality of respective covering member support sections 2112 to be disposed at any positions in the substrate non-channel region 2292 by design. It is therefore possible to flexibly dispose the covering member support sections 2112 depending on the purpose of the use of a microfluidic chip including the microfluidic base member 2701, the materials of the barrier layer 2071 and the cover layer 2012 of the microfluidic chip, and the like.

It is possible to form each of the covering member support sections 2112 as part of the barrier layer 2071 by forming a gap pattern corresponding to the dot (dotted) pattern 2120 in the exposure step (step S2003 described above) and the development step (step S2004 described above) as with the covering member support section 2111 of the microfluidic base member 2700.

It is to be noted that the present disclosure is not limited to this. It is sufficient if at least the two or more covering member support sections 2112 are disposed on the substrate non-channel region 2292 as the plurality of covering member support sections 2112 which forms the dot pattern 2120. It is then sufficient if the covering member support sections 2112 are disposed in the regions (the regions of the first and fifth covering member support sections 2112 from the top in the third column of the dot pattern 2120 illustrated in Fig. 27) corresponding to at least corner sections of the substrate 2070 in the substrate non-channel region 2292. In addition, the plurality of covering member support sections 2112 that forms the dot pattern 2120 do not each have to have a circular planar shape. For example, the planar shape of each of the covering member support sections 2112 may be a polygonal shape. That is, the covering member support sections 2112 are resin structures each formed by part of the barrier layer 2071 to have a polygonal shape or a circular shape in a plan view. The plurality of resin structures may be disposed on the substrate non-channel region 2292 to form dots. In addition, in this case, the polygonal shape may include an L shape. In a case where the planar shape of each of the covering member support sections 2112 is an L shape, the bent portion of L may be disposed to comply with a corner section of the substrate non-channel region 2292.

In addition, covering member support sections 2113 that support the cover layer 2012 may be formed on the substrate non-channel region 2292 by the barrier layer 2071 as in a microfluidic base member 2702 illustrated in Fig. 28. As illustrated in Fig. 28, in this example, each of the covering member support sections 2113 is a resin structure having a character shape in a plan view. More specifically, in this example, the nine covering member support sections 2113 each having a character shape are linearly disposed in a row on the substrate non-channel region 2292. That is, the plurality of covering member support sections 2113 forms a character string pattern 2131 on the substrate non-channel region 2292 of the substrate 2070. The covering member support sections 2113 form the character string pattern 2131, thereby making it possible to display various kinds of information (e.g., an identification number, a product name, and the like) for the microfluidic chip including the microfluidic base member 2702 on the substrate non-channel region 2292 while securing the contact area between the barrier layer 2071 and the cover layer 2012.

It is possible to form each of the covering member support sections 2113 as part of the barrier layer 2071 by forming a gap pattern corresponding to the letter string pattern 2131 in the exposure step (step S2003 described above) and the development step (step S2004 described above) as with the covering member support section 2111 of the microfluidic base member 2700.

It is to be noted that the present disclosure is not limited to this. It is sufficient if at least the two or more covering member support sections 2113 are provided on the substrate non-channel region 2292 as the plurality of covering member support sections 2113 which forms the character string pattern 2131. In addition, each of the covering member support sections 2113 included in the letter string pattern 2131 may be any letter such as an alphabetic character, a numeric character, a katakana character, a hitagana character, or a kanji character. Alternatively, each of the covering member support sections 2113 may include a symbol. In addition, the covering member support section 2113 is not limited to the letter shape. The covering member support section 2113 may include a predetermined pattern (such as a geometric pattern, a woodgrain pattern, or a Japanese pattern) or various shapes such as an animal or person character.

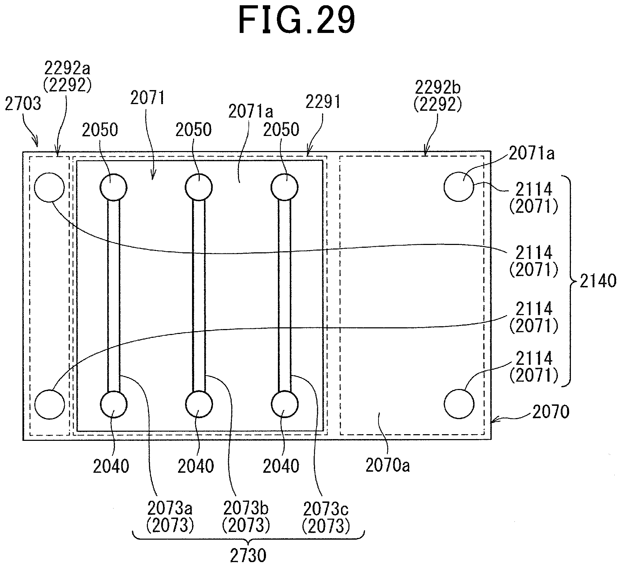

**In** addition, the plurality of substrate non-channel regions 2292 may be formed as in a microfluidic base member 2703 illustrated in Fig. 29. **In** this case, the substrate channel region 2291 may be disposed between the plurality of substrate non-channel regions 2292. **In** Fig. 29, the substrate non-channel region 2292 is divided into two regions (substrate non-channel regions 2292a and 2292b) and the substrate channel region 2291 is provided between the substrate non-channel regions 2292a and 2292b. **In** this example, the substrate 2070 has a quadrangular shape as in the microfluidic base members 2700, 2701, and 2702 and the two substrate non-channel regions 2292 are formed to include the four corner sections of the substrate 2070.

**In** addition, covering member support sections 2114 in the microfluidic base member 2703 are formed at the four corner sections of the substrate included in the substrate non-channel regions 2292a and 2292b. More specifically, the covering member support sections 2114 each have a circular planar shape as with the covering member support section 2112 illustrated in Fig. 27 and are disposed at the four corner sections to form dots. That is, the plurality of covering member support sections 2114 forms a locally dotted pattern 2140 on the substrate non-channel region 2292 of the substrate 2070.

It is to be noted that the present disclosure is not limited to this. It is sufficient if the covering member support sections 2114 are formed at two or more corner sections of the four corner sections of the substrate 2070 included in the substrate non-channel regions 2292a and 2292b. This makes it possible in the microfluidic chip 103 to secure the bonding area between the barrier layer 2071 and the cover layer 2012 and increase the bonding stability by locally disposing the covering member support sections 2114 at corner sections of the substrate 2070 that easily reduce in bonding stability. In addition, disposing the covering member support sections 2114 in the locally dotted pattern 2140 makes it possible to effectively increase the bonding stability without disposing a large number of covering member support sections 2114.

In addition, the present disclosure is not limited to this. The covering member support sections 2114 may each have a polygonal shape including an L shape as with the covering member support section 2112. In addition, the covering member support section 2114 may have a character shape.

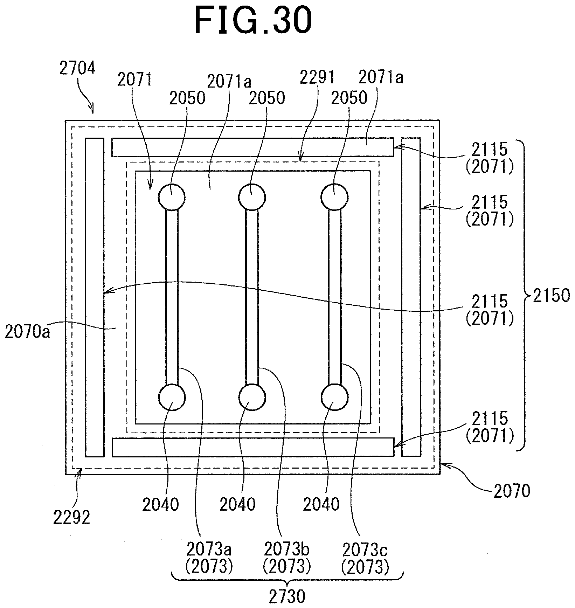

In addition, the substrate non-channel region 2292 may be provided to surround the substrate channel region 2291 as in a microfluidic base member 2704 illustrated in Fig. 30. That is, the substrate non-channel region 2292 may be formed in the peripheral section of the front surface 2070a of the substrate 2070 and the substrate channel region 2291 may be formed in the middle region of the front surface 2070a.

In addition, covering member support sections 2115 in the microfluidic base member 2704 are disposed to surround the inner periphery of the front surface 2070a of the substrate 2070 in the substrate non-channel region 2292. More specifically, the covering member support sections 2115 each have a rectangular planar shape as with the covering member support section 2111 illustrated in each of Fig. 25A and 26A and are disposed along the four sides of the front surface 2070a of the substrate 2070. That is, the plurality of covering member support sections 2115 forms a frame pattern 2150 on the substrate non-channel region 2292 of the substrate 2070. This makes it possible in the microfluidic base member 2704 to secure the bonding area between the barrier layer 2071 and the cover layer 2012 in the covering member bonded state and increase the bonding stability by disposing the covering member support sections 2115 at peripheral sections of the substrate 2070 that easily has bonding failure.

### (3.2.4.2) Second Modification Example

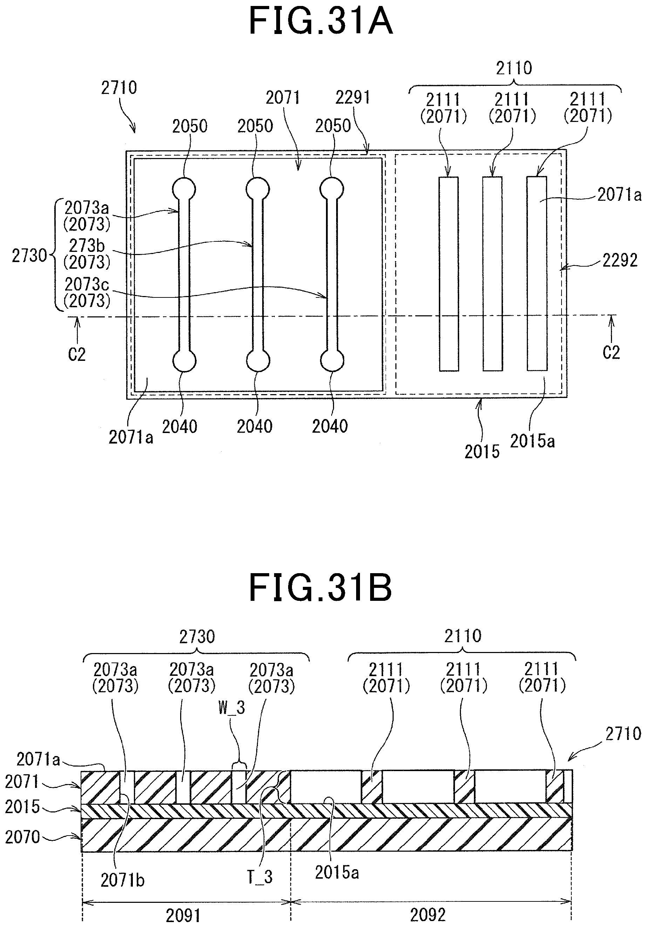

A microfluidic base member 2710 according to a second modification example of the present disclosure will be described below by using Figs. 31A and 31B. Fig. 31A is an outline plan view describing a configuration example of the microfluidic base member 2710 according to the second modification example of the present embodiment. Fig. 31B is a cross-sectional view for describing the configuration example of the microfluidic base member 2710 according to the second modification example of the present embodiment.

As illustrated in each of Figs. 31A and 31B, the microfluidic base member 2710 includes the substrate 2070, the adhesive layer 2015 disposed on the substrate 2070, the barrier layer 2071 that forms the channel group 2730 including the channel sections 2073a to 2073c and the covering member support sections 2111 above the substrate 2070, and the cover layer 2012. Specifically, the microfluidic base member 2710 includes the adhesive layer 2015 between the barrier layer 2071 and the substrate 2070. Specifically, the microfluidic base member 2710 includes the adhesive layer 2015 between the barrier layer 2071 and the substrate 2010. The microfluidic base member 2710 is different from the microfluidic base member 2700 according to the 3-1-th embodiment described above in that the microfluidic base member 2710 includes the adhesive layer 2015.

The adhesive layer 2015 in the microfluidic base member 2710 is a component similar to the adhesive layer 2015 of the microfluidic base member 2200 according to the 3-1-th embodiment described above, and will be thus denoted by the same reference sign and the detailed description thereof will be omitted.

Providing the adhesive layer 2015 on the substrate 2070 also makes it possible to contribute to an increase in the resolution of a channel pattern by the photosensitive resin, or the like.

As described above, the adhesive layer 2015 is formed on the substrate 2070. Therefore, as illustrated in each of Figs. 31A and 31B, in the microfluidic base member according to the present embodiment, the bottom section of each of the channel sections 2073 is formed by the adhesive layer 2015. The adhesive layer 2015 (specifically, the front surface 2015a of the adhesive layer 2015) included in the bottom section of the channel section 2073 is exposed in the channel section 2073.

### <Third Examples>

Examples (third Examples) of a third embodiment of the present disclosure will be specifically described below, but the present disclosure is not limited to them.

### (3.1-th Examples)

3.1-th Examples are Examples regarding the microfluidic base member according to the 3-1-th embodiment of the present disclosure. It is to be noted that the present 3.1-th Examples include "3.1-th Examples (1)" including Examples 1-1 to 1-9 and comparative examples 1-1 to 1-5 and "3.1-th Examples (2)" of Examples 1-11 to 1-19 and comparative examples 1-11 to 1-15.

### <3.1-th Examples (1)>

### [Fabrication of Microfluidic Base Member]

### <Example 1-1>

The present inventor manufactured a microfluidic base member by forming a barrier layer on a substrate and bonding the barrier layer and a cover layer as illustrated in Fig. 19B.

A method for manufacturing the microfluidic base member 2100 according to Example 1-1 in the 3.1-th Examples (1) will be described. First, glass was used as a substrate.

The glass substrate was coated with a transparent photosensitive resin to form a photosensitive resin layer. An acryl-based photosensitive resin was used for the photosensitive resin. The glass substrate was coated with the photosensitive resin by using a spin coater at a rotation speed of 1100 rpm for 30 seconds. The rotation speed and the time were adjusted to obtain a film thickness of 50 µm. Next, heating treatment (pre-bake) was conducted on a hot plate for the purpose of removing a residual solvent medium included in the photosensitive resin. Pre-baking was carried out at a temperature of 90°C for 20 minutes.

Next, the photosensitive resin layer on the glass substrate was exposed to draw a channel pattern. Specifically, the photosensitive resin was subjected to pattern exposure through a photomask having a microfluidic channel pattern arrangement. A photomask having a two-layer structure of chromium and chromium oxide as a light-shielding film was used as the photomask. In addition, a proximity exposure apparatus was used for the exposure. The exposure apparatus carried out exposure by using a high-pressure mercury lamp as a light source and having a cut filter of an i-line filter therein. The exposure value was 170 mJ/cm².

Next, the exposed photosensitive resin layer was developed and used as a barrier layer in which a channel pattern was formed. Specifically, the photosensitive resin layer was developed for 60 seconds by using an alkali development liquid (TMAH 2.38%) to dissolve unexposed portions and pattern channel structures.

Subsequently, shower washing with ultrapure water was performed to remove the development liquid from the photosensitive resin layer on the substrate, and the substrate was dried using a spin dryer.

Next, the channel pattern was subjected to heating treatment (post-bake) in an oven at 100°C for ten minutes.

In the development step described above, channel structures were formed (patterned) so that channel sections had an opening width (channel width) of 10 µm and a channel length of and cause the opening area ratio Ar_3 of the barrier layer in the covering member bonded state to be 10% in the barrier layer subjected to the post-baking (the remaining moisture was removed). That is, a barrier layer including a channel section having an opening width of 10 µm and having 10% as the opening area ratio Ar_3 of the barrier layer was formed in the development. This offered a microfluidic base member according to Example 1-1.

### [Fabrication of Microfluidic Chip]

Next, the bonding surfaces of the microfluidic base member including the barrier layer in which a channel section was formed and a separately fabricated cover layer were subjected to surface modification treatment and the barrier layer of the microfluidic base member and the cover layer were then bonded by pressure bonding (pressure bonding at room temperature) under the following conditions.

### <Pressure Bonding Conditions>

adhesive: acryl-based adhesive (model number 9969 manufactured by 3M Co., Ltd.)
apparatus used: rubber roller
pressure: 3 N/cm²
temperature: 25°C (room temperature)
press time: three seconds

In addition, polycarbonate having a channel inlet and a channel outlet made in advance and having a thickness of 5 mm was used for the cover layer.

This offered a microfluidic chip including the microfluidic base member according to this Example as illustrated in each of Figs. 18A and 18B.

### <Example 1-2>

Channel structures were formed by development in a barrier layer formed on a glass substrate so that the channel sections had an opening width of 500 µm. Except for this, a microfluidic chip including a microfluidic base member according to Example 1-2 was obtained as in Example 1-1 of the 3.1-th Examples (1).

### <Example 1-3>

Channel structures were formed by development in a barrier layer formed on a glass substrate so that channel sections had an opening width of 2000 µm. Except for this, a microfluidic chip including a microfluidic base member according to Example 1-3 was obtained as in Example 1-1 of the 3.1-th Examples (1).

### <Example 1-4>

Channel structures were formed by development so that a barrier layer formed on a glass substrate had an opening area ratio of 30% in the covering member bonded state. Except for that, a microfluidic chip including a microfluidic base member according to Example 1-4 was obtained as in Example 1-1 of the 3.1-th Examples (1).

### <Example 1-5>

Channel structures were formed by development in a barrier layer formed on a glass substrate so that the channel sections had an opening width of 500 µm. Except for this, a microfluidic chip including a microfluidic base member according to Example 1-5 was obtained as in Example 1-4 of the 3.1-th Examples (1).

### <Example 1-6>

Channel structures were formed by development in a barrier layer formed on a glass substrate so that channel sections had an opening width of 2000 µm. Except for this, a microfluidic chip including a microfluidic base member according to Example 1-6 was obtained as in Example 1-4 of the 3.1-th Examples (1).

### <Example 1-7>

Channel structures were formed by development so that a barrier layer formed on a glass substrate had an opening area ratio of 60% in the covering member bonded state. Except for this, a microfluidic chip including a microfluidic base member according to Example 1-7 was obtained as in Example 1-1 of the 3.1-th Examples (1).

### <Example 1-8>

Channel structures were formed by development in a barrier layer formed on a glass substrate so that the channel sections had an opening width of 500 µm. Except for this, a microfluidic chip including a microfluidic base member according to Example 1-8 was obtained as in Example 1-7 of the 3.1-th Examples (1).

### <Example 1-9>

Channel structures were formed by development in a barrier layer formed on a glass substrate so that channel sections had an opening width of 2000 µm. Except for this, a microfluidic chip including a microfluidic base member according to Example 1-9 was obtained as in Example 1-7 of the 3.1-th Examples (1).

### <Comparative Example 1-1>

Channel structures were formed by development so that a barrier layer formed on a glass substrate had an opening area ratio of 70% in the covering member bonded state. Except for this, a microfluidic chip including a microfluidic base member according to a comparative example 1-1 was obtained as in Example 1-1 of the 3.1-th Examples (1).

### <Comparative Example 1-2>

Channel structures were formed by development in a barrier layer formed on a glass substrate so that the channel sections had an opening width of 500 µm. Except for this, a microfluidic chip including a microfluidic base member according to a comparative example 1-2 was obtained as in the comparative example 1-1.

### <Comparative Example 1-3>

Channel structures were formed by development in a barrier layer formed on a glass substrate so that channel sections had an opening width of 2000 µm. Except for this, a microfluidic chip including a microfluidic base member according to a comparative example 1-3 was obtained as in the comparative example 1-1.

### <Comparative Example 1-4>

Channel structures were formed by development in a barrier layer formed on a glass substrate so that channel sections had an opening width of 3000 µm and so that the barrier layer had an opening area ratio of 30% in the covering member bonded state. Except for this, a microfluidic chip including a microfluidic base member according to a comparative example 1-4 was obtained as in Example 1-1 of the 3.1-th Examples (1).

### <Comparative Example 1-5>

Channel structures were formed by development in a barrier layer formed on a glass substrate so that channel sections had an opening width of 3000 µm and so that the barrier layer had an opening area ratio of 70% in the covering member bonded state. Except for this, a microfluidic chip including a microfluidic base member according to a comparative example 1-5 was obtained as in Example 1-1 of the 3.1-th Examples (1).

### [Assessment Methods]

The presence or absence of damage and liquid leakage at the time of bonding the cover layers were assessed for the microfluidic chips including the microfluidic base members according to Example 1-1 to Example 1-9 and the comparative example 1-1 to the comparative example 1-5 in the 3.1-th Examples (1) in the following methods after the bonding.

### (Presence or Absence of Damage)

The presence or absence of damage was visually confirmed for the microfluidic chips including the microfluidic base members according to Example 1-1 to Example 1-9 and the comparative example 1-1 to the comparative example 1-5 in the 3.1-th Examples (1). "∘ (acceptable)" indicates that no damage was visually confirmed and "× (unacceptable)" indicates that damage was visually confirmed.

### (Presence or Absence of Liquid Leakage)

A 10-µL colored reaction solution was collected by a pipette and introduced from an inlet channel of the cover layer for each of the microfluidic chips including the microfluidic base members according to Example 1-1 to Example 1-9 and the comparative example 1-1 to the comparative example 1-5 in the 3.1-th Examples (1). The transfer of the solution was observed with a microscope.

The liquid leakage state of each microfluidic chip was assessed in the two levels of "∘" and " ×" by the following criterion on the basis of a result of the observation.

### <Assessment Criterion>

∘: no liquid leakage was observed from the channel at a portion at which the barrier layer and the cover layer are bonded
×: liquid leakage was observed from the channel at a portion at which the barrier layer and the cover layer are bonded

Assessment results of the respective Examples and the respective comparative examples in the 3.1-th Examples (1) will be shown in Table 4 along with the opening area ratios of the barrier layers of the microfluidic base members in the covering member bonded state, the opening widths of the channels, the channel lengths, and the pressure bonding temperatures for bonding to the cover layers.

**[Table 4]**

| | Barrier layer | | | Pressure bonding temperature | Assessment | |
|---|---|---|---|---|---|---|
| | opening area ratio | opening width of channel | channel length | | damage state after bonding | liquid leakage |
| Example 1-1 | 10% | 10 µm | 50 mm | 25°C | ○ | ○ |
| Example 1-2 | 10% | 500 µm | 50 mm | 25°C | ○ | ○ |
| Example 1-3 | 10% | 2000 µm | 50 mm | 25°C | ○ | ○ |
| Example 1-4 | 30% | 10 µm | 50 mm | 25°C | ○ | ○ |
| Example 1-5 | 30% | 500 µm | 50 mm | 25°C | ○ | ○ |
| Example 1-6 | 30% | 2000 µm | 50 mm | 25°C | ○ | ○ |
| Example 1-7 | 60% | 10 µm | 50 mm | 25°C | ○ | ○ |
| Example 1-8 | 60% | 500 µm | 50 mm | 25°C | ○ | ○ |
| Example 1-9 | 60% | 2000 µm | 50 mm | 25°C | ○ | ○ |
| comparative example 1-1 | 70% | 10 µm | 50 mm | 25°C | × | × |
| comparative example 1-2 | 70% | 500 µm | 50 mm | 25°C | × | × |
| comparative example 1-3 | 70% | 2000 µm | 50 mm | 25°C | × | × |
| comparative example 1-4 | 30% | 3000 µm | 50 mm | 25°C | × | × |
| comparative example 1-5 | 70% | 3000 µm | 50 mm | 25°C | × | × |

It was confirmed that none of the microfluidic chips including the microfluidic base members according to Example 1-1 to Example 1-9 of the 3.1-th Examples (1) suffered any damage after bonding and no liquid leakage occurred after liquid flowed. In contrast, it was confirmed that the microfluidic chips including the microfluidic base members according to the comparative example 1-1 to the comparative example 1-5 of the 3.1-th Examples (1) each suffered damage after bonding. Further, liquid leakage was confirmed after liquid flowed.

As the results described above, it was confirmed that the opening area ratio of the wall section in the covering member bonded state and the dimensions (e.g., the opening width of a channel) of an opening section formed in the wall section were controlled in each of the microfluidic base members according to the respective Examples of the 3.1-th Examples (1) to satisfy the specific conditions, thereby allowing a microfluidic chip to be formed in which the bonding stability of bonding a microfluidic base member (a wall section here) and a covering member was increased, respective members (a substrate, the wall section, and the covering member) of the microfluidic chip were prevented from suffering damage due to pressure at the time of bonding a barrier layer and the covering member, and no liquid leakage occurred when liquid flowed.

Specifically, as with each of the microfluidic base members according to Example 1-1 to Example 1-9 of the 3.1-th Examples (1), it was confirmed that the barrier layer formed a channel section as an opening section having an opening width of 2000 µm or less and the barrier layer in the covering member bonded state had an opening area ratio of 60% or less, thereby allowing a microfluidic chip to be formed in which members were prevented from suffering damage due to pressure at the time of bonding the microfluidic chip base member (the barrier layer in particular) and the cover layer and no liquid leakage occurred when liquid flowed.

### <3.1-th Examples (2)>

### <Example 1-11>

Channel structures were formed by development so that a barrier layer formed on a glass substrate had an opening area ratio of 20%.

Further, the bonding surfaces of the barrier layer in which a channel section was formed and a separately fabricated cover layer were subjected to surface modification treatment and the barrier layer and the cover layer were then bonded by pressure bonding (thermocompression bonding) under the following conditions.

### <Pressure Bonding Conditions>

apparatus used: thermal press machine
pressure: 2 MPa
temperature: 50°C
press time: five min

Except for this, a microfluidic chip according to Example 1-11 of the 3.1-th Examples (2) was fabricated in a method similar to that of Example 1-1 of the 3.1-th Examples (1).

### <Example 1-12>

Channel structures were formed by development in a barrier layer formed on a glass substrate so that the channel sections had an opening width of 500 µm. Except for this, a microfluidic chip according to Example 1-12 was obtained as in Example 1-11 of the 3.1-th Examples (2).

### <Example 1-13>

Channel structures were formed by development in a barrier layer formed on a glass substrate so that channel sections had an opening width of 2000 µm. Except for this, a microfluidic chip according to Example 1-13 was obtained as in Example 1-11 of the 3.1-th Examples (2).

### <Example 1-14>

Channel structures were formed by development so that a barrier layer formed on a glass substrate had an opening area ratio of 30%. Except for this, a microfluidic chip according to Example 1-14 was obtained as in Example 1-11 of the 3.1-th Examples (2).

### <Example 1-15>

Channel structures were formed by development in a barrier layer formed on a glass substrate so that the channel sections had an opening width of 500 µm. Except for this, a microfluidic chip according to Example 1-15 was obtained as in Example 1-14 of the 3.1-th Examples (2).

### <Example 1-16>

Channel structures were formed by development in a barrier layer formed on a glass substrate so that channel sections had an opening width of 2000 µm. Except for this, a microfluidic chip according to Example 1-16 was obtained as in Example 1-14 of the 3.1-th Examples (2).

### <Example 1-17>

Channel structures were formed by development so that a barrier layer formed on a glass substrate had an opening area ratio of 60%. Except for this, a microfluidic chip according to Example 1-17 was obtained as in Example 1-11 of the 3.1-th Examples (2).

### <Example 1-18>

Channel structures were formed by development in a barrier layer formed on a glass substrate so that the channel sections had an opening width of 500 µm. Except for this, a microfluidic chip according to Example 1-18 was obtained as in Example 1-17 of the 3.1-th Examples (2).

### <Example 1-19>

Channel structures were formed by development in a barrier layer formed on a glass substrate so that channel sections had an opening width of 2000 µm. Except for this, a microfluidic chip according to Example 1-19 was obtained as in Example 1-17 of the 3.1-th Examples (2).

### <Comparative Example 1-11>

Channel structures were formed by development so that a barrier layer formed on a glass substrate had an opening area ratio of 70%. Except for this, a microfluidic chip according to a comparative example 1-11 was obtained as in Example 1-11 of the 3.1-th Examples (2).

### <Comparative Example 1-12>

Channel structures were formed by development in a barrier layer formed on a glass substrate so that the channel sections had an opening width of 500 µm. Except for this, a microfluidic chip according to a comparative example 1-12 was obtained as in the comparative example 1-11 of the 3.1-th Examples (2).

### <Comparative Example 1-13>

Channel structures were formed by development in a barrier layer formed on a glass substrate so that channel sections had an opening width of 2000 µm. Except for this, a microfluidic chip according to a comparative example 1-13 was obtained as in the comparative example 1-11 of the 3.1-th Examples (2).

### <Comparative Example 1-14>

Channel structures were formed by development in a barrier layer formed on a glass substrate so that channel sections had an opening width of 3000 µm and so that the barrier layer had an opening area ratio of 30%. Except for this, a microfluidic chip according to a comparative example 1-14 was obtained as in Example 1-11 of the 3.1-th Examples (2).

### <Comparative Example 1-15>

Channel structures were formed by development in a barrier layer formed on a glass substrate so that channel sections had an opening width of 3000 µm and so that the barrier layer had an opening area ratio of 70%. Except for this, a microfluidic chip according to a comparative example 1-15 was obtained as in Example 1-11 of the 3.1-th Examples (2).

### [Assessment Methods]

The presence or absence of damage and warpage and the presence or absence of liquid leakage at the time of bonding the cover layers were assessed for the microfluidic chips according to Example 1-11 to Example 1-19 and the comparative example 1-11 to the comparative example 1-15 in the 3.1-th Examples (2) in the following methods after the bonding.

### (Presence or Absence of Damage and Warpage)

The presence or absence of damage and warpage was visually confirmed for the microfluidic chips including the microfluidic base members according to Example 1-11 to Example 1-19 and the comparative example 1-11 to the comparative example 1-15 in the 3.1-th Examples (2). "∘ (acceptable)" indicates that none of damage and warpage was visually confirmed and "× (unacceptable)" indicates that at least one of damage or warpage was visually confirmed.

### (Presence or Absence of Liquid Leakage)

A 10-µL colored reaction solution was collected by a pipette and introduced from an inlet channel of the cover layer for each of the microfluidic chips according to Example 1-11 to Example 1-19 and the comparative example 1-11 to the comparative example 1-15 in the 3.1-th Examples (2). The transfer of the solution was observed with a microscope.

The liquid leakage state of each microfluidic chip was assessed in the two levels of "∘" and " ×" by the following criterion on the basis of a result of the observation.

### <Assessment Criterion>

∘: no liquid leakage was observed from the channel at a portion at which the barrier layer and the cover layer are bonded
×: liquid leakage was observed from the channel at a portion at which the barrier layer and the cover layer are bonded

It is to be noted that "-" describes that it is not possible for liquid to flow because of damage to a microfluidic chip.

Assessment results of the respective Examples and the respective comparative examples in the first Examples (2) will be shown in Table 5 along with the opening area ratios of the barrier layers of the microfluidic base members in the covering member bonded state, the opening widths of the channels, the channel lengths, and the pressure bonding temperatures for bonding to the cover layers.

**[Table 5]**

| | Barrier layer | | | Pressure bonding temperature | Assessment | |
|---|---|---|---|---|---|---|
| | Opening area ratio | Opening width of channel | Channel length | | Damage state after bonding | Liquid leakage |
| Example 1-11 | 20% | 10 µm | 50 mm | 50°C | ○ | ○ |
| Example 1-12 | 20% | 500 µm | 50 mm | 50°C | ○ | ○ |
| Example 1-13 | 20% | 2000 µm | 50 mm | 50°C | ○ | ○ |
| Example 1-14 | 30% | 10 µm | 50 mm | 50°C | ○ | ○ |
| Example 1-15 | 30% | 500 µm | 50 mm | 50°C | ○ | ○ |
| Example 1-16 | 30% | 2000 µm | 50 mm | 50°C | ○ | ○ |
| Example 1-17 | 60% | 10 µm | 50 mm | 50°C | ○ | ○ |
| Example 1-18 | 60% | 500 µm | 50 mm | 50°C | ○ | ○ |
| Example 1-19 | 60% | 2000 µm | 50 mm | 50°C | ○ | ○ |
| Comparative example 1-11 | 70% | 10 µm | 50 mm | 50°C | × | × |
| Comparative example 1-12 | 70% | 500 µm | 50 mm | 50°C | × | - |
| Comparative example 1-13 | 70% | 2000 µm | 50 mm | 50°C | × | - |
| Comparative example 1-14 | 30% | 3000 µm | 50 mm | 50°C | × | - |
| Comparative example 1-15 | 70% | 3000 µm | 50 mm | 50°C | × | - |

It was confirmed all of the microfluidic chips including the microfluidic base members according to Example 1-11 to Example 1-19 of the 3.1-th Examples (2) suffered neither damage nor warpage after bonding and no liquid leakage occurred after liquid flowed. In contrast, it was confirmed that the microfluidic chips including the microfluidic base members according to the comparative example 1-11 to the comparative example 1-15 of the 3.1-th Examples (2) each suffered damage or warpage after bonding. Further, liquid leakage was confirmed after liquid flowed.

As the results described above, it was confirmed that the opening area ratio of the wall section in the covering member bonded state and the dimensions (e.g., the opening width of a channel) of an opening section formed in the wall section were controlled in each of the microfluidic base members according to the respective Examples of the 3.1-th Examples (2) to satisfy the specific conditions, thereby allowing a microfluidic chip to be formed in which the bonding stability at the time of bonding members (a wall section of a microfluidic base member and a covering member here) included in the microfluidic chip to each other was increased, respective members (a substrate, the wall section, and the covering member) of the microfluidic chip were prevented from suffering even warpage in addition to damage due to pressure and heating at the time of bonding the microfluidic base member (the barrier layer in particular) and the cover layer, and no liquid leakage occurred when liquid flowed.

Specifically, it was confirmed that a channel section was formed in the barrier layer in covering member bonded state as an opening section having an opening width of 2000 µm or less and the barrier layer had an opening area ratio of 20% or more and 60% or less in each of the microfluidic base members according to Example 1-11 to Example 1-19 of the 3.1-th Examples (2), thereby allowing a microfluidic chip to be formed in which members were prevented from suffering damage and warpage due to pressure and heating at the time of bonding a microfluidic base member (a barrier layer in particular) and a cover layer by thermocompression bonding and no liquid leakage occurred when liquid flowed.

It is to be noted that the microfluidic base member according to the 3-1-th embodiment of the present disclosure, the microfluidic chip including the base member, and the methods for manufacturing the microfluidic base member and the microfluidic chip are not limited to the embodiments and the Examples described above. It is possible to make various modifications within the scope that does not impair the features of the invention.

### <3.2-th Examples>

### [Fabrication of Microfluidic Base Member]

### <Example 2-1>

The present inventor manufactured a microfluidic base member by forming a barrier layer on a substrate and bonding the barrier layer and a cover layer as illustrated in each of Figs. 26A and 26B.

A method for manufacturing the microfluidic base member according to Example 2-1 of 3.2-th Examples will be described. First, glass was used as a substrate.

The glass substrate was coated with a transparent photosensitive resin to form a photosensitive resin layer. An acryl-based photosensitive resin was used for the photosensitive resin. The glass substrate was coated with the photosensitive resin by using a spin coater at a rotation speed of 1100 rpm for 30 seconds. The rotation speed and the time were adjusted to obtain a film thickness of 50 µm. Next, heating treatment (pre-bake) was conducted on a hot plate for the purpose of removing a residual solvent medium included in the photosensitive resin. Pre-baking was carried out at a temperature of 90°C for 20 minutes.

Next, the photosensitive resin layer on the glass substrate was exposed to draw a channel pattern and a gap pattern for forming a covering member support section. Specifically, the photosensitive resin was subjected to pattern exposure through a photomask having a microfluidic channel pattern arrangement and a photomask having a gap pattern arrangement of a covering member support section. A photomask having a two-layer structure of chromium and chromium oxide as a light-shielding film was used as the photomask. In addition, a proximity exposure apparatus was used for the exposure. The exposure apparatus carried out exposure by using a highpressure mercury lamp as a light source and having a cut filter of an i-line filter therein. The exposure value was 170 mJ/cm².

Next, the exposed photosensitive resin layer was developed and used as a barrier layer in which the channel pattern and the gap pattern for forming a covering member support section were formed. Specifically, the photosensitive resin layer was developed for 60 seconds by using an alkali development liquid (TMAH 2.38%) to dissolve unexposed portions and pattern channel structures.

Subsequently, shower washing with ultrapure water was performed to remove the development liquid from the photosensitive resin layer on the substrate, and the substrate was dried using a spin dryer.

Next, members (a substrate and a barrier layer) for a microfluidic chip in which the channel pattern and the gap pattern for forming a covering member support section were formed was subjected to heating treatment (post-bake) in an oven at 100°C for ten minutes.

In the development step described above, channel structures and covering member support sections were formed (patterned) so that channel sections had an opening width (channel width) of 10 µm and a channel length of 500 mm and so that the opening area ratio Ar_3 of the barrier layer in the covering member bonded state was 20% in the barrier layer subjected to the post-baking (the remaining moisture was removed). As illustrated in Fig. 29, the covering member support sections each had a circular planar shape and were formed in a locally dotted pattern in which the covering member support sections were disposed at the four respective corner sections on the substrate 2070. The opposite surface (the surface having a circular shape) of each of the covering member support sections to the substrate had a diameter of 500 µm. This offered a microfluidic base member according to Example 2-1 of the 3.2-th Examples.

### [Fabrication of Microfluidic Chip]

Next, the bonding surfaces of the microfluidic base member including the barrier layer in which a channel section was formed and the separately fabricated cover layer were subjected to surface modification treatment and the barrier layer of the microfluidic base member and the cover layer were then bonded by thermocompression bonding while being heated to 60°C. A polycarbonate having a channel inlet and a channel outlet formed in advance and having a thickness of 5 mm was used for the cover layer. This offered a microfluidic chip including the microfluidic base member according to this Example as illustrated in each of Figs. 25A and 25B.

### <Example 2-2>

Channel structures were formed by development in a barrier layer formed on a glass substrate so that the channel sections had an opening width of 500 µm. Except for this, a microfluidic chip including a microfluidic base member according to Example 2-2 was obtained as in Example 2-1 of the 3.2-th Examples.

### <Example 2-3>

Channel structures were formed by development in a barrier layer formed on a glass substrate so that channel sections had an opening width of 2000 µm. Except for this, a microfluidic chip including a microfluidic base member according to Example 2-3 was obtained as in Example 2-1 of the 3.2-th Examples.

### <Example 2-4>

Covering member support sections each had a rectangular planar shape and were formed in a frame pattern (see Fig. 30) in which the covering member support sections were disposed on the four sides of the substrate 2070. The size (the area of the opposite surface to a substrate) of each covering member support section was 25 square millimeters (0.5 mm (500 µm) × 50 mm = 25 mm²). Except for this, a microfluidic chip including a microfluidic base member according to Example 2-4 was obtained as in Example 2-1 of the 3.2-th Examples.

### <Example 2-5>

Channel structures were formed by development in a barrier layer formed on a glass substrate so that the channel sections had an opening width of 500 µm. Except for this, a microfluidic chip including a microfluidic base member according to Example 2-5 was obtained as in Example 2-4 of the 3.2-th Examples.

### <Example 2-6>

Channel structures were formed by development in a barrier layer formed on a glass substrate so that channel sections had an opening width of 2000 µm. Except for this, a microfluidic chip including a microfluidic base member according to Example 2-6 was obtained as in Example 2-4 of the 3.2-th Examples.

### <Example 2-7>

Channel structures and covering member support sections were formed by development in a barrier layer formed on a glass substrate such that the opening area ratio Ar_3 of the barrier layer was 60% in the covering member bonded state. Except for this, a microfluidic chip including a microfluidic base member according to Example 2-7 was obtained as in Example 2-1 of the 3.2-th Examples.

### <Example 2-8>

Channel structures were formed by development in a barrier layer formed on a glass substrate so that the channel sections had an opening width of 500 µm. Except for this, a microfluidic chip including a microfluidic base member according to Example 2-8 was obtained as in Example 2-7 of the 3.2-th Examples.

### <Example 2-9>

Channel structures were formed by development in a barrier layer formed on a glass substrate so that channel sections had an opening width of 2000 µm. Except for this, a microfluidic chip including a microfluidic base member according to Example 2-9 was obtained as in Example 2-7 of the 3.2-th Examples.

### <Example 2-10>

Channel structures and covering member support sections were formed by development in a barrier layer formed on a glass substrate such that the opening area ratio Ar_3 of the barrier layer was 60% in the covering member bonded state. Except for this, a microfluidic chip including a microfluidic base member according to Example 2-10 was obtained as in Example 2-4 of the 3.2-th Examples.

### <Example 2-11>

Channel structures were formed by development in a barrier layer formed on a glass substrate so that the channel sections had an opening width of 500 µm. Except for this, a microfluidic chip including a microfluidic base member according to Example 2-11 was obtained as in Example 2-10 of the 3.2-th Examples.

### <Example 2-12>

Channel structures were formed by development in a barrier layer formed on a glass substrate so that channel sections had an opening width of 2000 µm. Except for this, a microfluidic chip including a microfluidic base member according to Example 2-12 was obtained as in Example 2-10 of the 3.2-th Examples.

### <Comparative Example 2-1>

Channel structures and covering member support sections were formed by development in a barrier layer formed on a glass substrate such that the opening area ratio Ar_3 of the barrier layer was 10% in the covering member bonded state. Except for this, a microfluidic chip including a microfluidic base member according to a comparative example 2-1 was obtained as in Example 2-1 of the 3.2-th Examples.

### <Comparative Example 2-2>

Channel structures were formed by development in a barrier layer formed on a glass substrate so that channel sections had an opening width of 3000 µm. Except for this, a microfluidic chip including a microfluidic base member according to a comparative example 2-2 was obtained as in Example 2-1 of the 3.2-th Examples.

### <Comparative Example 2-3>

Channel structures and covering member support sections were formed by development in a barrier layer formed on a glass substrate such that the opening area ratio Ar_3 of the barrier layer was 80% and a channel section had an opening width of 500 µm in the covering member bonded state. Except for this, a microfluidic chip including a microfluidic base member according to a comparative example 2-3 was obtained as in Example 2-1 of the 3.2-th Examples.

### <Comparative Example 2-4>

Channel structures were formed and covering member support sections were not formed by development in a barrier layer formed on a glass substrate such that the opening area ratio Ar_3 of the barrier layer was 20% and a channel section had an opening width of 500 µm in the covering member bonded state. Except for this, a microfluidic chip including a microfluidic base member according to a comparative example 2-4 was obtained as in Example 2-1 of the 3.2-th Examples.

### [Assessment Methods]

The presence or absence of damage and warpage and the presence or absence of liquid leakage at the time of bonding the cover layers were assessed for the microfluidic chips including the microfluidic base members according to Example 2-1 to Example 2-12 and the comparative example 2-1 to the comparative example 2-4 in the 3.2-th Examples in the following methods after the bonding.

### (Presence or Absence of Damage and Warpage)

The presence or absence of damage was visually confirmed for the microfluidic chips including the microfluidic base members according to Example 2-1 to Example 2-12 and the comparative example 2-1 to the comparative example 2-4 in the 3.2-th Examples. "∘ (acceptable)" indicates that none of damage and warpage was visually confirmed and "× (unacceptable)" indicates that at least one of damage or warpage was visually confirmed.

### (Presence or Absence of Liquid Leakage)

A 10-µL colored reaction solution was collected by a pipette and introduced from an inlet channel of the cover layer for each of the microfluidic chips including the microfluidic base members according to Example 2-1 to Example 2-12 and the comparative example 2-1 to the comparative example 2-4 in the 3.2-th Examples. The transfer of the solution was observed with a microscope.

The liquid leakage state of each microfluidic chip was assessed in the two levels of "∘" and "×" by the following criterion on the basis of a result of the observation.

### <Assessment Criterion>

∘: no liquid leakage was observed from the channel at a portion at which the barrier layer and the cover layer are bonded
×: liquid leakage was observed from the channel at a portion at which the barrier layer and the cover layer are bonded

It is to be noted that "-" describes that it is not possible for liquid to flow because of damage to a microfluidic chip.

Assessment results of Examples 2-1 to 2-12 and the comparative examples 2-1 to 2-4 in the 3.2-th Examples will be shown in Table 6 along with the opening area ratios of the barrier layers of the microfluidic base members in the covering member bonded state, the opening widths of the channels, the channel lengths, and the configurations of the covering member support sections.

**[Table 6]**

| | Barrier layer | | | Covering member support section | | | Assessment | |
|---|---|---|---|---|---|---|---|---|
| | Opening area ratio | Opening width of channel | Channel length | Shape | Size | Disposition | Damage state after bonding | Liquid leakage |
| Example 2-1 | 20% | 10 µm | 50 mm | Dot (circle) | Diameter of 500 µm | Four corners | ○ | ○ |
| Example 2-2 | 20% | 500 µm | 50 mm | | | | ○ | ○ |
| Example 2-3 | 20% | 2000 µm | 50 mm | | | | ○ | ○ |
| Example 2-4 | 20% | 10 µm | 50 mm | Frame | 500 µm × 50 mm | Four sides | ○ | ○ |
| Example 2-5 | 20% | 500 µm | 50 mm | | | | ○ | ○ |
| Example 2-6 | 20% | 2000 µm | 50 mm | | | | ○ | ○ |
| Example 2-7 | 60% | 10 µm | 50 mm | Dot (circle) | Diameter of 500 µm | Four corners | ○ | ○ |
| Example 2-8 | 60% | 500 µm | 50 mm | | | | ○ | ○ |
| Example 2-9 | 60% | 2000 µm | 50 mm | | | | ○ | ○ |
| Example 2-10 | 60% | 10 µm | 50 mm | Frame | 500 µm × 50 mm | Four sides | ○ | ○ |
| Example 2-11 | 60% | 500 µm | 50 mm | | | | ○ | ○ |
| Example 2-12 | 60% | 2000 µm | 50 mm | | | | ○ | ○ |
| Comparative example 2-1 | 10% | 10 µm | 50 mm | Dot (circle) | Diameter of 500 µm | Four corners | × | × |
| Comparative example 2-2 | 20% | 3000 µm | 50 mm | | | | × | - |
| Comparative example 2-3 | 80% | 500 µm | 50 mm | | | | × | - |
| Comparative example 2-4 | 20% | 500 µm | 50 mm | - | - | - | × | - |

It was confirmed that all of the microfluidic chips including the microfluidic base members according to Example 2-1 to Example 2-12 of the 3.2-th Examples suffered neither damage nor warpage after bonding and no liquid leakage occurred after liquid flowed. In contrast, the microfluidic chips including the microfluidic base members according to the comparative example 2-1 to the comparative example 2-4 each suffered damage or warpage after bonding. Further, liquid leakage was confirmed in the microfluidic chip including the microfluidic base member according to the comparative example 2-1 of the comparative examples after liquid flowed. In addition, the microfluidic chips including the microfluidic base members according to the comparative example 2-2 to the comparative example 2-4 each suffered great damage and it was not possible for liquid to flow.

As the results described above, it was confirmed that the barrier layer formed a channel section and a covering member support section, and the opening area ratio of the barrier layer in the covering member bonded state and the dimensions (e.g., the opening width of the channel and the gap between the covering member support sections) of an opening section formed in the barrier layer were controlled in each of the microfluidic chips including the microfluidic base members according to the respective Examples of the 3.2-th Examples to satisfy the specific conditions, thereby increasing the bonding stability of bonding a plurality of members (the wall section of the microfluidic base member and the covering member here), preventing members from suffering damage and warpage due to pressure at the time of bonding the wall section (barrier layer) and the covering member (cover layer), and without liquid leakage occurring when liquid flowed.

Specifically, a channel section and a covering member support section that supported the cover layer in the covering member bonded state were formed on the substrate by the barrier layer in each of the microfluidic base member according to Example 2-1 to Example 2-12 of the 3.2-th Examples. The channel section was formed as an opening section having an opening width of 2000 µm or less. The barrier layer in the covering member bonded state had an opening area ratio of 20% or more and 60% or less. It was confirmed that this made it possible to form a microfluidic chip in which members were prevented from suffering damage and warpage due to pressure and heating at the time of bonding a barrier layer of a microfluidic base member and a cover layer by thermocompression bonding and without liquid leakage occurring when liquid flowed.

In addition, for example, it is possible for the third embodiment described above to adopt configurations as follows.
(1) A microfluidic base member including:
   a substrate; and
   a barrier section including a resin material, the barrier section being provided on the substrate, the barrier section forming a channel on the substrate, characterized in that
   the channel is formed in the barrier section as an opening section having an opening width of 2000 µm or less, and
   the barrier section has an opening area ratio of 60% or less in a covering member bonded state in which a covering member is provided on an opposite surface of the barrier section to the substrate, the covering member serving as a cover of the channel.
(2) The microfluidic base member according to (1), characterized in that, in a case where the barrier section and the covering member are joined together by thermocompression bonding, the barrier section has an opening area ratio of 20% or more and 60% or less.
(3) The microfluidic base member according to (1) or (2), characterized in that the substrate includes a channel region in which the one or more channels are formed by the barrier section and a non-channel region in which the channels are not formed on a front surface closer to the barrier section.
(4) The microfluidic base member according to (3), characterized in that the barrier section is provided in the channel region and the non-channel region and does not vary in thickness between the channel region and the non-channel region.
(5) The microfluidic base member according to (3) or (4), characterized in that the barrier section forms a covering member support section on the non-channel region, the covering member support section supporting the covering member in the covering member bonded state.
(6) The microfluidic base member according to (5), characterized in that one or more resin structures each including part of the barrier section are formed on the non-channel region as the covering member support sections.
(7) The microfluidic base member according to (6), characterized in that
   the covering member support section is the resin structure formed by the part of the barrier section, the resin structure having a rectangular shape in a plan view, and
   a plurality of the covering member support sections is disposed on the non-channel region to be parallel with long sides of the rectangles.
(8) The microfluidic base member according to (6), characterized in that
   the covering member support section is the resin structure formed by the part of the barrier section, the resin structure having a polygonal shape or a circular shape in a plan view, and
   a plurality of the resin structures is disposed on the non-channel region to form dots.
(9) The microfluidic base member according to (6), characterized in that
   the substrate has a quadrangular shape,
   the non-channel region includes four corner sections of the substrate, and
   the covering member support sections are formed at two or more corner sections of the four corner sections of the substrate included in the non-channel region.
(10) The microfluidic base member according to any one of (5) to (9), characterized in that the covering member support section that is part of the barrier section is in surface contact with the covering member on an opposite surface to the substrate in the covering member bonded state.
(11) The microfluidic base member according to any one of (1) to (10), characterized in that the barrier section forms a channel group including a plurality of the channels on the substrate.
(12) The microfluidic base member according to any one of (1) to (11), characterized in that an adhesive layer is provided between the barrier section and the substrate.
(13) The microfluidic base member according to any one of (1) to (12), characterized in that the resin material that forms the barrier section is a photosensitive resin having photosensitivity to light having a wavelength of 190 nm or more and 400 nm or less in an ultraviolet region.
(14) A method for manufacturing a microfluidic base member, including:
   a step of coating a substrate with resin;
   a step of exposing the resin used for the coating;
   a step of developing and cleaning the exposed resin to form a barrier section that defines a channel on the substrate; and
   a step of conducting post-baking treatment on the barrier section, characterized in that
   redundant resin on the substrate is removed by the developing to form an opening section having an opening width of 2000 µm or less in the barrier section and cause the barrier section to have an opening area ratio of 60% or less in a covering member bonded state in which a covering member is provided on an opposite surface of the barrier section to the substrate, the opening section serving as the channel, the covering member serving as a cover of the channel.
(15) The method for manufacturing the microfluidic base member according to (14) characterized in that, in a case where the covering member bonded state is produced by bonding the barrier section and the covering member by thermocompression bonding, the barrier section in the covering member bonded state has an opening area ratio of 20% or more and 60% or less due to the developing.
(16) The method for manufacturing the microfluidic base member according to (14) or (15), characterized in that redundant resin on the substrate is removed in the developing so that the barrier section forms the channel and a covering member support section on the substrate, the covering member support section supporting the covering member in the covering member bonded state.
(17) The method for manufacturing the microfluidic base member according to any one of (14) to (16), characterized in that a photosensitive resin is sensitized to light having a wavelength of 190 nm or more and 400 nm or less in an ultraviolet region in the step of exposing the resin.

### Industrial Applicability

The present disclosure is favorably usable as a microfluidic chip that allows an upper cover to be formed without requesting a complicated manufacturing step in a microfluidic chip for research use, diagnostic use, testing, analysis, incubation, or the like, and a method for manufacturing the microfluidic chip.

### Reference Signs List

1, 2, 101, 102, 1001, 1002, 1101, 1102, 1103, 2001, 2002 ... Microfluidic chip
4, 40, 1004, 1040, 2004, 2040 ... Input section
5, 50, 1005, 1050, 2005, 2050 ... Output section
10, 1010, 2010, 2070 ... Substrate
11, 1011, 2011, 2071 ... Barrier layer
12, 1012, 2012 ... Cover layer
13, 13a, 13b, 13c, 1013, 1013a, 1013b, 1013c, 2013, 2013a, 2013b, 2013c, 2073, 2073a, 2073c ... Channel section
15, 1015, 2015 ... Adhesive layer
31, 31a, 31b, 1091 ... Channel region
32, 2032 ... Support region
110, 1011b, 2011b, 2071b ... Side surface
130, 1130, 2130, 2730 ... Channel group
1092 ... Non-channel region
1111, 1112, 1113, 1114, 1115 ... Covering member support section 2031, 2031a, 2031b ... Barrier channel region
2100, 2101, 2102, 2200, 2700, 2701, 2702, 2703, 2704, 2710 ... Microfluidic base member
2191, 2291... Substrate channel region
2192, 2292... Substrate non-channel region

## Claims

1. A microfluidic chip comprising:
a substrate;
a barrier section including a resin material, the barrier section being provided on the substrate, the barrier section forming a channel; and
a covering member that is provided on an opposite surface of the barrier section to the substrate and covers the channel, **characterized in that**
the channel is formed in the barrier section as an opening section having an opening width of 2000 µm or less, and
the barrier section has an opening area ratio of 60% or less.

2. The microfluidic chip according to claim 1, **characterized in that**
the barrier section and the covering member are joined together by thermocompression bonding, and
the barrier section has an opening area ratio of 20% or more and 60% or less.

3. The microfluidic chip according to claim 2, **characterized in that** a plurality of the channels is formed in the barrier section.

4. The microfluidic chip according to claim 3, **characterized in that** the barrier section includes a channel region in which at least one of the channels is formed and a non-channel region in which the channels are not formed.

5. The microfluidic chip according to claim 2, **characterized in that**
the substrate includes a substrate channel region in which the channel is provided and a substrate non-channel region in which the channel is not provided on a surface opposed to the covering member,
the channel is formed on the substrate channel region by the barrier section, and
one or more resin structures each including part of the barrier section are formed on the substrate non-channel region as covering member support sections that each support the covering member.

6. The microfluidic chip according to claim 5, **characterized in that** the barrier section does not vary in thickness between the substrate channel region and the substrate non-channel region.

7. The microfluidic chip according to claim 6, **characterized in that** the covering member support section that is the part of the barrier section is in surface contact with the covering member on an opposite surface to the substrate.

8. The microfluidic chip according to claim 7, **characterized in that**
the covering member support section is the resin structure formed by the part of the barrier section, the resin structure having a rectangular shape in a plan view, and
a plurality of the covering member support sections is disposed on the substrate non-channel region to be parallel with long sides of the rectangular shapes.

9. The microfluidic chip according to claim 7, **characterized in that**
the covering member support section is the resin structure formed by the part of the barrier section, the resin structure having a polygonal shape or a circular shape in a plan view, and
a plurality of the resin structures is disposed on the substrate non-channel region to form dots.

10. The microfluidic chip according to claim 7, **characterized in that**
the substrate has a quadrangular shape,
the substrate non-channel region includes four corner sections of the substrate, and
the covering member support sections are formed at two or more corner sections of the four corner sections of the substrate included in the substrate non-channel region.

11. The microfluidic chip according to any one of claims 1 to 10, **characterized in that** an adhesive layer is provided between the barrier section and the substrate.

12. The microfluidic chip according to any one of claims 1 to 10, **characterized in that** the resin material that forms the barrier section is a photosensitive resin having photosensitivity to light having a wavelength of 190 nm or more and 400 nm or less included in an ultraviolet region.

13. A microfluidic base member comprising:
a substrate; and
a barrier section including a resin material, the barrier section being provided on the substrate, the barrier section forming a channel on the substrate, **characterized in that**
the channel is formed in the barrier section as an opening section having an opening width of 2000 µm or less, and
the barrier section has an opening area ratio of 60% or less in a covering member bonded state in which a covering member is provided on an opposite surface of the barrier section to the substrate, the covering member serving as a cover of the channel.

14. The microfluidic base member according to claim 13, **characterized in that**, in a case where the barrier section and the covering member are joined together by thermocompression bonding, the barrier section has an opening area ratio of 20% or more and 60% or less.

15. The microfluidic base member according to claim 14, **characterized in that** the substrate includes a substrate channel region in which the one or more channels are formed by the barrier section and a substrate non-channel region in which the channels are not formed on a front surface closer to the barrier section.

16. The microfluidic base member according to claim 15, **characterized in that** the barrier section forms a covering member support section on the substrate non-channel region, the covering member support section supporting the covering member in the covering member bonded state.

17. The microfluidic base member according to claim 16, **characterized in that** one or more resin structures each including part of the barrier section are formed on the substrate non-channel region as the covering member support sections.

18. A method for manufacturing a microfluidic chip, comprising:
a step of coating a substrate with resin;
a step of exposing the resin used for the coating;
a step of developing and cleaning the exposed resin to form a barrier section that defines a channel on the substrate;
a step of conducting post-baking treatment on the barrier section; and
a step of bonding a covering member to an opposite surface of the barrier section to the substrate, **characterized in that**
redundant resin on the substrate is removed by the developing to form an opening section having an opening width of 2000 µm or less in the barrier section and cause the barrier section to have an opening area ratio of 60% or less, the opening section serving as the channel.

19. The method for manufacturing the microfluidic chip according to claim 18, **characterized in that** pressure is applied to narrow a gap between the barrier section and the covering member and bond the barrier section and the covering member with no gap in between in the step of bonding the covering member to the opposite surface of the barrier section to the substrate.

20. The method for manufacturing the microfluidic chip according to claim 19, **characterized in that**
the barrier section has an opening area ratio of 20% or more and 60% or less due to the developing, and
the barrier section and the covering member are bonded by thermocompression bonding in the step of bonding the covering member to the opposite surface of the barrier section to the substrate.

21. The method for manufacturing the microfluidic chip according to claim 20, **characterized in that** redundant resin on the substrate is removed by the developing so that the barrier section forms the channel and a covering member support section on the substrate, the covering member support section supporting the covering member.

22. The method for manufacturing the microfluidic chip according to any one of claims 18 to 21, **characterized in that** a photosensitive resin is sensitized to light having a wavelength of 190 nm or more and 400 nm or less in an ultraviolet region in the step of exposing the resin.

23. A method for manufacturing a microfluidic base member, comprising:
a step of coating a substrate with resin;
a step of exposing the resin used for the coating;
a step of developing and cleaning the exposed resin to form a barrier section that defines a channel on the substrate; and
a step of conducting post-baking treatment on the barrier section, **characterized in that**
redundant resin on the substrate is removed by the developing to form an opening section having an opening width of 2000 µm or less in the barrier section and cause the barrier section to have an opening area ratio of 60% or less in a covering member bonded state in which a covering member is provided on an opposite surface of the barrier section to the substrate, the opening section serving as the channel, the covering member serving as a cover of the channel.
